# EUROPÄISCHE PATENTSCHRIFT

(11) **EP 2 935 293 B1**
(45) Veröffentlichungstag und Bekanntmachung des Hinweises auf die Patenterteilung: **21.08.2019**
(21) Anmeldenummer: 13805769.0
(22) Anmeldetag: 27.11.2013
(51) Int. Cl.: C07F 15/00, H01L 51/00, H05B 33/10, C09K 11/06, H01L 51/50

(54) **IRIDIUMKOMPLEXE UND DEREN VERWENDUNG IN ELEKTRONISCHEN VORRICHTUNGEN INSBESONDERE IN ELEKTROLUMINESZENZVORRICHTUNGEN**
IRIDIUM COMPLEXES AND THEIR USE IN ELECTRONIC DEVICES, ESPECIALLY ELECTROLUMINESCENT DEVICES
COMPLEXES DU IRIDIUM ET LEUR UTILISATION DANS LES DISPOSITIFS ELECTRONIQUES EN PARTICULIER LES DISPOSITIFS ELECTROLUMINESCENTES

(30) Priorität: 21.12.2012 EP 12008582
(43) Veröffentlichungstag der Anmeldung: 28.10.2015
(73) Patentinhaber: Merck Patent GmbH, 64293 Darmstadt (DE)
(72) Erfinder: STOESSEL, Philipp, 60487 Frankfurt am Main (DE); BREUNING, Esther, 64372 Ober-Ramstadt (DE); KAISER, Joachim, 64289 Darmstadt (DE)
(86) Internationale Anmeldenummer: PCT/EP2013/003582
(87) Internationale Veröffentlichungsnummer: WO 2014/094962

(56) Entgegenhaltungen:
- WO-A1-2011/044988
- SOMEPALLI VENKATESWARLU ET AL: "Cyclisation of 2-(2-aminophenyl)quinazolin-4(3)-one reexamined: formation of isomeric angular fused quinazolinoquinazolinones and their spectroscopic identification", TETRAHEDRON LETTERS, PERGAMON, GB, Bd. 53, Nr. 21, 18. März 2012 (2012-03-18) , Seiten 2643-2646, XP028410133, ISSN: 0040-4039, DOI: 10.1016/J.TETLET.2012.03.055 [gefunden am 2012-03-23]

## Beschreibung

Die vorliegende Erfindung betrifft Metallkomplexe sowie elektronische Vorrichtungen, insbesondere organische Elektrolumineszenzvorrichtungen, enthaltend diese Metallkomplexe.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch Verbesserungsbedarf, insbesondere im Hinblick auf Effizienz, Betriebsspannung und Lebensdauer.

Gemäß dem Stand der Technik werden in phosphoreszierenden OLEDs als Triplettemitter insbesondere Iridiumkomplexe eingesetzt, wie zum Beispiel Iridiumkomplexe, welche als Liganden Imidazophenanthridin-Derivate bzw. Diimidazochinazolin-Derivate enthalten (WO 2007/095118). Aus der WO 2011/044988 sind Iridiumkomplexe bekannt, in welchen der Ligand mindestens eine Carbonylgruppe enthält. Generell sind bei phosphoreszierenden Emittern noch weitere Verbesserungen, insbesondere hinsichtlich Effizienz, Betriebsspannung und Lebensdauer, wünschenswert.

Aufgabe der vorliegenden Erfindung ist daher die Bereitstellung neuer Metallkomplexe, welche sich als Emitter für die Verwendung in OLEDs eignen und dabei zu verbesserten Eigenschaften der OLED, insbesondere hinsichtlich Effizienz, Betriebsspannung und/oder Lebensdauer führen.

Überraschend wurde gefunden, dass bestimmte, unten näher beschriebene heteroleptische Metallchelatkomplexe diese Aufgabe lösen und verbesserte Eigenschaften in organischen Elektrolumineszenzvorrichtung zeigen. Diese Metallkomplexe emittieren insbesondere in den Farben gelbgrün, gelb, orange oder rot, also mit Emissionsmaxima im Bereich von ca. 540-650 nm. Diese Metallkomplexe und elektronische Vorrichtungen, insbesondere organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1),

[Ir(L)ₙ(L')ₘ] Formel (1)

wobei die Verbindung der allgemeinen Formel (1) eine Teilstruktur Ir(L)ₙ der Formel (2) enthält: 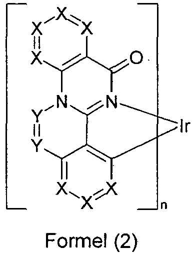 wobei für die verwendeten Symbole und Indizes gilt:
- X: ist bei jedem Auftreten gleich oder verschieden CR oder N mit der Maßgabe, dass maximal zwei Symbole X pro Ligand für N stehen;
- Y: ist bei jedem Auftreten gleich oder verschieden CR oder N mit der Maßgabe, dass maximal ein Symbol Y für N steht, oder die beiden Symbole Y stehen zusammen für eine Gruppe der folgenden Formel (3), 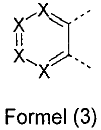 wobei die gestrichelten Bindungen die Verknüpfung dieser Gruppe im Liganden symbolisieren;
- R: ist bei jedem Auftreten gleich oder verschieden H, D, F, Cl, Br, I, N(R¹)₂, CN, Si(R¹)₃, B(OR¹)₂, C(=O)R¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, Si(R¹)₂, C=O, NR¹, O, S oder CONR¹ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden;
- R¹: ist bei jedem Auftreten gleich oder verschieden H, D, F, N(R²)₂, CN, Si(R²)₃, B(OR²)₂, C(=O)R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², Si(R²)₂, C=O, NR², O, S oder CONR² ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R² auch miteinander ein mono- oder polycyclisches, aliphatisches oder aromatisches Ringsystem bilden;
- L': ist gleich oder verschieden bei jedem Auftreten ein monoanionischer bidentater Ligand, welcher eine Kombination aus zwei der Formeln (32) bis (55) ist, wobei L' aus diesen Gruppen gebildet wird, indem diese Gruppen jeweils an der durch # gekennzeichneten Position aneinander binden, 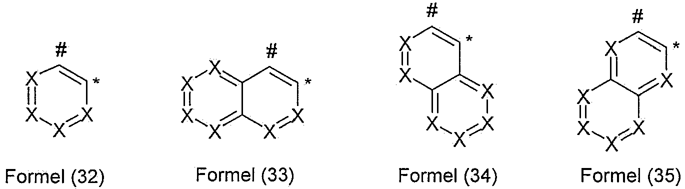 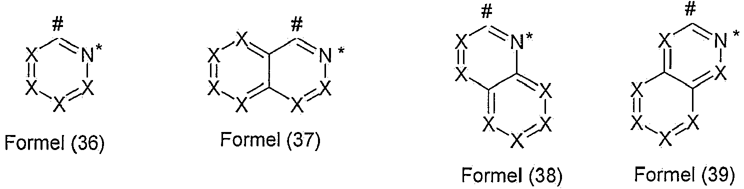 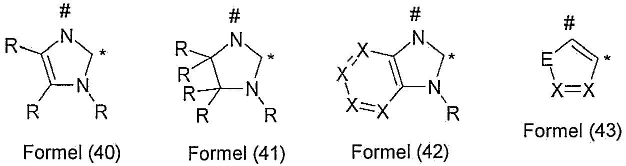 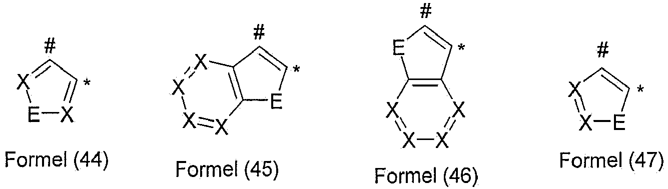 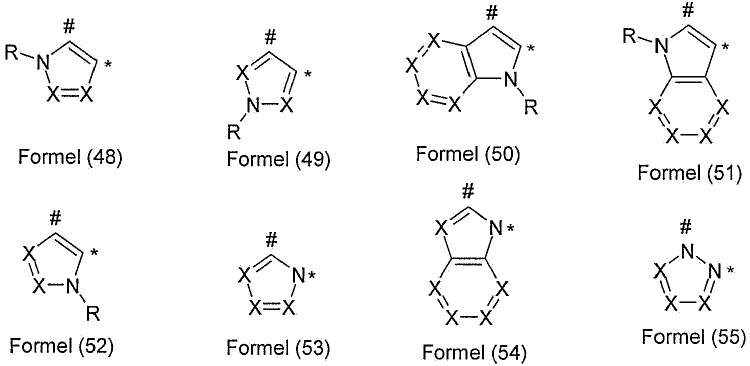 wobei die Position, an der die Gruppen an das Metall koordinieren, durch * gekennzeichnet sind und E für O, S oder CR₂ steht;
- n: ist 1 oder 2;
- m: ist 1 oder 2;
mit der Maßgabe, dass n + m = 3 ist.

Es handelt sich bei den Komplexen der Formel (1) somit um heteroleptische Komplexe.

In der folgenden Beschreibung bedeutet "benachbarte Gruppen X", dass die Gruppen X in der Struktur direkt aneinander gebunden sind.

Weiterhin bedeutet "benachbart" in der Definition der Reste, dass diese Reste an dasselbe oder an direkt aneinander gebundene C-Atome gebunden sind oder, wenn sie nicht an direkt gebundene C-Atome gebunden sind, dass es sich um die nächstmögliche Position handelt, in der ein Substituent gebunden sein kann. Dies wird anhand von einem spezifischen Liganden in der folgenden schematischen Darstellung für benachbarte Reste nochmals erläutert:

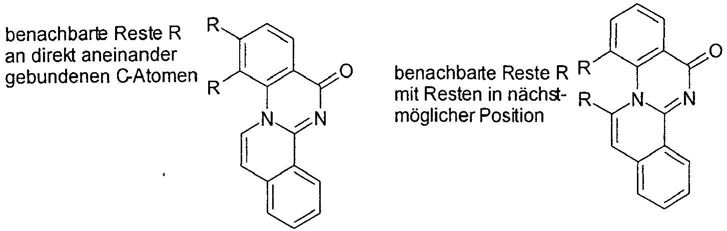

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N- oder O-Atom oder eine Carbonylgruppe, verbunden sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylengruppe oder durch eine Silylengruppe verbunden sind.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, Cyclohexyl, 2-Methylpentyl, neo-Hexyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die erfindungsgemäßen Komplexe können facial bzw. pseudofacial sein, oder sie können meridional bzw. pseudomeridional sein.

In einer bevorzugten Ausführungsform ist der Index n = 1, d. h. der erfindungsgemäße Komplex enthält einen Liganden L und zwei Liganden L'. Dies ist inbesondere dann bevorzugt, wenn der Ligand L' ein ortho-metallierter Ligand ist, der über ein Kohlenstoffatom und ein Stickstoffatom an das Iridium koordiniert.

In einer weiteren bevorzugten Ausführungsform ist der Index n = 2, d. h. der erfindungsgemäße Komplex enthält zwei Liganden L und einen Liganden L'. Dies ist eine bevorzugte Ausführungsform, wenn der Ligand L' über ein Kohlenstoffatom und ein Stickstoffatom an das Iridium koordiniert.

In einer weiteren bevorzugten Ausführungsform der Erfindung stehen im Liganden L insgesamt 0, 1 oder 2 der Symbole X und Y für N. Besonders bevorzugt stehen im Liganden L insgesamt 0 oder 1 der Symbole X und Y für N. Ganz besonders bevorzugt steht keines der Symbole X und Y für N, d. h. die Symbole X stehen gleich oder verschieden bei jedem Auftreten für CR und die Symbole Y stehen gleich oder verschieden bei jedem Auftreten für CR oder die Symbole Y stehen zusammen für eine Gruppe der Formel (3). In einer bevorzugten Ausführungsform der Erfindung stehen die Symbole X in dem Cyclus, der über das Kohlenstoffatom an das Iridium koordiniert, gleich oder verschieden bei jedem Auftreten für CR. Insbesondere bevorzugt stehen alle Symbole X und Y gleich oder verschieden bei jedem Auftreten für CR.

Bevorzugte Ausführungsformen der Formel (2) sind die Strukturen der folgenden Formeln (4) bis (12), 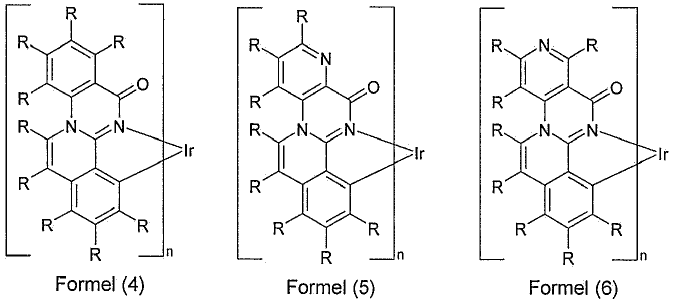 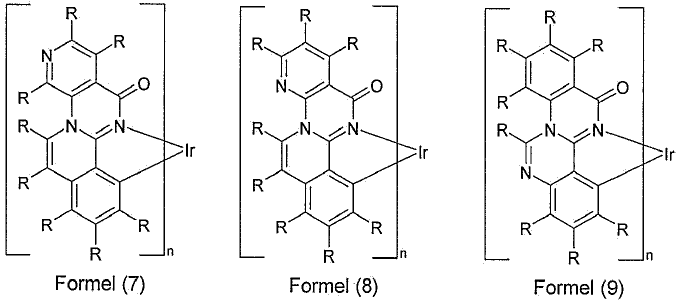 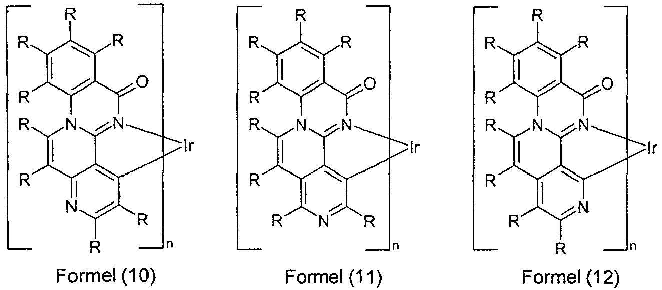 wobei die verwendeten Symbole und Indizes die oben genannten Bedeutungen aufweisen.

Bevorzugte Teilstrukturen MLₙ, in denen die beiden Symbole Y zusammen für eine Gruppe der Formel (3) stehen, sind die Strukturen der folgenden Formeln (13) bis (24), 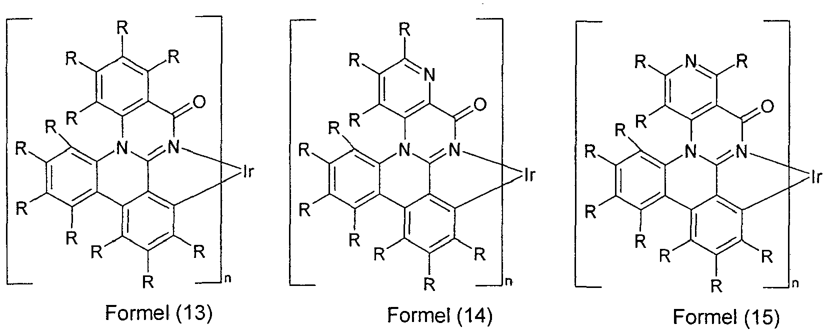 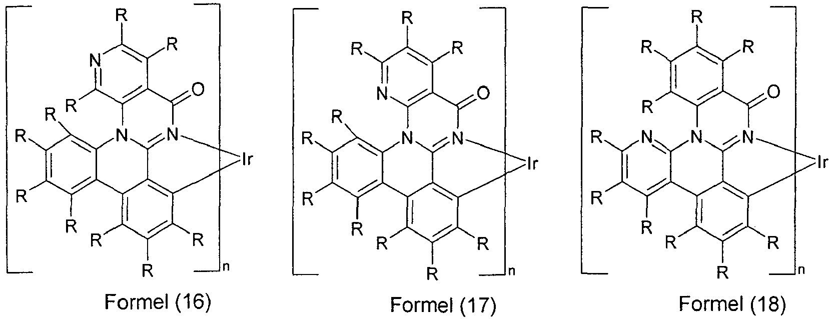 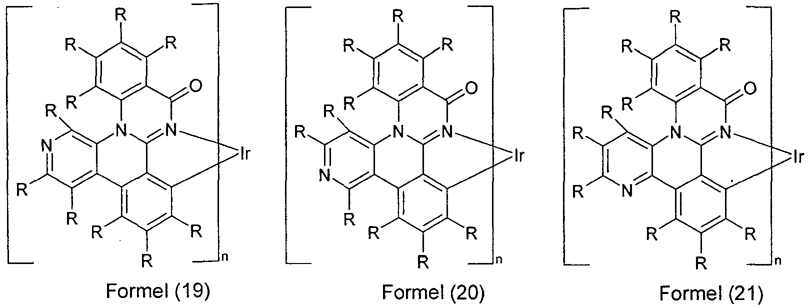 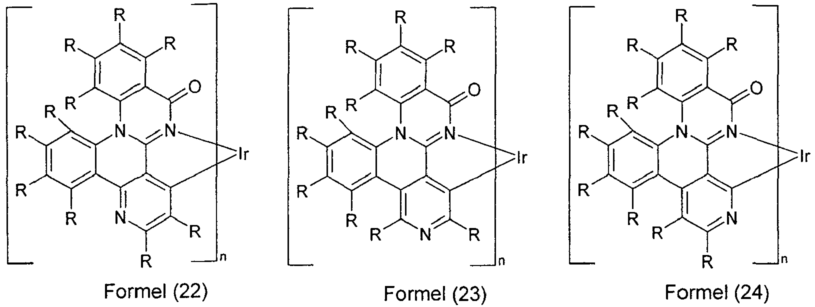 wobei die verwendeten Symbole und Indizes die oben genannten Bedeutungen aufweisen.

Dabei ist in den oben genannten Strukturen der Rest R, der in ortho-Position zur Koordination an das Iridium gebunden ist, bevorzugt ausgewählt aus der Gruppe bestehend aus H, D, F und Methyl.

Durch Ringbildung der Substituenten R können auch größere kondensierte Liganden L entstehen. Dies ist exemplarisch an den Strukturen der folgenden Formeln (4a) bis (4e) abgebildet, wobei eine Ringbildung an den anderen der oben genannten Liganden ebenso möglich ist, 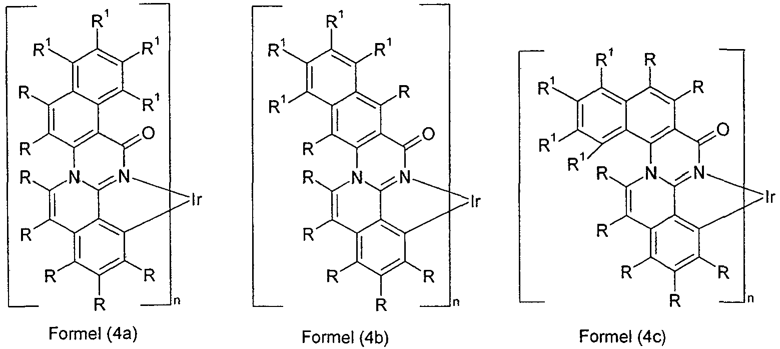 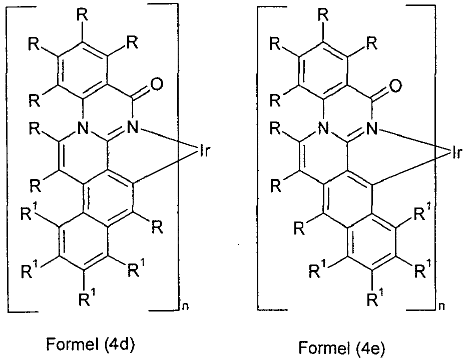 wobei die verwendeten Symbole und Indizes die oben genannten Bedeutungen aufweisen.

Wenn eine oder mehrere Gruppen X oder Y in den Teilstrukturen der Formel (2) für N stehen, wenn es sich also beispielsweise um Teilstrukturen der Formeln (5) bis (12) oder (14) bis (24) handelt, ist es bevorzugt, wenn benachbart zu diesem Stickstoffatom eine Gruppe R als Substituent gebunden ist, welche ungleich Wasserstoff oder Deuterium ist. Dabei ist dieses R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden. Dabei handelt es sich dann bevorzugt um Strukturen der Formel (25) oder (26), wie sie unten genauer beschrieben sind.

Wenn der Rest R, der einem Stickstoffatom benachbart ist, für eine Alkylgruppe steht, dann weist diese Alkylgruppe bevorzugt 3 bis 10 C-Atome auf. Bevorzugt handelt es sich weiterhin um eine sekundäre oder tertiäre Alkylgruppe, bei der das sekundäre oder tertiäre C-Atom entweder direkt an den Liganden gebunden ist oder über eine CH₂-Gruppe an den Liganden gebunden ist. Besonders bevorzugt ist diese Alkylgruppe ausgewählt aus den Strukturen der folgenden Formeln (R-1) bis (R-33), wobei jeweils auch die Anknüpfung dieser Gruppen an den Liganden mit eingezeichnet ist: 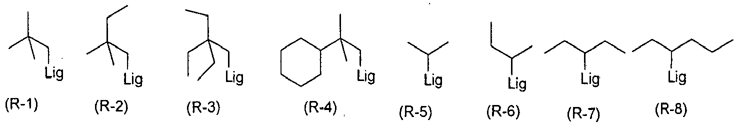 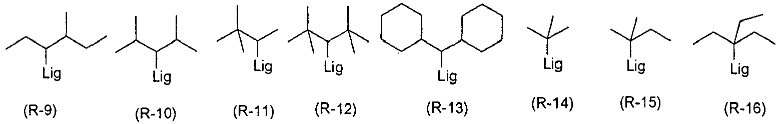 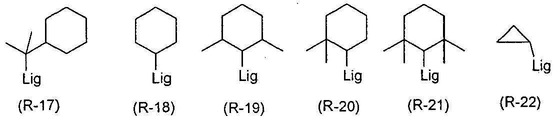 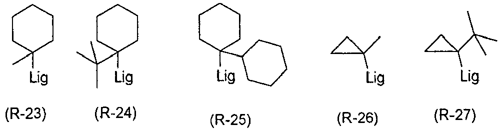 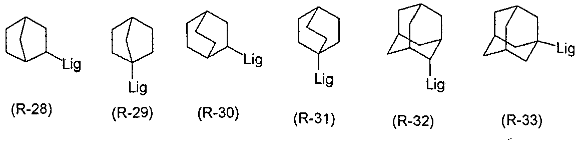 wobei Lig die Anknüpfung der Alkylgruppe an den Liganden kennzeichnet.

Wenn der Rest R, der einem Stickstoffatom benachbart ist, für eine Alkoxygruppe steht, dann weist diese Alkoxygruppe bevorzugt 3 bis 10 C-Atome auf. Bevorzugt ist diese Alkoxygruppe ausgewählt aus den Strukturen der folgenden Formeln (R-34) bis (R-47), wobei jeweils auch die Anknüpfung dieser Gruppen an den Liganden mit eingezeichnet ist: 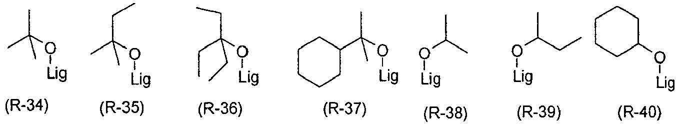 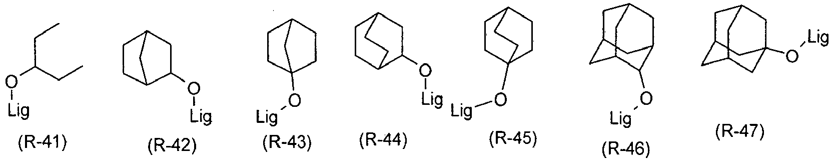 wobei Lig die Anknüpfung der Alkoxygruppe an den Liganden kennzeichnet.

Wenn der Rest R, der einem Stickstoffatom benachbart ist, für eine Dialkylaminogruppe steht, dann weist jede dieser Alkylgruppen bevorzugt 1 bis 8 C-Atome auf, besonders bevorzugt 1 bis 6 C-Atome. Beispiele für geeignete Alkylgruppen sind Methyl, Ethyl oder die oben als Gruppen (R-1) bis (R-33) aufgeführten Strukturen. Besonders bevorzugt ist die Dialkylaminogruppe ausgewählt aus den Strukturen der folgenden Formeln (R-48) bis (R-55), wobei jeweils auch die Anknüpfung dieser Gruppen an den Liganden mit eingezeichnet ist: 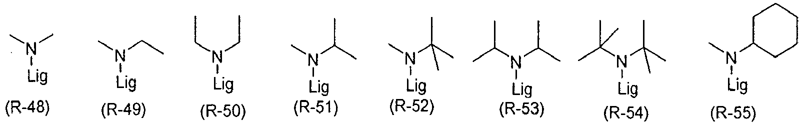 wobei Lig die Anknüpfung der Dialkylaminogruppe an den Liganden kennzeichnet.

Wenn der Rest R, der einem Stickstoffatom benachbart ist, für eine Aralkylgruppe steht, dann ist diese Aralkylgruppe bevorzugt ausgewählt aus den Strukturen der folgenden Formeln (R-56) bis (R-69), wobei jeweils auch die Anknüpfung dieser Gruppen an den Liganden eingezeichnet ist: 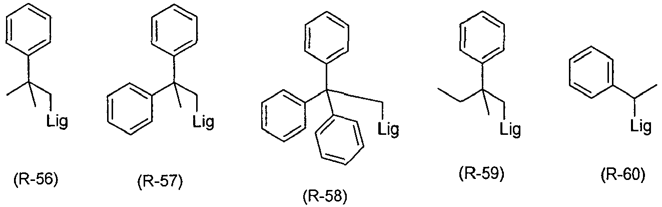 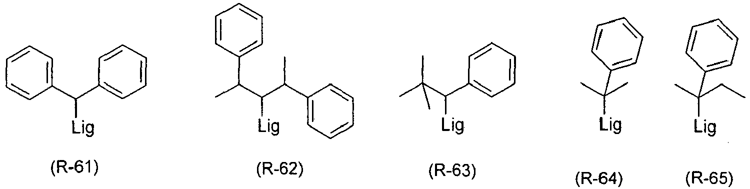 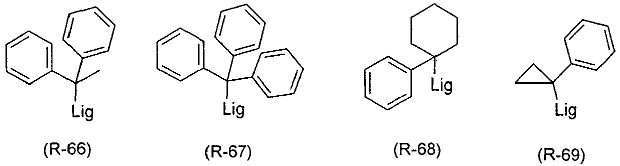 wobei Lig die Anknüpfung der Aralkylgruppe an den Liganden kennzeichnet und die Phenylgruppen jeweils durch einen oder mehrere Reste R¹ substituiert sein können.

Wenn der Rest R, der einem Stickstoffatom benachbart ist, für ein aromatisches bzw. heteroaromatisches Ringsystem steht, dann weist dieses aromatische bzw. heteroaromatische Ringsystem bevorzugt 5 bis 30 aromatische Ringatome auf, besonders bevorzugt 5 bis 24 aromatische Ringatome. Weiterhin enthält dieses aromatische bzw. heteroaromatische Ringsystem bevorzugt keine Aryl- bzw. Heteroarylgruppen, in denen mehr als zwei aromatische Sechsringe direkt aneinander kondensiert sind. Besonders bevorzugt enthält das aromatische bzw. heteroaromatische Ringsystem überhaupt keine kondensierten Aryl- bzw. Heteroarylgruppen, und ganz besonders bevorzugt enthält es nur Phenylgruppen. Dabei ist das aromatische Ringsystem bevorzugt ausgewählt aus den Strukturen der folgenden Formeln (R-70) bis (R-88), wobei jeweils auch die Anknüpfung dieser Gruppen an den Liganden eingezeichnet ist: 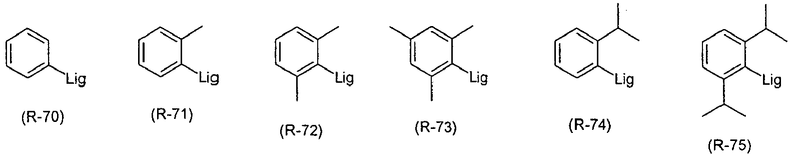 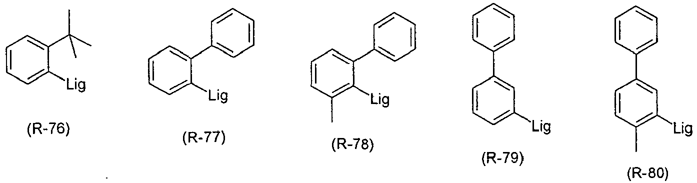 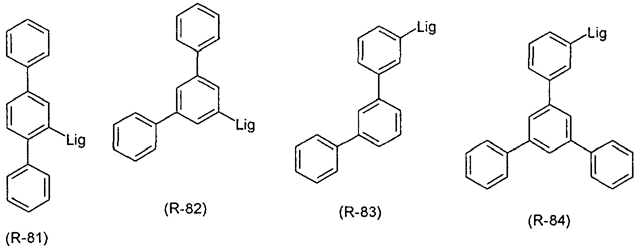 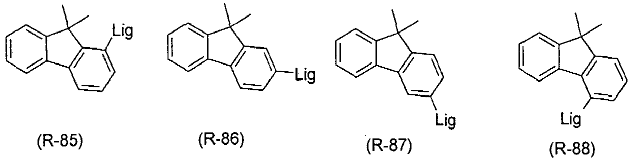 wobei Lig die Anknüpfung des aromatischen Ringsystems an den Liganden kennzeichnet und die Phenylgruppen jeweils durch einen oder mehrere Reste R¹ substituiert sein können.

Weiterhin ist das heteroaromatische Ringsystem bevorzugt ausgewählt aus den Strukturen der folgenden Formeln (R-89) bis (R-119), wobei jeweils auch die Anknüpfung dieser Gruppen an den Liganden eingezeichnet ist: 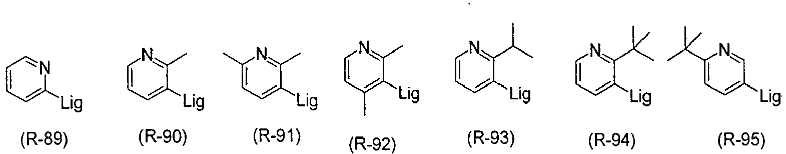 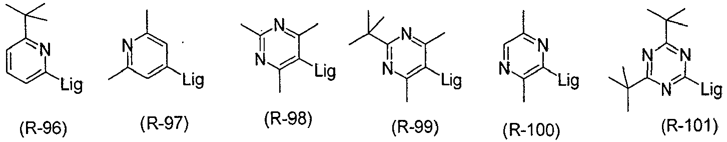 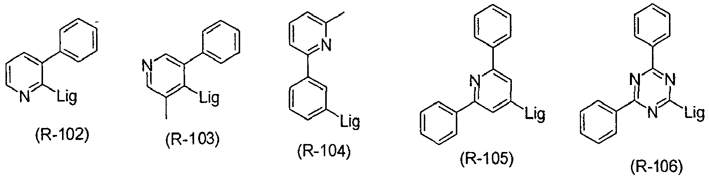 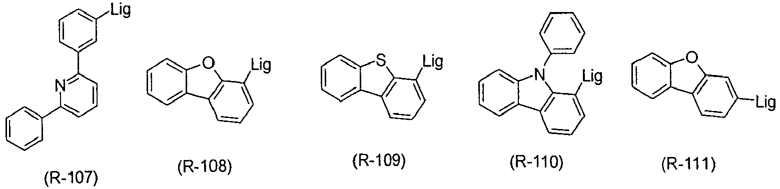 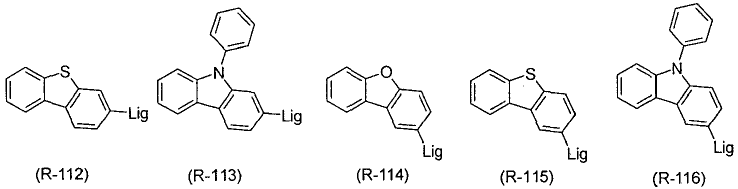 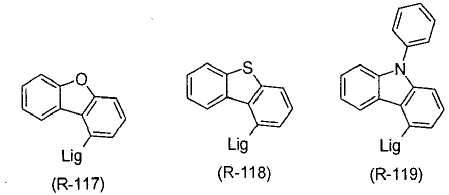 wobei Lig die Anknüpfung des heteroaromatischen Ringsystems an den Liganden kennzeichnet und die aromatischen und heteroaromatischen Gruppen jeweils durch einen oder mehrere Reste R¹ substituiert sein können.

In einer bevorzugten Ausführungsform der Erfindung bilden benachbarte Reste R und/oder R¹ keinen Ring miteinander.

In einer anderen bevorzugten Ausführungsform stehen in der Teilstruktur der Formel (2) zwei benachbarte Gruppen X für CR und/oder zwei benachbarte Reste Y für CR und die jeweiligen Reste R spannen zusammen mit den C-Atomen einen Ring gemäß einer der folgenden Formeln (25) bis (31) auf; ebenso ist es bevorzugt, wenn in den Teilstrukturen der Formeln (4) bis (24) zwei Reste R, die an direkt aneinander gebundene C-Atome binden, zusammen mit den C-Atomen, an die sie binden, einen Ring miteinander bilden, so dass sich eine der Strukuren gemäß einer der folgenden Formeln (25) bis (31) ergibt: 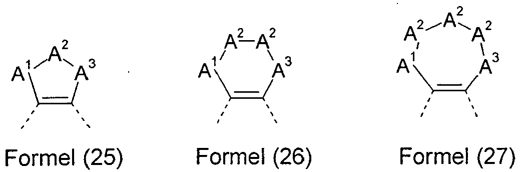 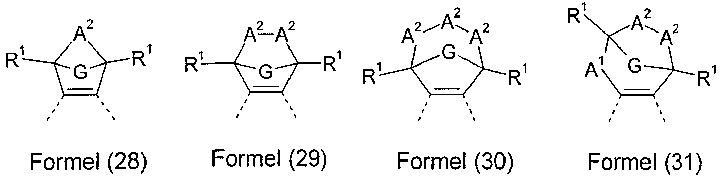 wobei R¹ und R² die oben genannten Bedeutungen aufweisen, wobei mehrere R¹ auch miteinander verknüpft sein können und so ein weiteres Ringsystem aufspannen können, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, O, S, NR³ oder C(=O);
- A²: ist gleich oder verschieden bei jedem Auftreten C(R¹)₂, O, S, NR³ oder C(=O); oder A²-A² in Formel (26), (27), (28), (29), (30) oder (31) kann außer für eine Kombination der oben genannten Gruppen für -CR²=CR²- oder eine ortho-verknüpfte Arylen- oder Heteroarylengruppe mit 5 bis 14 aromatischen Ringatomen, welche durch einen oder mehrere Reste R² substituiert sein kann, stehen;
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

Die Gruppen der Formel (25) bis (31) können in jeder Position der Teilstruktur der Formel (2) vorliegen, in der zwei Gruppen X bzw. zwei Gruppen Y direkt aneinander gebunden sind. Bevorzugte Positionen, in denen eine Gruppe der Formel (25) bis (31) vorliegt, sind die Teilstrukturen der folgenden Formeln (2a), (2b) und (2c), 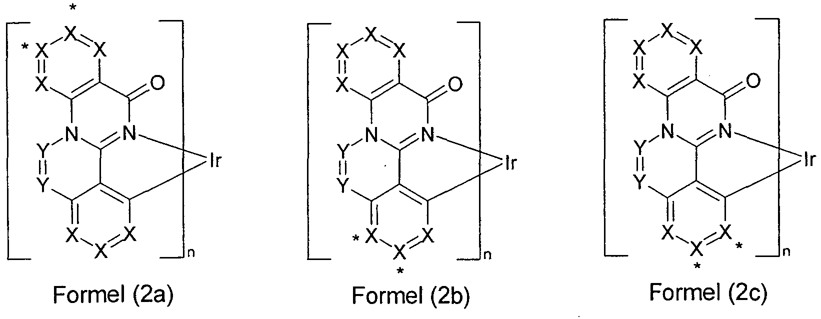 wobei die verwendeten Symbole und Indizes die oben genannten Bedeutungen aufweisen und * jeweils die Position anzeigt, an der die beiden benachbarten Gruppen X für CR stehen und die jeweiligen Reste R zusammen mit den C-Atomen einen Ring der einer der Formeln (25) bis (31) aufspannen.

In den oben abgebildeten Strukturen der Formeln (25) bis (31) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, da diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wesentlich bei den Gruppen der Formeln (25) bis (31) ist, dass diese keine aziden benzylischen Protonen aufweisen. Unter benzylischen Protonen werden Protonen verstanden, die an ein Kohlenstoffatom binden, welches direkt an den Liganden gebunden sind. Die Abwesenheit von aziden benzylischen Protonen wird in Formel (25) bis (27) dadurch erreicht, dass A¹ und A³, wenn diese für C(R³)₂ stehen, so definiert sind, dass R³ ungleich Wasserstoff ist. Die Abwesenheit von aziden benzylischen Protonen ist in Formel (28) bis (31) dadurch erreicht, dass es sich dabei um bicyclische Strukturen handelt. Aufgrund der starren räumlichen Anordnung ist R¹, wenn es für H steht, deutlich weniger azide als benzylische Protonen, da das korrespondierende Anion der bicyclischen Struktur nicht mesomeriestabilisiert ist. Auch wenn R¹ in Formel (28) bis (31) für H steht, handelt es sich dabei daher um ein nicht-azides Proton im Sinne der vorliegenden Anmeldung.

In einer bevorzugten Ausführungsform der Struktur gemäß Formel (25) bis (31) steht maximal eine der Gruppen A¹, A² und A³ für ein Heteroatom, insbesondere für O oder NR³, und die anderen Gruppen stehen für C(R³)₂ bzw. C(R¹)₂ oder A¹ und A³ stehen gleich oder verschieden bei jedem Auftreten für O oder NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂. Bevorzugte Ausführungsformen der Formel (25) sind somit die Strukturen der Formel (25-A), (25-B), (25-C) und (25-D), und eine besonders bevorzugte Ausführungsform der Formel (25-A) sind die Strukturen der Formel (25-E) und (25-F), 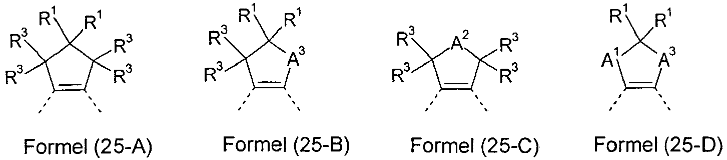 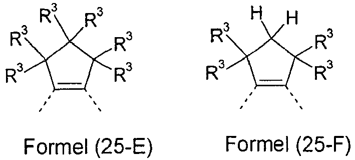 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (26) sind die Strukturen der folgenden Formeln (26-A) bis (26-F), 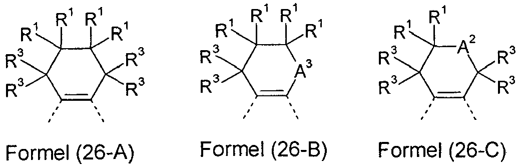 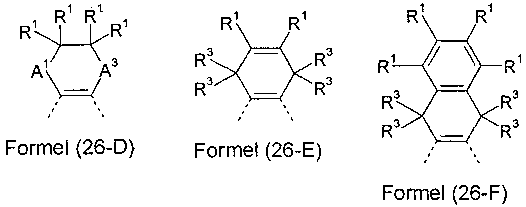 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (27) sind die Strukturen der folgenden Formeln (27-A) bis (27-E), 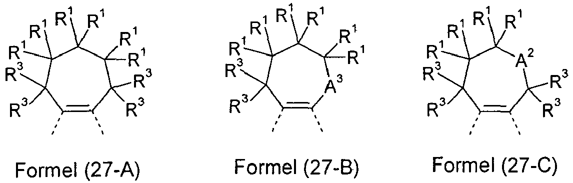 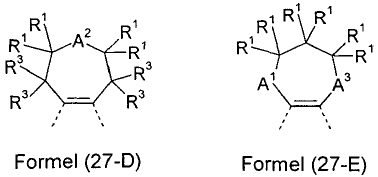 wobei R¹ und R³ die oben genannten Bedeutungen aufweisen und A¹, A² und A³ gleich oder verschieden bei jedem Auftreten für O oder NR³ steht.

In einer bevorzugten Ausführungsform der Struktur gemäß Formel (28) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (28) sind somit eine Strukturen der Formel (28-A) und (28-B), und eine besonders bevorzugte Ausführungsform der Formel (28-A) ist eine Struktur der Formel (28-C), 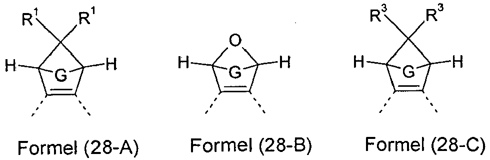 wobei die verwendeten Symbole die oben genannten Bedeutungen aufweisen.

In einer bevorzugten Ausführungsform der Struktur gemäß Formel (29), (30) und (31) stehen die Reste R¹, die an den Brückenkopf gebunden sind, für H, D, F oder CH₃ besonders bevorzugt für H. Weiterhin bevorzugt steht A² für C(R¹)₂. Bevorzugte Ausführungsformen der Formel (29), (30) und (31) sind somit die Strukturen der Formeln (29-A), (30-A) und (31-A), 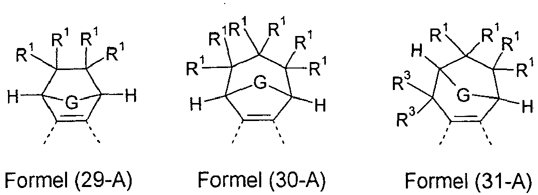 wobei die verwendeten Symbole die oben genannten Bedeutungen aufweisen.

Weiterhin bevorzugt steht die Gruppe G in den Formeln (28), (28-A), (28-B), (28-C), (29), (29-A), (29), (29-A), (29) und (29-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (25) bis (31) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (25) bis (31) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (25) sind die im Folgenden aufgeführten Gruppen:

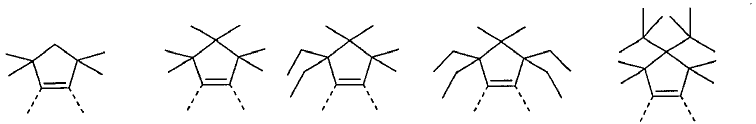

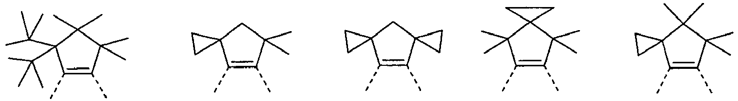

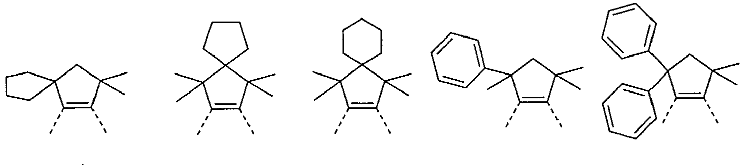

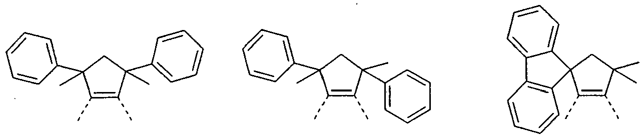

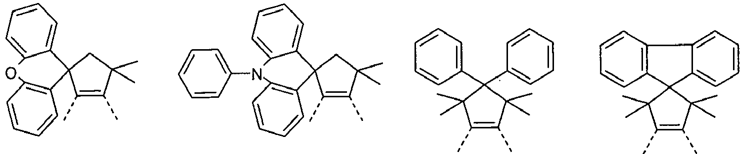

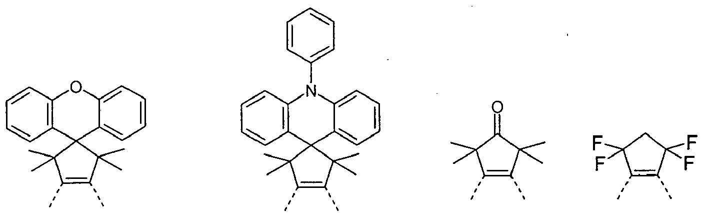

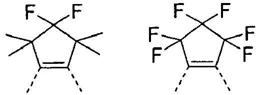

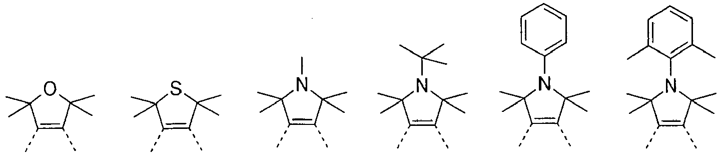

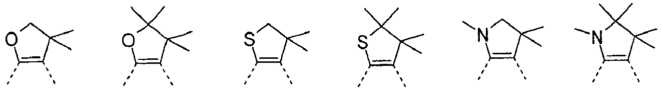

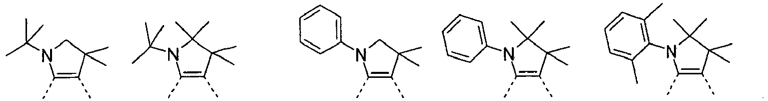

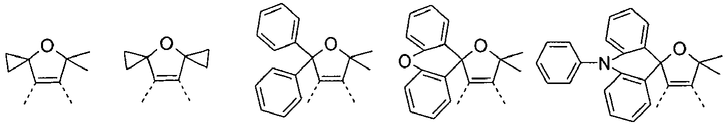

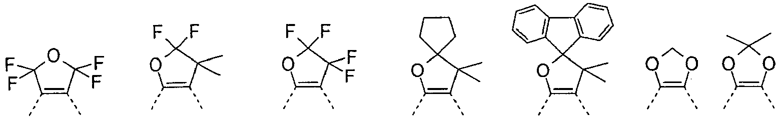

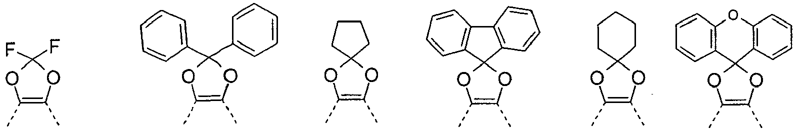

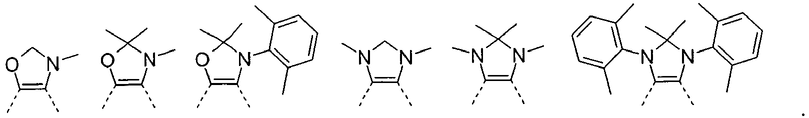

Beispiele für besonders geeignete Gruppen der Formel (26) sind die im Folgenden aufgeführten Gruppen:

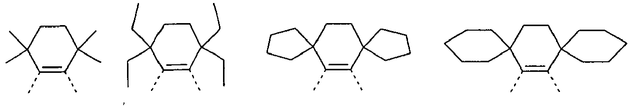

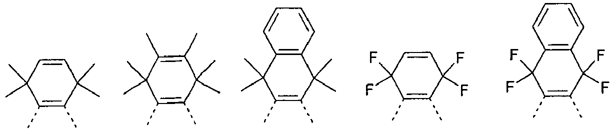

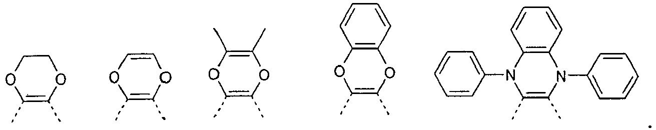

Beispiele für besonders geeignete Gruppen der Formel (26), (30) und (31) sind die im Folgenden aufgeführten Gruppen:

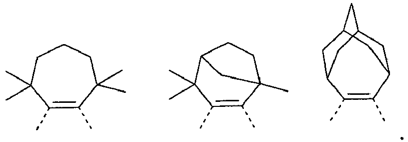

Beispiele für besonders geeignete Gruppen der Formel (28) sind die im Folgenden aufgeführten Gruppen:

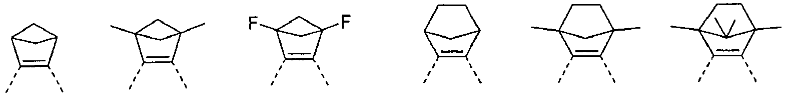

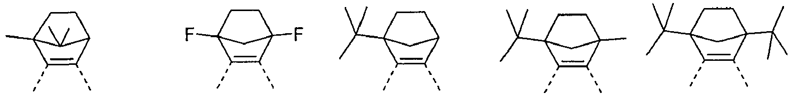

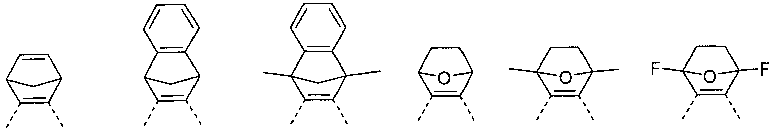

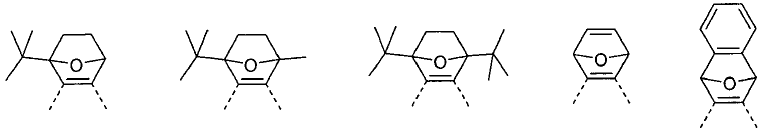

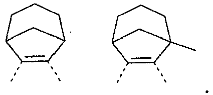

Beispiele für besonders geeignete Gruppen der Formel (29) sind die im Folgenden aufgeführten Gruppen:

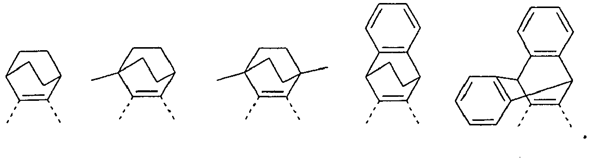

Insbesondere die Verwendung derartiger ankondensierter bicyclischer Strukturen kann aufgrund der Chiralität der Strukturen auch zu chiralen Liganden L führen. Hier kann sowohl die Verwendung enantiomerenreiner Liganden wie auch die Verwendung des Racemats geeignet sein. Es kann auch insbesondere geeignet sein, im erfindungsgemäßen Metallkomplex nicht nur ein Enantiomer von einem Liganden zu verwenden, sondern gezielt beide Enantiomere, so dass beispielsweise ein Komplex (+L)₂(-L)M oder ein Komplex (+L)(-L)₂M entsteht, wobei +L bzw. -L jeweils das entsprechende + bzw - Enantiomer des Liganden kennzeichnen. Dies kann Vorteile bezüglich der Löslichkeit des entsprechenden Komplexes gegenüber Komplexen, die nur +L oder nur -L als Ligand enthalten, haben.

Wenn in der Teilstruktur der Formel (2) noch weitere bzw. andere Reste R gebunden sind, so sind diese Reste R bei jedem Auftreten gleich oder verschieden bevorzugt ausgewählt aus der Gruppe bestehend aus H, D, F, N(R¹)₂, CN, Si(R¹)₃, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch F ersetzt sein können, oder einem aromatischen oder heteroaromatischen Ringsystem mit 5 bis 18 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden. Wenn es sich um ein aromatisches oder heteroaromatisches Ringsystem handelt, ist es bevorzugt, wenn dieses nicht mehr als zwei direkt aneinander ankondensierte aromatische 6-Ringe aufweist, insbesondere überhaupt keine direkt aneinander ankondensierten aromatischen 6-Ringe.

Im Folgenden werden bevorzugte Liganden L' beschrieben, wie sie in Formel (1) vorkommen.

In einer bevorzugten Ausführungsform der Erfindung handelt es sich bei dem Liganden L' um einen monoanionischen Liganden, der aus zwei der Gruppen der Formel (32) bis (59) gebildet wird, wobei eine dieser Gruppen über ein negativ geladenes Kohlenstoffatom und die andere dieser Gruppen über ein neutrales Stickstoffatom an das Iridium koordiniert.

Ebenfalls kann es bevorzugt sein, wenn zwei benachbarte Symbole X in diesen Liganden für eine Gruppe der oben genannten Formel (25) oder (26) stehen.

Die weiteren bevorzugten Reste R in den oben aufgeführten Strukturen sind definiert wie die Reste R des Liganden L.

Die Liganden L und L' können je nach Struktur auch chiral sein. Dies ist insbesondere dann der Fall, wenn sie eine bicyclische Gruppe der Formel (28) bis (31) enthalten oder wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln bei Raumtemperatur in ausreichender Konzentration löslich, um die Komplexe aus Lösung verarbeiten zu können, beispielsweise durch Druckverfahren.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der erfindungsgemäßen Verbindungen gemäß Formel (1) durch Umsetzung der entsprechenden freien Liganden mit Iridiumalkoholaten der Formel (60), mit Iridiumketoketonaten der Formel (61), mit Iridiumhalogeniden der Formel (62) oder mit dimeren Iridiumkomplexen der Formel (63) oder (64), 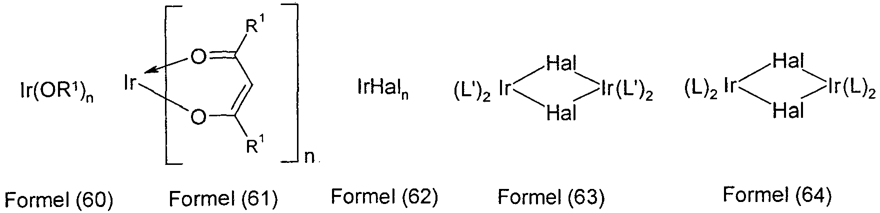 wobei die Symbole und Indizes L', m, n und R¹ die oben angegebenen Bedeutungen haben und Hal = F, Cl, Br oder I ist.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet ist [IrCl₂(acac)₂]⁻, beispielsweise Na[IrCl₂(acac)₂]. Weitere besonders geeignete Iridiumedukte sind Iridium(III)-tris(acetylacetonat) und Iridium(III)-tris(2,2,6,6-tetramethyl-3,5-heptandionat).

Die Synthese der Komplexe wird bevorzugt durchgeführt wie in WO 2002/060910 und in WO 2004/085449 beschrieben. Die heteroleptischen Komplexe können beispielsweise gemäß WO 05/042548 synthetisiert werden. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Zur Synthese der erfindungsgemäßen Komplexe kann bevorzugt gemäß Schema 1 vorgegangen werden. Zunächst werden durch Umsetzung der freien Liganden L-H mit einem geeigneten Ir-Precursor, bevorzugt Iridium-(III)chlorid-Hydrat, in Gegenwart eines protischen Lösungsmittels oder Lösungsmittelgemischs die chloro-verbrückten dimeren Iridiumkomplexe erhalten, die dann mit einem Liganden L', gegebenenfalls unter Zusatz von Additiven wie Basen oder Salzen (WO 2007/065523) weiter umgesetzt werden.

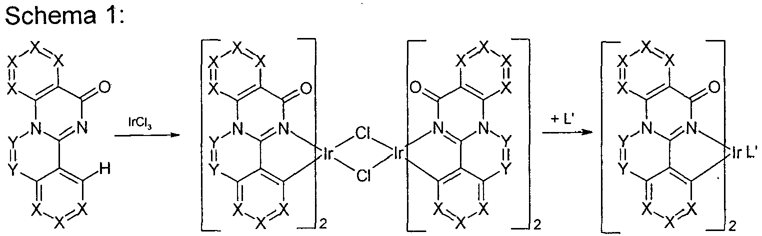

Völlig analog kann die Darstellung heteroleptischer Iridium-Komplexe ausgehend von dem Chloro-verbrückten Dimer [(L')₂IrCl]₂ durch Umsetzung mit dem freien Liganden L-H erfolgen (Schema 2).

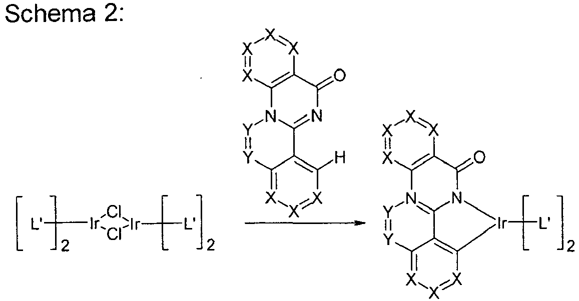

Üblicherweise fallen bei diesen Verfahren Gemische enthaltend Komplextypen der Formel Ir(L)₂(L') und der Formel Ir(L)(L')₂ an, die chromatographisch getrennt werden können. Die relativen Mengen an den Komplextypen der Formel Ir(L)₂(L') und der Formel Ir(L)(L')₂ können durch das stöchiometrische Verhältnis von [Ir(L)₂Cl]₂ zu Ligand L' gesteuert werden. So entsteht bei einem stöchiometrischen Verhältnis von [Ir(L)₂Cl]₂ zu L' von 1:2 bis ca. 1:6 mehrheitlich das Produkt der Formel Ir(L)₂(L'), dagegen bei einem stöchiometrischen Verhältnis von [Ir(L)₂Cl]₂ zu L' von ca. 1:8 bis ca. 1:25 mehrheitlich das Produkt der Formel Ir(L)(L')₂.

Statt ausgehend von dem Chloro-verbrückten Dimers kann die Synthese auch durch Umsetzung der Liganden L mit Iridiumkomplexen der Formel [Ir(L')₂(HOMe)₂]A oder [Ir(L')₂(NCMe)₂]A oder durch Umsetzung der Liganden L' mit Iridiumkomplexen der Formel [Ir(L)₂(HOMe)₂]A oder [Ir(L)₂(NCMe)₂]A, wobei A jeweils ein nicht koordinierendes Anion wie z. B. Triflat, Tetrafluoroborat, Hexafluorophosphat, etc. darstellt, in dipolarprotischen Lösungsmitteln, wie z. B. Ethylenglykol, Propylenglykol, Glycerin, Diethylenglykol, Triethylenglykol, etc., durchgeführt werden.

Bei einem stöchiometrischen Verhältnis von [Ir(L')₂(HOMe)₂]A oder [Ir(L')₂(NCMe)₂]A zu L von 1:1 werden überwiegend die Komplexe der Formel Ir(L)(L')₂ erhalten. Bei einem stöchiometrischen Verhältnis von [Ir(L')₂(HOMe)₂]A oder [Ir(L')₂(NCMe)₂]A zu L von 1:2 oder größer fallen im Wesentlichen die Komplexe der Formel Ir(L)₂(L') an, so dass diese Methode gut geeignet ist, diese Komplexe in guter Ausbeute darzustellen. Die Rohprodukte enthaltend die beiden Komplextypen der Formel Ir(L)₂(L') und der Formel Ir(L)(L')₂ können chromatographisch getrennt und so gereinigt werden.

Mit den hier erläuterten Synthesemethoden lassen sich unter anderem die im Folgenden dargestellten erfindungsgemäßen Strukturen herstellen.

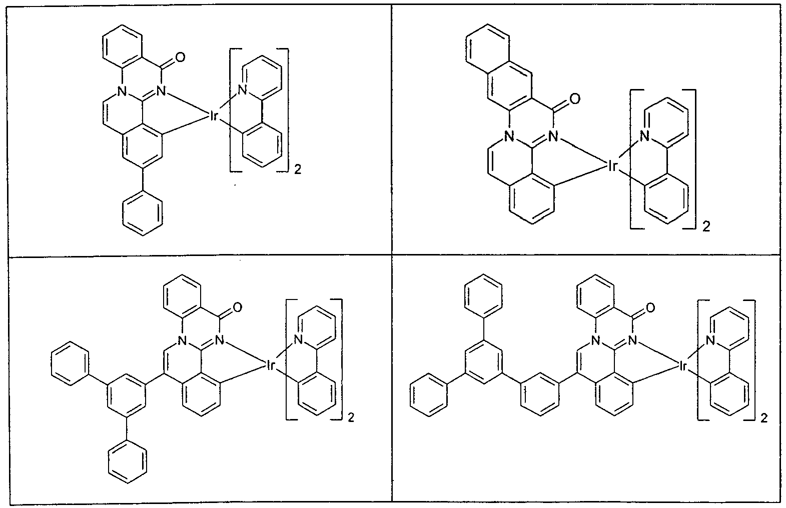

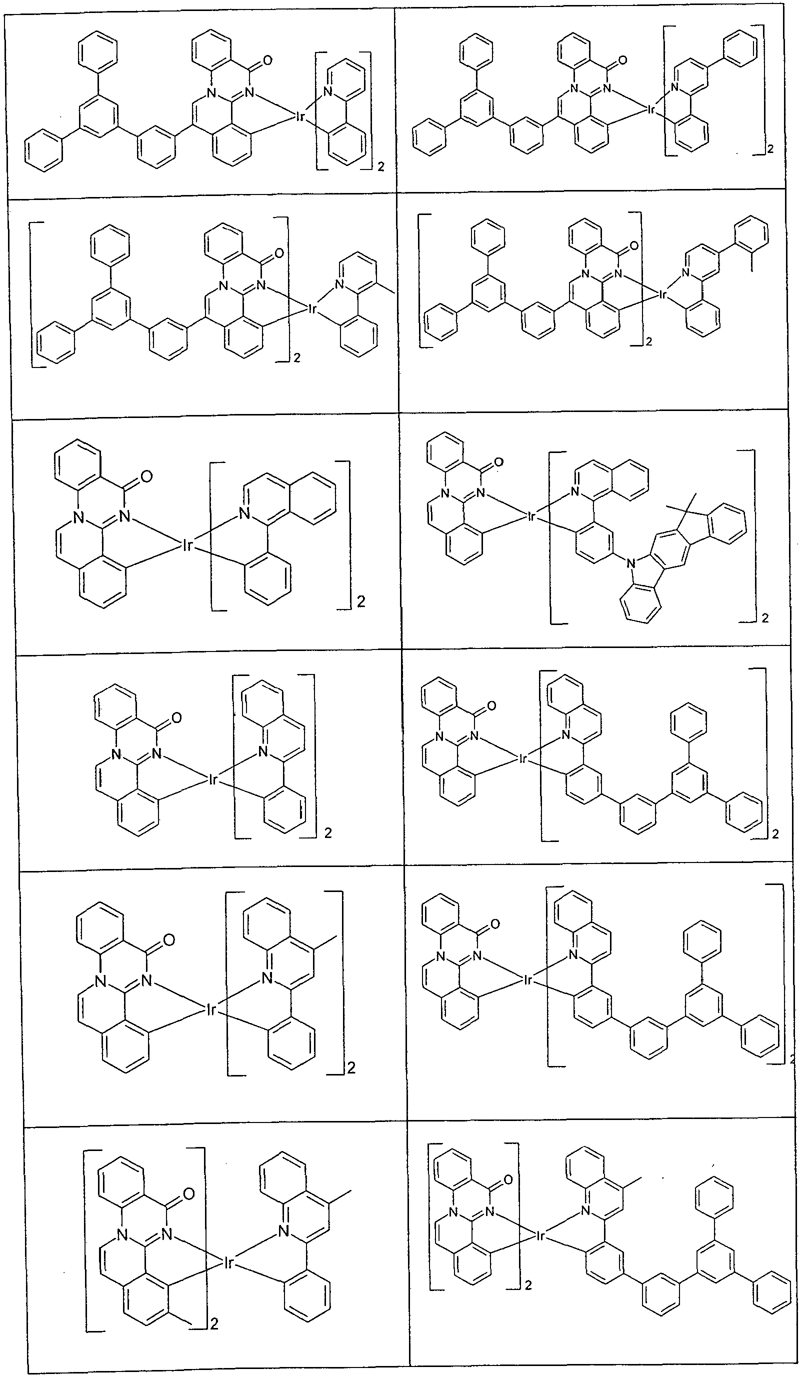

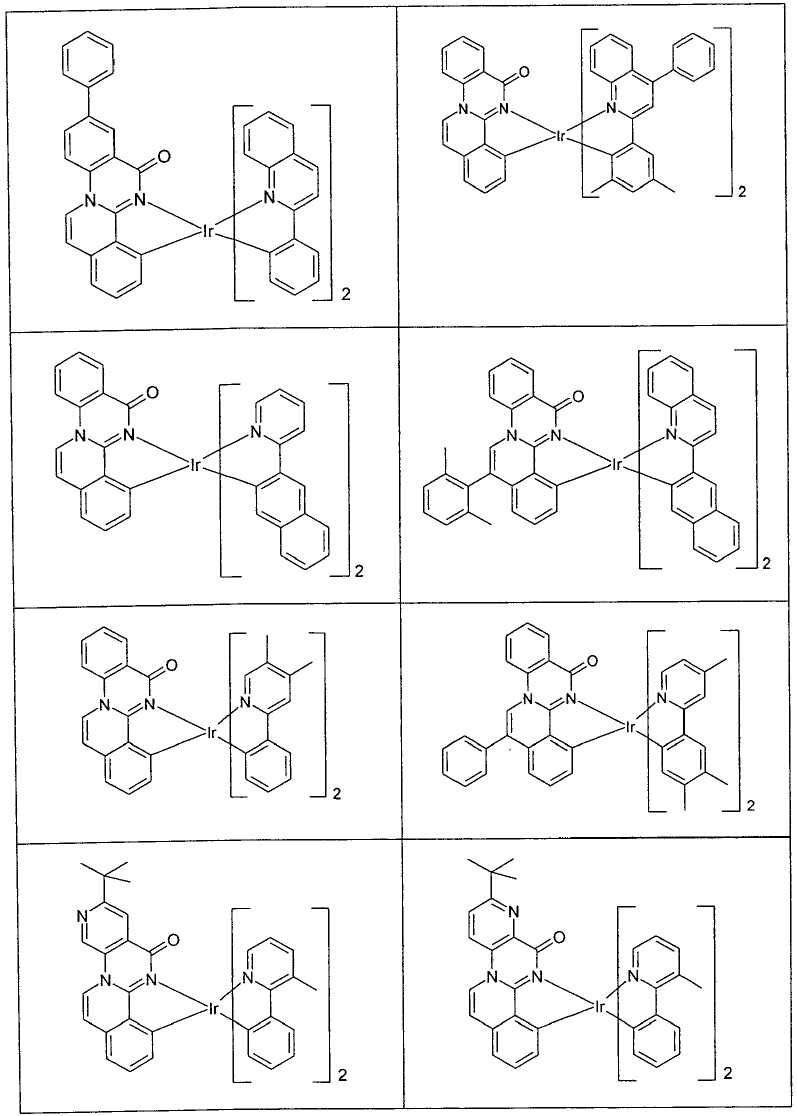

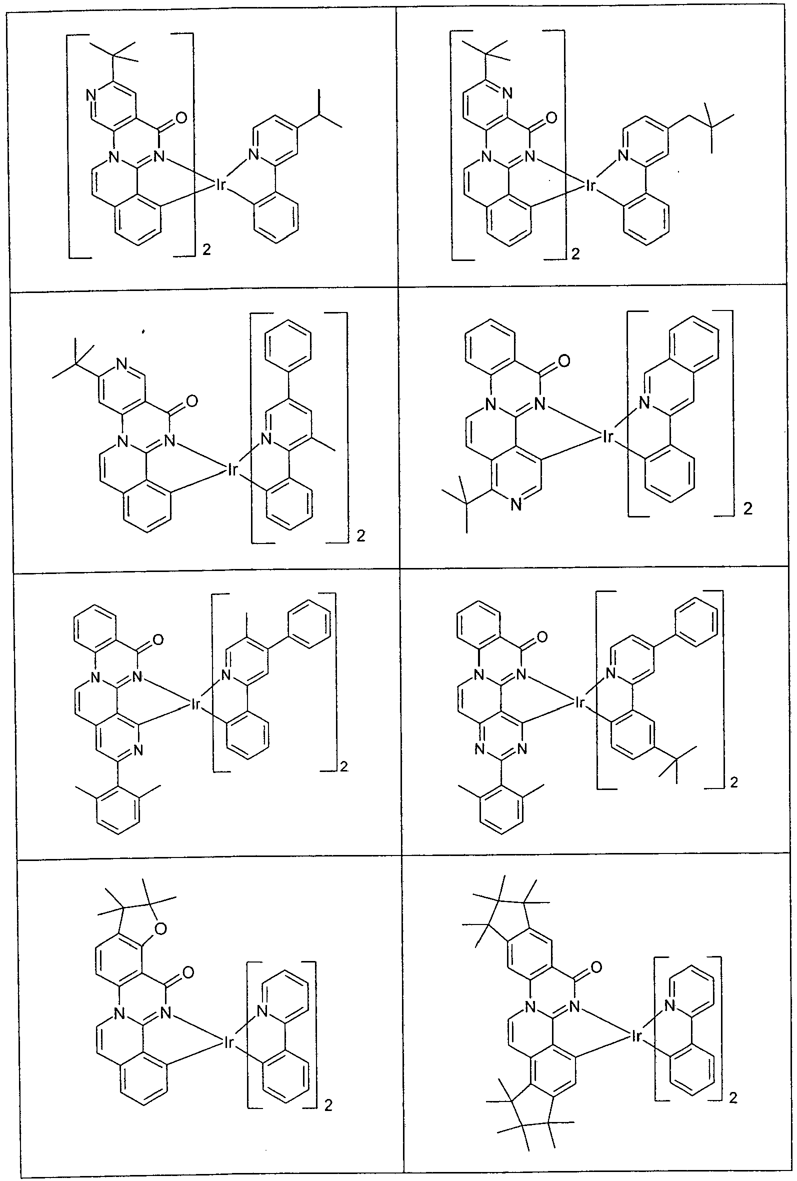

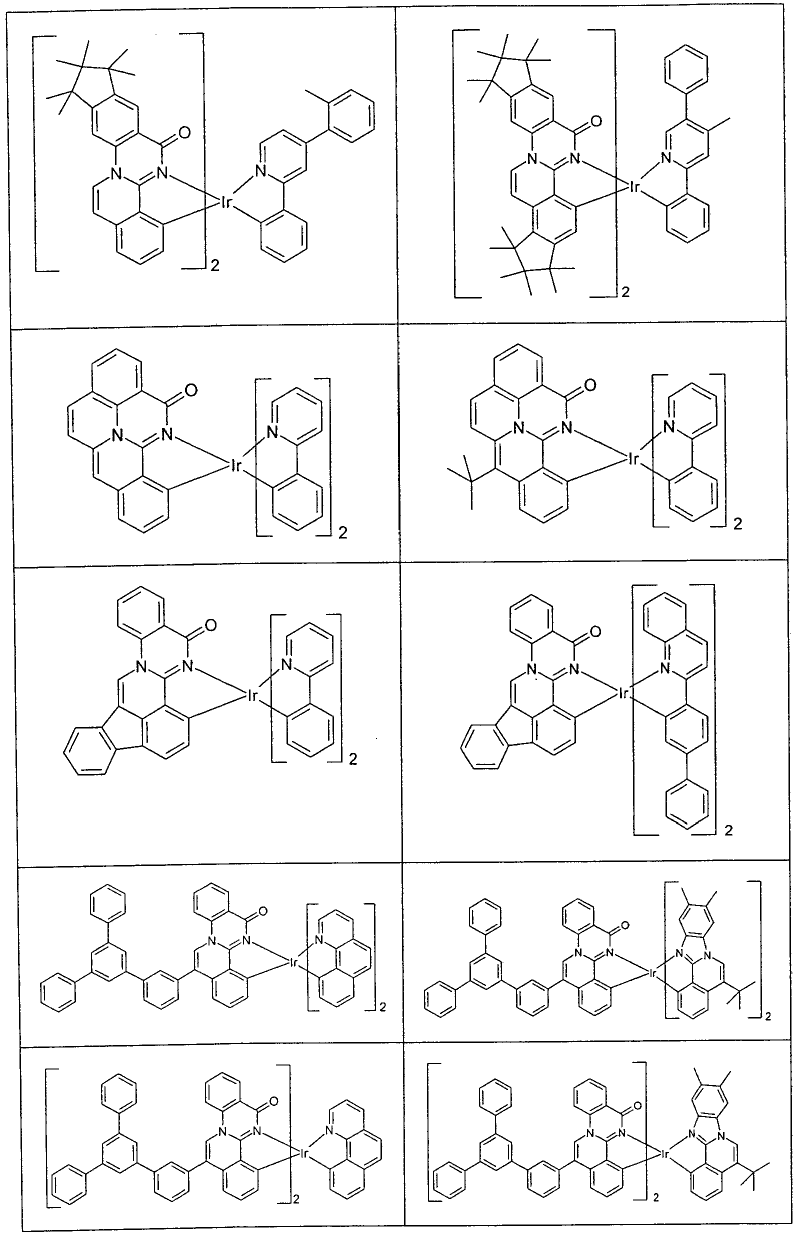

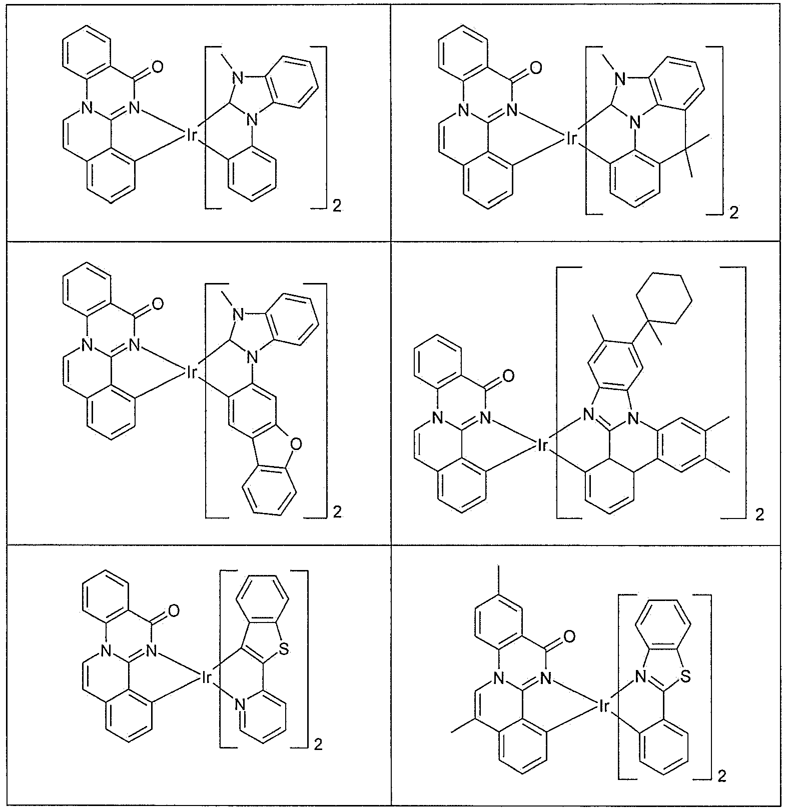

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, enthaltend eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Geeignete Matrixmaterialien sind hinten im Zusammenhang mit der organischen Elektrolumineszenzvorrichtung aufgeführt. Diese weitere Verbindung kann auch polymer sein.

Die oben beschriebenen Komplexe gemäß Formel (1) bzw. die oben aufgeführten bevorzugten Ausführungsformen können in einer elektronischen Vorrichtung als aktive Komponente verwendet werden. Ein weiterer Gegenstand der vorliegenden Erfindung ist daher die Verwendung einer Verbindung nach Formel (1) bzw. nach einer der bevorzugten Ausführungsformen in einer elektronischen Vorrichtung. Weiterhin können die erfindungsgemäßen Verbindungen zur Erzeugung von Singulett-Sauerstoff, in der Photokatalyse oder in Sauerstoffsensoren eingesetzt werden.

Nochmals ein weiterer Gegenstand der vorliegenden Erfindung ist eine elektronische Vorrichtung enthaltend mindestens eine Verbindung gemäß Formel (1) bzw. nach einer der bevorzugten Ausführungsformen.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Eine bevorzugte Ausführungsform sind Dreischichtsysteme, wobei die drei Schichten blaue, grüne und orange oder rote Emission zeigen (siehe z. B. WO 2005/011013) bzw. Systeme, welche mehr als drei emittierende Schichten aufweisen. Eine weitere bevorzugte Ausführungsform sind Zweischichtsysteme, wobei die beiden Schichten entweder blaue und gelbe oder blaugrüne und orange Emission zeigen. Zweischichtsysteme sind insbesondere für Beleuchtungsanwendungen von Interesse. Solche Ausführungsformen sind mit den erfindungsgemäßen Verbindungen besonders geeignet, da diese häufig gelbe bzw. orange Emission zeigen. Die weiß emittierenden Elektrolumineszenzvorrichtungen können für Beleuchtungsanwendungen oder als Backlight für Displays oder mit Farbfilter als Display eingesetzt werden.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bzw. der Matrixmaterialien bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Berylliumkomplexe, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen. Hierfür eignen sich insbesondere Mischungen aus mindestens einem elektronentransportierenden Matrixmaterial und mindestens einem lochtransportierenden Matrixmaterial oder Mischungen aus mindestens zwei elektronentransportierenden Matrixmaterialien oder Mischungen aus mindestens einem loch- oder elektronentransportierenden Matrixmaterial und mindestens einem weiteren Material mit einer großen Bandlücke, welches somit weitgehend elektrisch inert ist und nicht oder nicht in wesentlichem Umfang am Ladungstransport teilnimmt, wie z. B. in WO 2010/108579 beschrieben. Eine bevorzugte Kombination ist beispielsweise die Verwendung eines aromatischen Ketons oder eines Triazinderivats mit einem Triarylamin-Derivat oder einem Carbazol-Derivat als gemischte Matrix für den erfindungsgemäßen Metallkomplex.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise blau oder grün emittierende Triplettemitter als Co-Matrix für die erfindungsgemäßen Komplexe gemäß Formel (1) eingesetzt werden.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

In den weiteren Schichten können generell alle Materialien verwendet werden, wie sie gemäß dem Stand der Technik für die Schichten verwendet werden und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Organische Elektrolumineszenzvorrichtungen enthaltend Verbindungen gemäß Formel (1) als emittierende Materialien weisen eine sehr gute Lebensdauer auf.
2. Organische Elektrolumineszenzvorrichtungen enthaltend Verbindungen gemäß Formel (1) als emittierende Materialien weisen eine sehr gute Effizienz auf.
3. Organische Elektrolumineszenzvorrichtungen enthaltend Verbindungen gemäß Formel (1) als emittierende Materialien weisen eine sehr niedrige Betriebsspannung auf.

Diese oben genannten Vorteile gehen nicht mit einer Verschlechterung der weiteren elektronischen Eigenschaften einher. Insbesondere sind die Lebensdauer und/oder die Effizienz der erfindungsgemäßen Verbindungen besser als die Lebensdauer bzw. Effizienz der entsprechenden homoleptischen Komplexe IrL₃.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße Verbindungen synthetisieren und diese in elektronischen Vorrichtungen verwenden und kann somit die Erfindung im gesamten offenbarten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z.B. von Sigma-ALDRICH bzw. ABCR bezogen werden. Die Nummern bei den literaturbekannten Verbindungen, die teilweise auch in eckigen Klammern angegeben sind, sind die CAS-Nummern der Verbindungen.

### A: Synthese von Synthonen, S

### Beispel S1: 5,6-Dibrom-1,1,2,2,3,3-hexamethyl-indan, S1

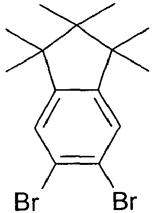

Eine Lösung von 101.2 g (500 mmol) 1,1,2,2,3,3-Hexamethyl-indan [91324-94-6] in 1000 ml Dichlormethan wird mit 1.3 g wasserfreiem Eisen-(III)chlorid versetzt und dann unter Lichtausschluss tropfenweise mit einer Mischung von 76.8 ml (1.5 mol) Brom und 100 ml Dichlormethan so versetzt, dass die Temperatur 25 °C nicht übersteigt; gegebenenfalls wird mit einem Kaltwasserbad gegengekühlt. Nach beendeter Zugabe rührt man die Reaktionsmischung 30 h bei 35 °C nach, versetzt dann langsam mit 1000 ml gesättigter Natriumsulfit-Lösung, trennt die wässrige Phase ab, wäscht die organische dreimal mit je 1000 ml Wasser, trocknet über Natriumsulfat, filtriert über eine kurze Säule aus Kieselgel und zieht dann das Lösungsmittel ab. Abschießend wird der Feststoff einmal aus Ethanol umkristallisiert. Ausbeute: 163.9 g (455 mmol), 91 %; Reinheit: ca. 98 %ig nach ¹H NMR.

Analog werden folgende Verbindungen dargestellt:

| Bsp. | Edukt | Produkt | Ausbeute |
|---|---|---|---|
| S2 | 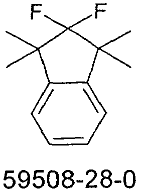 | 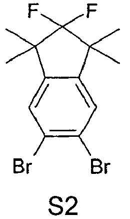 | 83 % |
| S3 | 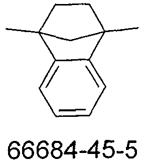 | 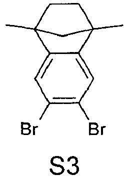 | 79 % |
| S4 | 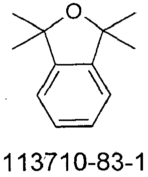 | 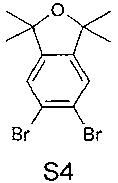 | 84 % |
| S5 | 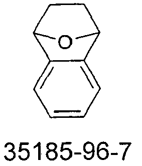 | 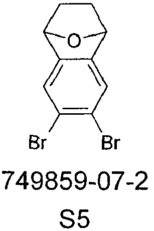 | 81 % |

### Beispiel S6: 7-Brom-1,2,3,4-tetrahydro-1,4-methano-naphthalin-6-carbonsäure, S6

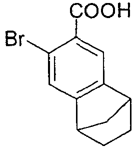

Durchführung analog J. Organomet. Chem., L. S. Chen et al., 1980, 193, 283-292. Eine auf -110 °C gekühlte Lösung von 30.2 g (100 mmol) 6,7-Dibrom-1,2,3,4-tetrahydro-1,4-methano-naphthalin [42810-32-2] in einem Gemisch aus 1000 ml THF und 1000 ml Diethylether wird so mit 40 ml (100 mmol) n-Butyllithium, 2.5 M in Hexan, vorgekühlt auf -110 °C, versetzt, dass die Temperatur -105 °C nicht übersteigt. Man rührt 30 min. nach und leitet dann unter gutem Rühren für 15 min. einen trockenen Kohlendioxidstrom in die Reaktionsmischung ein. Dann lässt man langsam auf Raumtemperatur erwärmen, fügt 55 ml 2 N HCl zu, rührt 30 min. bei Raumtemperatur nach und zieht dann das Lösungsmittel im Vakuum ab. Der Rückstand wird in 500 ml Dichlormethan gelöst, die organische Phase wird einmal mit 300 ml 0.1 N HCl und einmal mit 100 ml gesättigter Kochsalzlösung gewaschen und über Magnesiumsulfat getrocknet. Abschließend entfernt man das Lösungsmittel im Vakuum, rührt den Rückstand in 150 ml MeOH aus, saugt vom farblosen Feststoff ab, wäscht diesen mit wenig Methanol und trocknet im Vakuum. Ausbeute: 17.7 g (66 mmol), 66 %; Reinheit: ca. 95 % nach ¹H-NMR.

Analog werden folgende Verbindungen dargestellt:

| Bsp. | Edukte | Produkt | Ausbeute |
|---|---|---|---|
| S7 | 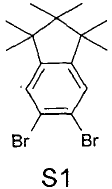 | 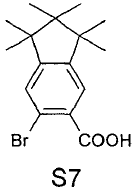 | 70 % |
| S8 | 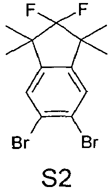 | 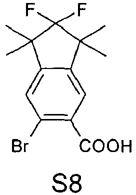 | 73 % |
| S9 | 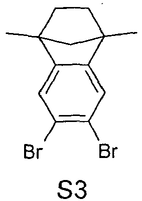 | 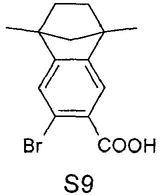 | 69 % |
| S10 | 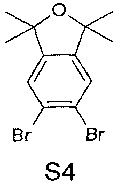 | 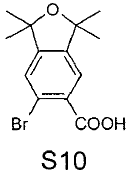 | 65 % |
| S11 | 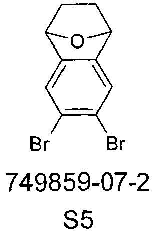 | 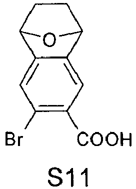 | 73 % |

### Beispiel S12: 3-Brom-biphenyl-2-carbonylchlorid, S12

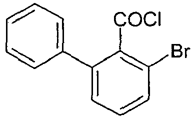

Eine Suspension von 277.1 g (1.0 mol) 3-Brombiphenyl-2-carbonsäure [94654-52-1] in 1000 ml THF und 0.1 ml DMF wird tropfenweise so mit 94.3 ml (1.1 mol) Oxalylchlorid versetzt, dass eine moderate Gasentwicklung (Vorsicht: HCl und CO) eintritt. Nach beendeter Zugabe rührt man bei 40 °C nach, bis die Gasentwicklung beendet ist, und entfernt dann das überschüssige Oxalylchlorid und das THF bei 40 °C im Vakuum. Der Rückstand wird ohne weitere Reinigung zur Synthese der Liganden eingesetzt. Ausbeute: quantitativ.

Analog werden folgende Verbindungen dargestellt:

| Bsp. | Carbonsäure | Carbonsäurechlorid | Ausbeute |
|---|---|---|---|
| S13 | 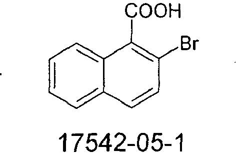 | 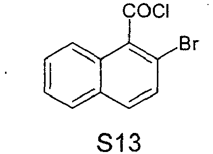 | quant. |
| S14 | 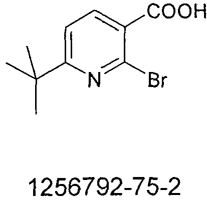 | 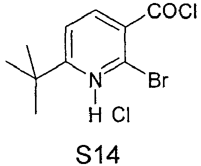 | quant. |
| S15 | 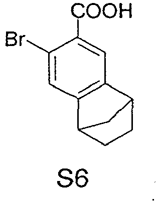 | 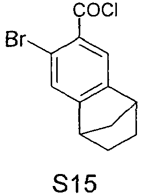 | quant. |
| S16 | 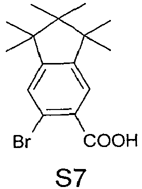 | 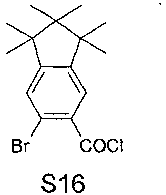 | quant. |
| S17 | 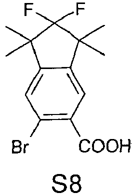 | 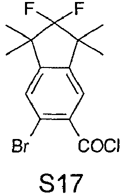 | quant. |
| S18 | 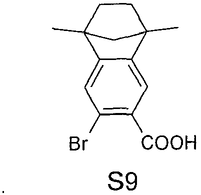 | 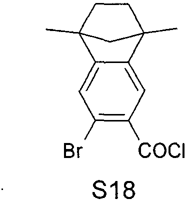 | quant. |
| S19 | 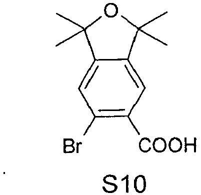 | 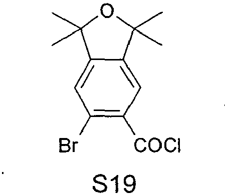 | quant. |
| S20 | 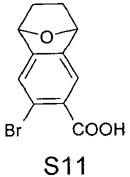 | 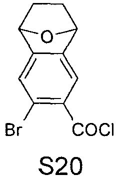 | quant. |

### Beispiel L1: 6H-Isoquino[2,1-a]quinazolin-6-on, L1

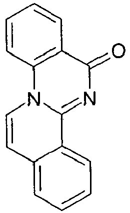

Ein auf 0 °C gekühltes, gut gerührtes Gemisch aus 144.2 g (1.0 mol) 1-Amino-isochinolin [1532-84-9], 180.2 ml (1.3 mol) Triethylamin und 1300 ml Dichlormethan (DCM) wird tropfenweise so mit einem Gemisch aus 219.5 g (1.0 mmol) 2-Brom-benzoesäurechlorid [7154-66-7] und 150 ml Dichlormethan versetzt, dass die Temperatur +5 °C nicht übersteigt. Nach beendeter Zugabe lässt man langsam auf Raumtemperatur erwärmen und rührt 12 h bei Raumtemperatur nach. Die Reaktionsmischung wird dann 4 x mit je 1000 ml Wasser und einmal mit 1000 ml gesättigter Kochsalzlösung gewaschen und über Magnesiumsulfat getrocknet. Das Trockenmittel wird abfiltriert und mit 1000 ml DCM nachgewaschen, anschließend wird das Filtrat im Vakuum vollständig vom DCM befreit. Der Rückstand wird in 2000 ml o-Xylol gelöst, mit 327.2 g (1.0 mmol) Cäsiumcarbonat, 9.5 g (50 mmol) Kupfer(l)iodid und 200 g Glasperlen (3 mm Durchmesser) versetzt und unter sehr gutem Rühren 48 h unter Rückfluss erhitzt. Man destilliert das o-Xylol weitgehend ab, lässt erkalten, versetzt die Reaktionsmischung mit 1500 ml DCM, saugt die Reaktionsmischung über ein kurzes Celite-Bett ab, wäscht dieses zweimal mit je 300 ml DCM nach, entfernt dann das Lösungsmittel im Vakuum und rührt den Rückstand mit 1000 ml Ethanol bei 50 °C 2 h aus. Nach Erkalten saugt man vom Feststoff ab, wäscht diesen einmal mit 200 ml Ethanol, trocknet im Vakuum und sublimiert ihn dann bei T ca. 160 °C / p ca. 1 x 10⁻⁴ mbar, um leichtflüchtige und nicht flüchtige Komponenten zu entfernen. Ausbeute: 94.5 g (383 mmol), 38 %. Reinheit: > 99.5 % n. ¹H-NMR.

Analog werden folgende Liganden L dargestellt:

| Bsp. | Amin | Carbonsäurechlorid | Ligand | Ausbeute |
|---|---|---|---|---|
| L2 | 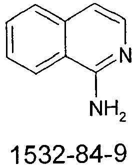 | 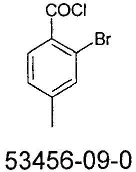 | 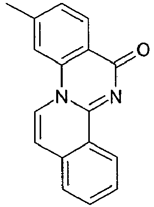 | 36 % |
| L3 | 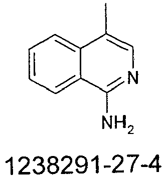 | 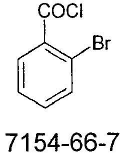 | 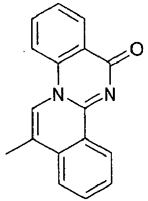 | 40 % |
| L4 | 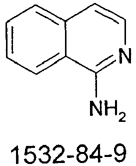 | 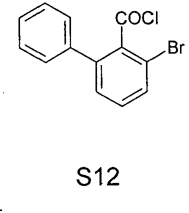 | 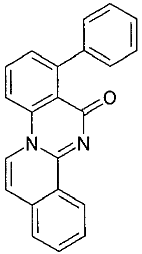 | 37 % |
| L5 | 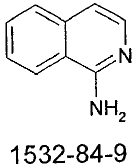 | 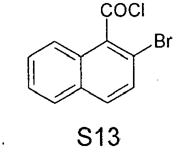 | 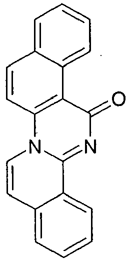 | 39 % |
| L6 | 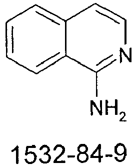 | 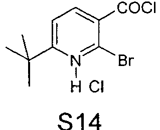 | 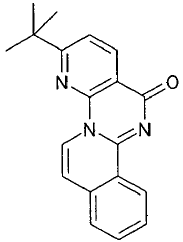 | 36 % |
| | | Verwendung von 2.3 mol Triethylamin | | |
| L7 | 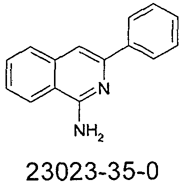 | 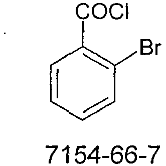 | 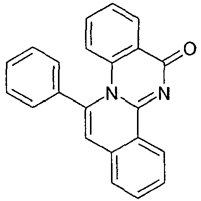 | 24 % |
| L8 | 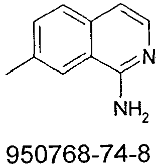 | 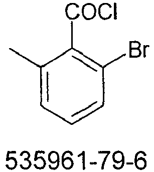 | 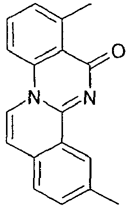 | 43 % |
| L9 | 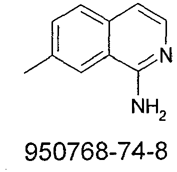 | 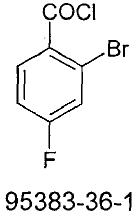 | 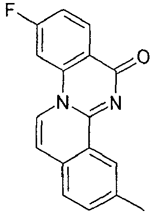 | 40 % |
| L10 | 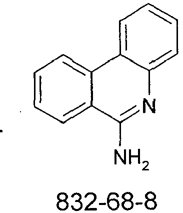 | 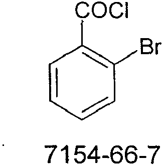 | 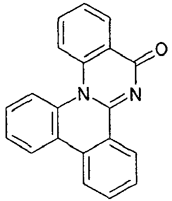 | 32 % |
| L11 | 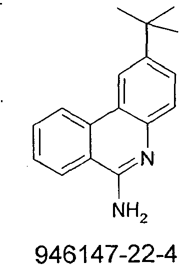 | 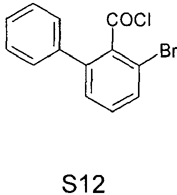 | 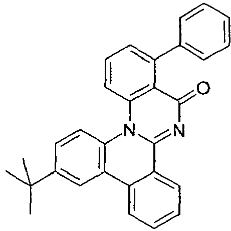 | 30 % |
| L12 | 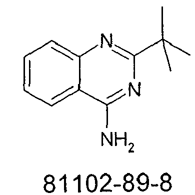 | 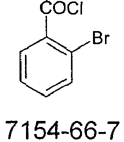 | 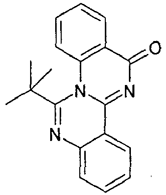 | 33 % |
| L13 | 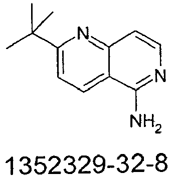 | 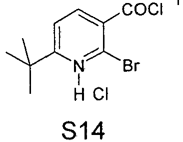 | 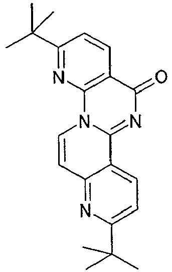 | 37 % |
| | | Verwendung von 2.3 mol Triethylamin | | |
| L14 | 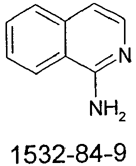 | 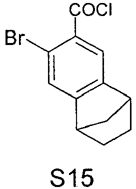 | 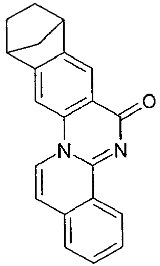 | 35 % |
| L15 | 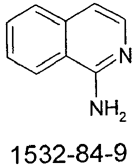 | 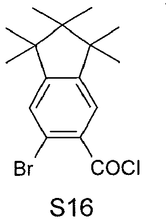 | 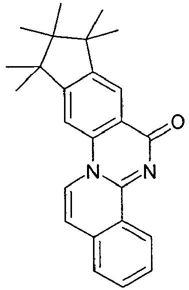 | 41 % |
| L16 | 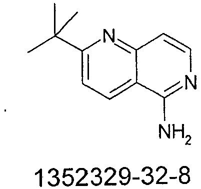 | 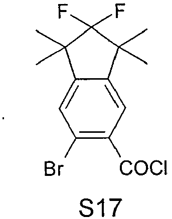 | 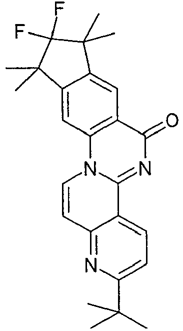 | 30 % |
| L17 | 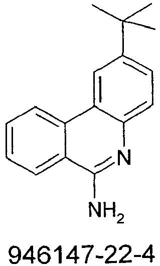 | 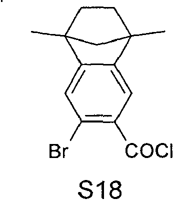 | 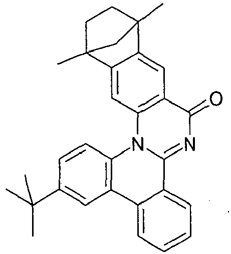 | 26 % |
| L18 | 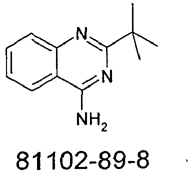 | 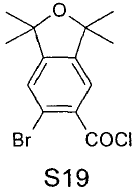 | 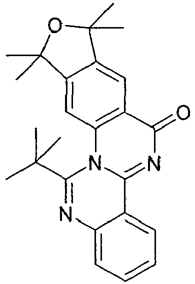 | 27 % |
| L19 | 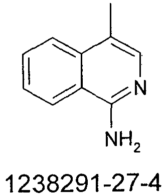 | 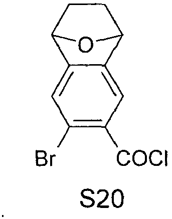 | 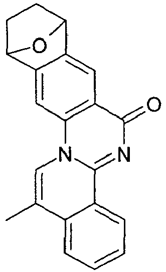 | 38 % |

### C: Synthese der Metallkomplexe:

### 1) Komplexe der Formel [Ir(L)₂Cl]₂:

Ein Gemisch aus 10 mmol Natrium-bis-acetylacetonato-dichloro-iridat(III) [770720-50-8], 22 mmol des Liganden L und ein glasummantelter Magnetrührkern werden in ein zylindrisches Reaktionsgefäß (40 ml Volumen) mit Schraubdeckel und Teflonseptum unter Inertgas (Stickstoff oder Argon) abgefüllt. Die Reaktionsmischung wird langsam unter Rühren erhitzt, bis sich eine Schmelze bildet. Dann wird die Temperatur langsam in 20 °C Schritten alle 20 min. gesteigert, bis die Endtemperatur (s.u.) erreicht ist, wobei das sich bildende Acetylaceton über eine Kanüle im Septum abgelassen wird. Ist die Enttemperatur erreicht, wird die Reaktionsmischung weitere 20 h bei der Endtemperatur gehalten. Nach Erkalten unter Schutzgas wird der Sinterkuchen mechanisch zerkleinert, mit 100 g Glaskugeln (3 mm Durchmessser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist, typische Suspensionsmittel sind Diethylether, tert-Butyl-methylether, Ethylacetat, DCM, Aceton, Ethylacetat, Toluol, etc.) 3 h gerührt und dabei mechanisch aufgeschlossen. Man dekantiert die feine Suspension von den Glaskugeln ab, saugt den Feststoff ([Ir(L)₂Cl]₂, der noch ca. 2 eq NaCl enthält, nachfolgend das rohe Chloro-Dimer genannt) ab und trocknet diesen im Vakuum. Das so erhaltene rohe Chloro-Dimer wird im Folgenden ohne weitere Reinigung eingesetzt.

Analog werden die folgenden Iridiumkomplexe erhalten:

| **Bsp.** | **Ligand L** | **Ir-Komplex** | **Endtemp. Suspensionsmittel** | **Ausbeute** |
|---|---|---|---|---|
| [Ir(L1)₂Cl]₂ | L1 | 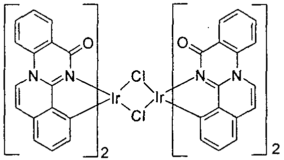 | 260 °C Ethylacetat | 93 % |
| | | [Ir(L1 )₂Cl]₂ | | |
| [Ir(L2)₂Cl]₂ | L2 | [Ir(L2)₂Cl]₂ | 260 °C Ethylacetat | 90 % |
| [Ir(L3)₂Cl]₂ | L3 | [Ir(L3)₂Cl]₂ | 260 °C Ethylacetat | 94 % |
| [Ir(L4)₂Cl]₂ | L4 | [Ir(L4)₂Cl]₂ | 270 °C Ethylacetat | 95 % |
| [Ir(L5)₂Cl]₂ | L5 | [Ir(L5)₂Cl]₂ | 280 °C Ethylacetat | 91 % |
| [Ir(L6)₂Cl]₂ | L6 | [Ir(L6)₂Cl]₂ | 260 °C Aceton | 90 % |
| [Ir(L7)₂Cl]₂ | L7 | [Ir(L7)₂Cl]₂ | 260 °C Toluol | 86 % |
| [Ir(L8)₂Cl]₂ | L8 | [Ir(L8)₂Cl]₂ | 280 °C Ethylacetat | 92 % |
| [Ir(L9)₂Cl]₂ | L9 | [Ir(L₉)₂Cl]₂ | 280 °C Ethylacetat | 92 % |
| [Ir(L10)₂Cl]₂ | L10 | [Ir(L10)₂Cl]₂ | 290 °C THF | 95 % |
| [Ir(L11)₂Cl]₂ | L11 | [Ir(L11)₂Cl]₂ | 270 °C Ethylacetat | 90 % |
| [Ir(L12)₂Cl]₂ | L12 | [Ir(L12)₂Cl]₂ | 270 °C MeO-t-Bu | 89 % |
| [Ir(L13)₂Cl]₂ | L13 | [Ir(L13)₂Cl]₂ | 280 °C DCM | 78 % |
| [Ir(L14)₂Cl]₂ | L14 | [Ir(L14)₂Cl]₂ | 270 °C Ethylacetat | 90 % |
| [Ir(L15)₂Cl]₂ | L15 | [Ir(L15)₂Cl]₂ | 270 °C Ethylacetat | 90 % |
| [Ir(L16)₂Cl]₂ | L16 | [Ir(L16)₂Cl]₂ | 270 °C Ethylacetat | 92 % |
| [Ir(L 17)₂Cl]₂ | L17 | [Ir(L17)₂Cl]₂ | 290 °C Toluol | 93 % |
| [Ir(L18)₂Cl]₂ | L18 | [Ir(L18)₂Cl]₂ | 270 °C Ethylacetat | 89 % |
| [Ir(L19)₂Cl]₂ | L19 | [Ir(L19)₂Cl]₂ | 270 °C MeO-t-Bu | 93 % |

### 2) Komplexe der Formel Ir(L)₂(L') mit Liganden L' mit O-O, O-N, N-N Donoratomen (nicht Gegenstand der Erfindung)

Das in 1) erhaltene rohe Chloro-Dimer der Formel [Ir(L)₂Cl]₂ wird in einem Gemisch aus 75 ml 2-Ethoxyethanol und 25 ml Wasser suspendiert und mit 13 mmol des Liganden L' und 15 mmol Natriumcarbonat versetzt. Nach 20 h Rühren unter Rückfluss und Lichtausschluss gibt man weitere 75 ml Wasser tropfenweise zu, saugt nach Erkalten vom Feststoff ab, wäscht diesen dreimal mit je 50 ml Wasser und dreimal mit je 50 ml Methanol und trocknet diesen im Vakuum. Der trockene Feststoff wird in einem kontinuierlichen Heißextraktor auf einem 3-5 cm hohen Celite-Bett platziert und dann mit dem angegebenen Extraktionsmittel (Vorlagemenge ca. 300 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, Aceton, Ethylacetat (EE), Dichlormethan (DCM), etc.) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Einengen des Eluats auf 50 ml und Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metall-Komplexes mittels NMR und / oder HPLC bestimmt. Liegt die Reinheit unter 99.5 % wird der Heißextraktionsschritt wiederholt, ist eine Reinheit von 99.5 - 99.9 % erreicht, wird der Metallkomplex getempert oder sublimiert. Neben dem Heißextraktionsverfahren zur Reinigung kann die Reinigung auch chromatographisch an Kieselgel oder Alox mit geeigneten Elutionsmitteln (s.u.) erfolgen. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 250 - 400 °C, wobei die Sublimation bevorzugt in Form einer fraktionierten Sublimation durchgeführt wird.

| **Bsp.** | [Ir(L)₂Cl]₂ | **Co-Ligand L'** | **Ir(L)₂(L') Reinigungsmethode Extraktionsmittel Elutionsmittel** | **Ausbeute** |
|---|---|---|---|---|
| Ir(L1)₂(L'1) | [Ir(L1)₂Cl]₂ | 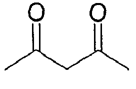 | 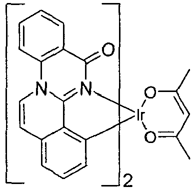 | 45 % |
| | | 123-54-6 | Chromatographie Kieselgel / DCM | |
| | | L'1 | | |
| Ir(L12)₂(L'1) | [Ir(L12)₂Cl]₂ | L'1 | 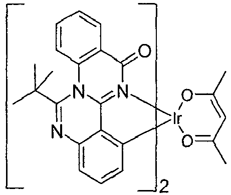 | 44 % |
| | | | Chromatographie Kieselgel / DCM | |
| Ir(L15)₂(L'1) | [Ir(L15)₂Cl]₂ | L'1 | 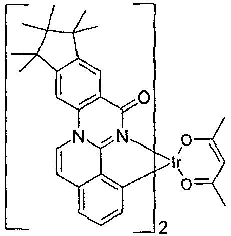 | 49 % |
| | | | Chromatographie Kieselgel / EE | |
| Ir(L11)₂(L'2) | [Ir(L11)₂Cl]₂ | 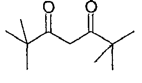 | 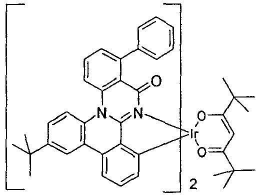 | 36 % |
| | | 1118-71-4 | Extraktion Toluol | |
| | | L'2 | | |
| Ir(L7)₂(L'2) | [Ir(L7)₂Cl]₂ | L'2 | 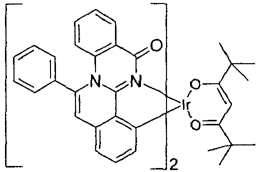 | 44 % |
| | | | Extraktion Aceton | |
| Ir(L8)₂(L'2) | [Ir(L8)₂Cl]₂ | L'2 | 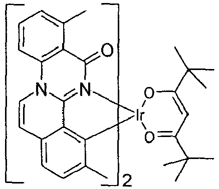 | 29 % |
| | | | Chromatographie Kieselgel / DCM | |
| Ir(L13)₂(L'3) | [Ir(L13)₂Cl]₂ | 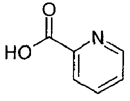 | 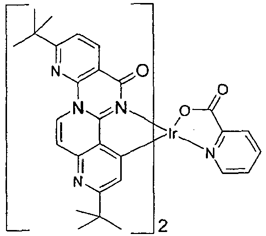 | 37 % |
| | | 98-98-6 | Extraktion Ethylacetat | |
| | | L'3 | | |
| Ir(L5)₂(L'4) | [Lr(L5)₂Cl]₂ | 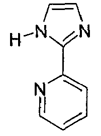 | 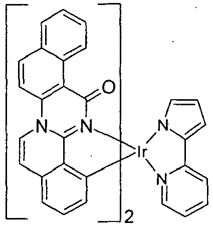 | 39 % |
| | | 18653-75-3 | Extraktion Toluol | |
| | | L'4 | | |
| Ir(L16)₂(L'5) | [Ir(L16)₂Cl]₂ | 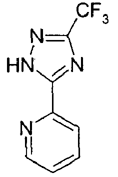 | 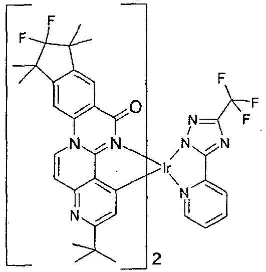 | 47 % |
| | | 219508-27-7 | Extraktion Xylol | |
| | | L'5 | | |

### 2) Heteroleptische tris-orthometallierte Komplexe der Formel Ir(L)₂(L') und der Formel Ir(L)(L')₂ aus [Ir(L)₂Cl]₂

Die o.g. Verbindungen werden durch Umsetzung der rohen Chloro-Dimere der Formel [Ir(L)₂Cl]₂ mit den Liganden L' in dipolar-protischen Lösungsmitteln (Ethylenglykol, Propylenglykol, Glycerin, Diethylenglykol, Triethylenglykol, etc.) erhalten. Üblicherweise fallen Gemische enthaltend beide Komplextypen der Formel Ir(L)₂(L') und der Formel Ir(L)(L')₂ an, die chromatographisch getrennt werden können. Die relativen Mengen an den Komplextypen der Formel Ir(L)₂(L') und der Formel Ir(L)(L')₂ können durch das stöchiometrische Verhältnis von [Ir(L)₂Cl]₂ zu Co-Ligand L' gesteuert werden. So entsteht bei einem stöchiometrischen Verhältnis von [Ir(L)₂Cl]₂ zu L' von 1:2 bis ca. 1:6 mehrheitlich das Produkt der Formel Ir(L)₂(L'), dagegen bei einem stöchiometrischen Verhältnis von [Ir(L)₂Cl]₂ zu L' von ca. 1:8 bis ca. 1:25 mehrheitlich das Produkt der Formel Ir(L)(L')₂.

Das in 1) erhaltene rohe Chloro-Dimer der Formel [Ir(L)₂Cl]₂ wird in 100 ml des angegebenen Lösungsmittels vorgelegt. Die Reaktionsmischung wird durch Durchleiten eines Inertgasstroms (Stickstoff oder Argon) unter Rühren entgast. Dann fügt man die angegebene Menge an Ligand L' zu und rührt das Gemisch unter Lichtausschluss 48 h bei 160 °C. Nach Abkühlen auf 70 °C tropft man 100 ml Ethanol zu, lässt unter Rühren erkalten, saugt vom ausgefallenen Feststoff ab, wäscht diesen dreimal mit je 30 ml Ethanol und trocknet im Vakuum. Die Komplexe der Formel Ir(L)₂(L') und der Formel Ir(L)(L')₂ werden chromatographisch isoliert, wobei der Verlauf auf DC-Karten verfolgt wird. Saubere Fraktionen werden vereinigt, fast bis zur Trockene eingeengt, wobei das Produkt häufig auskristallisiert. Man fügt dann Ethanol zu, bringt mit EtOH auf eine Schutzgasfritte, wäscht mehrmals mit wenig Ethanol und trocknet im Vakuum. Gegebenenfalls wird erneut chromatographiert, bis eine Reinheit > 99.5 % oder mehr erreicht ist. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 250-400 °C, wobei die Sublimation bevorzugt in Form einer fraktionierten Sublimation durchgeführt wird.

| **Bsp.** | **[Ir(L)₂Cl]₂** | **Co-Ligand L'** | **Ir(L)₂(L') Ir(L)(L')₂ Stöchiometrie Lösungsmittel [Ir(L)₂Cl]₂: L' Adsobens / Elutionsmittel** | **Ausbeute** |
|---|---|---|---|---|
| Ir(L1)₂(L'6) | [Ir(L1)₂Cl]₂ | 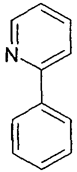 | 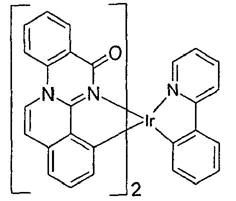 | 30 % |
| Ir(L1)(L'6)₂ | | L'6 | 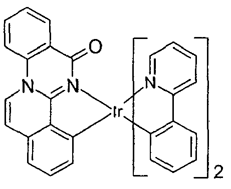 | 10 % |
| | | 1008-89-5 | 1:4 | |
| | | | Ethylenglykol Kieselgel **/** DCM | |
| Ir(L1)₂(L'6) | [Ir(L1)₂Cl]₂ | L'6 | 1:12 | 12 % |
| Ir(L1)(L'6)₂ | | | Ethylenglykol | 38 % |
| | | | Kieselgel / DCM | |
| Ir(L1)₂(L'6) | [Ir(L1)₂Cl]₂ | L'6 | 1:25 | 6 % |
| Ir(L1)(L'6)₂ | | | Ethylenglykol Kieselgel / DCM | 40 % |
| Ir(L1)₂(L'7) | [Ir(L1)₂Cl]₂ | 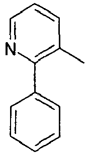 | 1:5 | 37 % |
| Ir(L1)(L'7)₂ | | L'7 | Ethylenglykol Kieselgel / DCM | 11 % |
| | | 10273-90-2 | | |
| Ir(L1)₂(L'7) | [Ir(L1)₂Cl]₂ | L'7 | 1:12 | 11 % |
| Ir(L1)(L'7)₂ | | | Ethylenglykol Kieselgel / DCM | 41 % |
| Ir(L1)₂(L'8) | [Ir(L1)₂Cl]₂ | 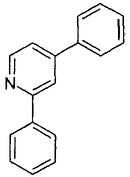 | 1:5 | 39 % |
| Ir(L1)(L'8)₂ | | L'8 | Ethylenglykol Kieselgel / DCM | 12 % |
| | | 26274-35-1 | | |
| Ir(L1)₂(L'8) | [Ir(L1)₂Cl]₂ | L'8 | 1:12 | 9 % |
| Ir(L1)(L'8)₂ | | | Ethylenglykol Kieselgel / DCM | 44 % |
| Ir(L2)₂(L'9) | [Ir(L2)₂Cl]₂ | 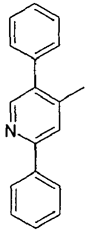 | 1:8 | 17 % |
| Ir(L2)(L'9)₂ | | L'9 | Ethylenglykol Kieselgel / DCM | 31 % |
| | | 156021-08-8 | | |
| Ir(L3)₂(L'8) | [Ir(L3)₂Cl]₂ | 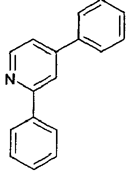 | 1:8 | 18 % |
| Ir(L3)(L'8)₂ | | L'8 | Ethylenglykol | 30 % |
| | | 26274-35-1 | Kieselgel / DCM | |
| Ir(L4)₂(L'10) | [Ir(L4)₂Cl]₂ | 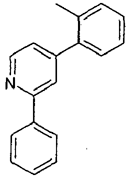 | 1:12 | 14 % |
| Ir(L4)(L'10)₂ | | L'10 | Ethylenglykol Kieselgel / DCM | 41 % |
| | | 1215556-61-8 | | |
| Ir(L5)₂(L'11) | [Ir(L5)₂Cl]₂ | 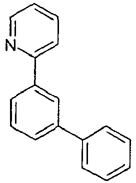 | 1:12 | 15 % |
| Ir(L5)(L'11)₂ | | L'11 | Propylenglykol Kieselgel EE / n-Hexan 2 / 1 | 33 % |
| | | 458541-39-4 | | |
| Ir(L6)₂(L'12) | [Ir(L6)₂Cl]₂ | 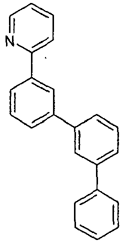 | 1:12 | 14 % |
| Ir(L6)(L'12)₂ | | L'12 | Ethylenglykol Kieselgel / DCM | 36 % |
| | | 1147894-90-3 | | |
| Ir(L7)₂(L'13) | [Ir(L7)₂Cl]₂ | 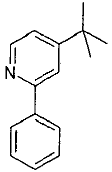 | 1:6 | 30 % |
| Ir(L7)(L'13)₂ | | L'13 | Ethylenglykol Kieselgel / DCM | 17 % |
| | | 53911-36-7 | | |
| Ir(L8)₂(L'6) | [Ir(L8)₂Cl]₂ | L'6 | 1:12 | --- |
| Ir(L8)(L'6)₂ | | | Ethylenglykol Kieselgel / DCM | 33 % |
| Ir(L9)₂(L'14) | [Ir(L9)₂Cl]₂ | 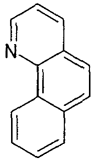 | 1:5 | 18 % |
| Ir(L9)(L'14)₂ | | L'14 | Ethylenglykol / 185 °C Kieselgel / DCM | 23 % |
| | | 230-27-3 | | |
| Ir(L10)₂(L'15) | [Ir(L10)₂Cl]₂ | 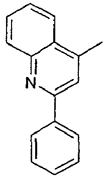 | 1:12 | 23 % |
| Ir(L10)(L'15)₂ | | L'15 | Ethylenglykol Kieselgel / DCM | 31 % |
| | | 4789-76-8 | | |
| Ir(L11)₂(L'8) | [Ir(L11)₂Cl]₂ | L'8 | 1:12 | 16 % |
| Ir(L11)(L'8)₂ | | | Ethylenglykol Kieselgel / DCM | 39 % |
| Ir(L12)₂(L'16) | [Ir(L12)₂Cl]₂ | 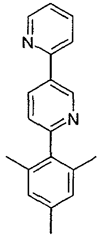 | 1:10 | 8 % |
| Ir(L12)(L'16)₂ | | L'16 | Ethylenglykol / 185 °C Kieselgel / DCM | 25 % |
| | | 1238604-37-9 | | |
| Ir(L13)₂(L'17) | [Ir(L13)₂Cl]₂ | 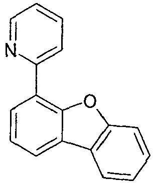 | 1:12 | 15 % |
| Ir(L13)(L'17)₂ | | L'17 | Ethylenglykol Kieselgel / Toluol | 37 % |
| | | 1062595-43-0 | | |
| Ir(L14)₂(L'8) | [Ir(L14)₂Cl]₂ | L'8 | 1:12 | 16 % |
| Ir(L14)(L'8)₂ | | | Ethylenglykol | 40 % |
| | | | Kieselgel | |
| | | | DCM / n-Hexan | |
| | | | 1 / 2 | |
| | | | Isol. als Gemisch der Diasteromeren | |
| Ir(L15)₂(L'18) | [Ir(L15)₂Cl]₂ | 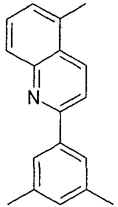 | 1:10 | 15 % |
| Ir(L 15)(L'18)₂ | | L'18 | Ethylenglykol / 185 °C | 24 % |
| | | 1056451-61-6 | Kieselgel / DCM | |
| Ir(L16)₂(L'19) | [Ir(L16)₂Cl]₂ | 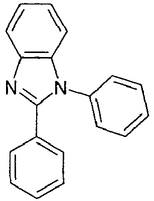 | 1:12 | 17 % |
| Ir(L16)(L'19)₂ | | L'19 | Ethylenglykol | 56 % |
| | | 2622-67-5 | Kieselgel / DCM | |
| Ir(L17)₂(L'20) | [Ir(L17)₂Cl]₂ | 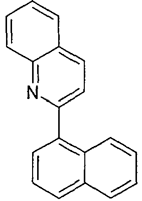 | 1:12 | 15 % |
| Ir(L17)(L'20)₂ | | | Ethylenglykol | 41 % |
| | | L'20 | Kieselgel / DCM | |
| | | 24702-41-8 | Isol. als Gemisch der Diasteromeren | |
| Ir(L18)₂(L'21) | [Ir(L18)₂Cl]₂ | 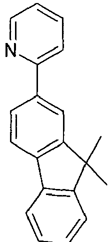 | 1:12 | 12 % |
| Ir(L18)(L'21)₂ | | L'21 | Ethylenglykol | 38 % |
| | | 457932-45-4 | Kieselgel / DCM | |
| Ir(L19)₂(L'22) | [Ir(L19)₂Cl]₂ | 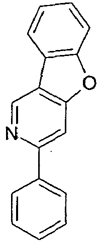 | 1:12 | 14 % |
| Ir(L19)(L'22)₂ | | | Ethylenglykol | 40 % |
| | | L'22 | Kieselgel / DCM | |
| | | 1159490-57-9 | Isol. als Gemisch der Diasteromeren | |

### 3) Heteroleptische tris-orthometallierte Komplexe der Formel Ir(L)₂(L') und der Formel Ir(L)(L')₂ aus [Ir(L')₂(HOMe)₂]A oder [Ir(L')₂(NCMe)₂]A

Die o.g. Verbindungen werden durch Umsetzung der Liganden L mit Iridiumkomplexen der Formel [Ir(L')₂(HOMe)₂]A oder [Ir(L')₂(NCMe)₂]A (A = nicht koordinierendes Anion wie z.B. Triflat, Tetrafluoroborat, Hexafluorophosphat, etc.) in dipolar-protischen Lösungsmitteln (Ethylenglykol, Propylenglykol, Glycerin, Diethylenglykol, Triethylenglykol, etc.) erhalten. Bei einem stöchiometrischen Verhältnis von [Ir(L')₂(HOMe)₂]A oder [Ir(L')₂(NCMe)₂]A zu L von 1:1 werden überwiegend die Komplexe der Formel Ir(L)(L')₂ erhalten. Bei einem stöchiometrischen Verhältnis von [Ir(L')₂(HOMe)₂]A oder [Ir(L')₂(NCMe)₂]A zu L von 1:2 oder größer fallen im Wesentlichen die Komplexe der Formel Ir(L)₂(L') an, so dass diese Methode gut geeignet ist, diese Komplexe in guter Ausbeute darzustellen. Die Rohprodukte enthaltend die beiden Komplextypen der Formel Ir(L)₂(L') und der Formel Ir(L)(L')₂ können wie unter 2) beschrieben chromatographisch getrennt und so gereinigt werden.

10 mmol des [Ir(L')₂(HOMe)₂]A oder [Ir(L')₂(NCMe)₂]A werden in einer Apparatur mit Wasserabscheider in 100 ml entgastem Lösungsmittel (s.Tabelle) vorgelegt. Dann fügt man die angegebene Menge an Ligand L zu (Menge s. Tabelle) und rührt das Gemisch 48 h bei 180 °C unter Lichtausschluss, wobei sich eine kleine Menge einer farblosen Flüssigkeit im Wasserabscheider sammelt, die nach NMR-Analyse MeOH oder MeCN und Wasser und thermische Zersetzungsprodukte des Lösungsmittels enthält. Man lässt die Suspension auf Raumtemperatur abkühlen, saugt vom ausgefallenen Feststoff ab, wäscht diesen dreimal mit je 20-30 ml Ethanol und trocknet im Vakuum. Die Komplexe der Formel Ir(L)₂(L') und der Formel Ir(L)(L')₂ werden chromatographisch isoliert, wobei der Verlauf auf DC-Karten verfolgt wird. Saubere Fraktionen werden vereinigt, fast bis zur Trockene eingeengt, wobei das Produkt häufig auskristallisiert. Man fügt dann Ethanol zu, bringt mit EtOH auf eine Schutzgasfritte, wäscht mehrmals mit wenig Ethanol und trocknet im Vakuum. Gegebenenfalls wird erneut chromatographiert, bis eine Reinheit > 99.5 % oder mehr erreicht ist. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 250 - 400 °C, wobei die Sublimation bevorzugt in Form einer fraktionierten Sublimation durchgeführt wird.

| **Bsp.** | **[Ir(L')₂(HOMe)₂]A oder [Ir(L')₂(NCMe)₂]A** | **Ligand L** | **Ir(L)₂(L') Ir(L)(L')₂ Stöchiometrie [Ir(L)₂Cl]₂** : **L' Lösungsmittel Adsobens / Elutionsmittel** | **Ausbeute** |
|---|---|---|---|---|
| Ir(L1)₂(L'6) | [Ir(L'6)₂(NCMe)₂]OTf | 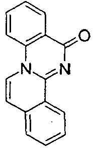 | 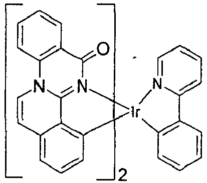 | 11 % |
| Ir(L1)(L'6)₂ | 153540-10-4 | L1 | 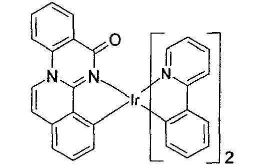 | 27 % |
| | | | 1:1 | |
| | | | 1,2-Propandiol Kieselgel / DCM | |
| Ir(L1)₂(L'6) | [Ir(L'6)₂(NCMe)₂]OTf | L1 | 1:2 | 37 % |
| Ir(L1)(L'6)₂ | 153540-10-4 | | 1,2-Propandiol Kieselgel / DCM | 7 % |
| Ir(L1)₂(L'6) | [Ir(L'6)₂(NCMe)₂]OTf | L1 | 1:4 | 46 % |
| Ir(L1)(L'6)₂ | 153540-10-4 | | 1,2-Propandiol Kieselgel / DCM | 5 % |
| Ir(L3)₂(L'23) | [Ir(L'23)₂(NCMe)₂]B F₄ | L3 | 1:3 | 42 % |
| | 871837-94-4 | | 1,2-Propandiol Kieselgel / DCM | |
| | 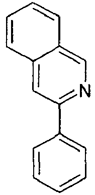 | | | |
| | L'23 | | | |
| Ir(L3)₂(L'24) | [Ir(L'24)₂(NCMe)₂]P F₆ | L8 | 1:3 | 34 % |
| | 1374259-46-7 | | 1,2-Propandiol Kieselgel DCM **/** EE 98/2 | |
| | 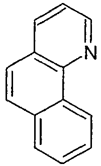 | | | |
| | L'24 | | | |
| Ir(L15)₂(L'25) | [Ir(L'25)₂(HOMe)_{2]}O Tf | L15 | 1:3 | 39 % |
| | 1215692-70-8 | | Ethylenglykol Kieselgel DCM / THF 99 / 1 | |
| | 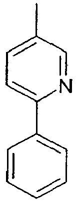 | | | |
| | L'25 | | | |

### Herstellung der OLEDs

### 1) Vakuum-prozessierte Devices

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (Indium-Zinn-Oxid) bilden die Substrate, auf welche die OLEDs aufgebracht werden. Die OLEDs haben prinzipiell folgenden Schichtaufbau: Substrat / Lochinjektionsschicht 1 (HIL1) HAT-CN [105598-27-4], 5 nm / Lochtransportschicht 1 (HTL1), 75 nm / Lochtransportschicht 2 (HTL2), 10 nm / Emissionsschicht (EML) / Elektronentransportschicht (ETL) / optionale Elektroneninjektionsschicht (EIL) und abschließend eine Kathode. Die Kathode wird durch eine 100 nm dicke Aluminiumschicht gebildet.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:M2:Ir-Komplex (55%:35%:10%) bedeutet hierbei, dass das Material M1 in einem Volumenanteil von 55%, M2 in einem Anteil von 35% und Ir-Komplex in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 6 gezeigt.

Die OLEDs werden standardmäßig charakterisiert. Hierfür werden die Elektrolumineszenzspektren, die Stromeffizienz (gemessen in cd/A), die Externe Qanteneffizienz (EQE in %) und die Spannung (gemessen bei 1000 cd/m² in V) bestimmt. Außerdem wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD80 bedeutet, dass es sich bei der genannten Lebensdauer um die Zeit handelt, bei der die Leuchtdichte auf 80% der Startleuchtdichte abgefallen ist, also von z. B. 1000 cd/m² auf 800 cd/m². Die Werte für die Lebensdauer können mit Hilfe dem Fachmann bekannten Umrechnungsformeln auf eine Angabe für andere Startleuchtdichten umgerechnet werden.

### Verwendung von erfindungsgemäßen Verbindungen als Emittermaterialien in phosphoreszierenden OLEDs

Die erfindungsgemäßen Verbindungen fassen sich insbesondere als phosphoreszierende Emittermaterialien in der Emissionsschicht in OLEDs einsetzen. Die Ergebnisse der OLEDs sind in Tabelle 2 zusammengefasst.

**Tabelle 1: Aufbau der OLED**

| **Bsp.** | **EML** | **ETL** | **EIL** |
|---|---|---|---|
| | **Dicke** | **Dicke** | **Dicke** |
| D-Ir(L1)₂(L'1) | M1:M2: Ir(L1)₂(L'1) (45%:45%:10%) | ETM1:ETM2 (50%:50%) | --- |
| | 25 nm | 45 nm | |
| D-Ir(L12)₂(L'1) | M1:M2: Ir(L12)₂(L'1) (45%:45%:10%) | ETM1:ETM2 (50%:50%) | ETM2 |
| | 25 nm | 45 nm | 3 nm |
| D-Ir(L15)₂(L'1) | M1:M3: Ir(L15)₂(L'1) (45%:50%:5%) | ETM1:ETM2 (50%:50%) | --- |
| | 25 nm | 45 nm | |
| D-Ir(L11)₂(L'2) | M1:M3: Ir(L11)₂(L'2) (45%:50%:5%) | ETM1:ETM2 (50%:50%) | --- |
| | 25 nm | 45 nm | |
| D-Ir(L7)₂(L'2) | M1: Ir(L7)₂(L'2) (80%:20%) | ETM1:ETM2 (50%:50%) | --- |
| | 25 nm | 45 nm | |
| D-Ir(L8)₂(L'2) | M1:M2: Ir(L8)₂(L'2) (45%:45%:10%) | ETM1:ETM2 (50%:50%) | --- |
| | 25 nm | 45 nm | |
| D-Ir(L13)₂(L'3) | M1:M2: Ir(L13)₂(L'3) (55%:35%:10%) | ETM1:ETM2 (50%:50%) | --- |
| | 25 nm | 45 nm | |
| D-Ir(L5)₂(L'4) | M1:M2: Ir(L5)₂(L'4) (35%:58%:7%) | ETM1:ETM2 (50%:50%) | --- |
| | 25 nm | 45 nm | |
| D-Ir(L16)₂(L'5) | M1:M3: Ir(L16)₂(L'5) (20%:65%:15%) | ETM1 | ETM2 |
| | 25 nm | 45 nm | 3 nm |
| D-Ir(L1)₂(L'6) | M1:M3: Ir(L1)₂(L'6) (45%:45%:10%) | ETM1:ETM2 (50%:50%) | --- |
| | 25 nm | 45 nm | |
| D-Ir(L1)(L'6)₂ | M1:M2: Ir(L1)(L'6)₂ | ETM3 | EIM1 |
| | (30%:60%:10%) 25 nm | 45 nm | 1nm |
| D-Ir(L1)₂(L'7) | M1:M4: Ir(L1)₂(L'7) (60%:30%: 10%) | ETM1:ETM2 (50%:50%) | --- |
| | 25 nm | 45 nm | |
| D-Ir(L1)(L'7)₂ | M1:M2: Ir(L1)(L'7)₂ (45%:45%:10%) | ETM1:ETM2 (50%:50%) | --- |
| | 25 nm | 45 nm | |
| D-Ir(L1)₂(L'8) | M1:M3: Ir(L1)₂(L'6) (45%:45%:10%) | ETM1:ETM2 (50%:50%) | --- |
| | 25 nm | 45 nm | |
| D-lr(L1)(L'8)₂ | M1:M2: Ir(L1))(L'8)₂ (50%:40%:10%) | ETM1:ETM2 (50%:50%) | --- |
| | 25 nm | 45 nm | |
| D-Ir(L2)₂(L'9) | M1:M3: Ir(L1)₂(L'6) (45%:47%:8%) | ETM1:ETM2 (50%:50%) | --- |
| | 25 nm | 45 nm | |
| D-Ir(L2)(L'9)₂ | M1:M2: Ir(L2)(L'9)₂ (30%:60%:10%) | ETM1:ETM2 (50%:50%) | --- |
| | 25 nm | 45 nm | |
| D-Ir(L4)₂(L'10) | M1:M3: Ir(L4)₂(L'10) (45%:45%:10%) | ETM1:ETM2 (50%:50%) | --- |
| | 25 nm | 45 nm | |
| D-Ir(L4)(L'10)₂ | M1:M2: Ir(L4)(L'10)₂ (30%:60%: 10%) | ETM1:ETM2 (50%:50%) | --- |
| | 25 nm | 45 nm | |
| D-Ir(L5)₂(L'11) | M1:M3: Ir(L5)₂(L'11) (45%:45%:10%) | ETM1:ETM2 (50%:50%) | --- |
| | 25 nm | 45 nm | |
| D-Ir(L5)(L'11)₂ | M1:M2: Ir(L5)(L'11)₂ (45%:45%:10%) | ETM1:ETM2 (50%:50%) | --- |
| | 25 nm | 45 nm | |
| D-Ir(L6)₂(L'12) | M1:M4: Ir(L6)₂(L'12) (60%:25%:15%) | ETM1:ETM2 (50%:50%) | --- |
| | 25 nm | 45 nm | |
| D-Ir(L6)(L'12)₂ | M1:M2: Ir(L6)(L'12)₂ (35%:55%:10%) | ETM1:ETM2 (50%:50%) | --- |
| | 25 nm | 45 nm | |
| D-Ir(L7)₂(L'13) | M1:M3: Ir(L7)₂(L'13) (45%:45%:10%) | ETM1:ETM2 (50%:50%) | --- |
| | 25 nm | 45 nm | |
| D-Ir(L7)(L'13)₂ | M1:M2: Ir(L7)(L'13)₂ (45%:45%:10%) | ETM1:ETM2 (50%:50%) | --- |
| | 25 nm | 45 nm | |
| D-Ir(L8)₂(L'6) | M1:M3: Ir(L8)₂(L'6) (45%:45%:10%) | ETM1:ETM2 (50%:50%) | --- |
| | 25 nm | 45 nm | |
| D-Ir(L8)(L'6)₂ | M1:M2: Ir(L8)(L'6)₂ (45%:45%:10%) | ETM1:ETM2 (50%:50%) | --- |
| | 25 nm | 45 nm | |
| D-Ir(L9)₂(L'14) | M1:M3: Ir(L9)₂(L'14) (65%:25%: 10%) | ETM1:ETM2 (50%:50%) | --- |
| | 25 nm | 45 nm | |
| D-Ir(L9)(L'14)₂ | M1:M2: Ir(L9)(L'14)₂ (35%:55%:10%) | ETM1:ETM2 (50%:50%) | --- |
| | 25 nm | 45 nm | |
| D-Ir(L10)₂(L'15) | M1:M3: Ir(L10)₂(L'15) (45%:45%:10%) | ETM1:ETM2 (50%:50%) | --- |
| | 25 nm | 45 nm | |
| D-Ir(L10)(L'15)₂ | M1:M2: Ir(L10)(L'15)₂ (45%:45%:10%) | ETM1:ETM2 (50%:50%) | --- |
| | 25 nm | 45 nm | |
| D-Ir(L11)₂(L'8) | M1:M3: Ir(L11)₂(L'8) (45%:45%:10%) | M1:ETM2 (50%:50%) | --- |
| | 25 nm | 45mn | |
| D-Ir(L11)(L'8)₂ | M1:M2: (L11)(L'8)₂ 5%:45%:10%) 25nm | M1:ETM2 (50%:50%) | --- |
| | | 45 nm | |
| D-Ir(L12)₂(L'16) | M1:M3: Ir(L12)₂('16) (65%:25%:10%) 25 nm | ETM1:ETM2 (50%:50%) | --- |
| | | 45 nm | |
| D-Ir(L12)(L'16)₂ | M1:M2: Ir(L12)(L'16)₂ (55%:35%:10%) | ETM1:ETM2 (50%:50%) | --- |
| | 25 nm | 45 nm | |
| D-Ir(L13)₂(L'17) | M1:M3: Ir(L13)₂(L'17) (45%:45%:10%) | ETM1:ETM2 (50%:50%) | --- |
| | 25 nm | 45 nm | |
| D-Ir(L13)(L'17)₂ | M1:M2: Ir(L13)(L'17)₂ (45%:45%:10%) | ETM1:ETM2 (50%:50%) | --- |
| | 25 nm | 45 nm | |
| D-Ir(L14)₂(L'8) | M1:M3: Ir(L14)₂(L'8) (45%:45%:10%) | ETM1:ETM2 (50%:50%) | --- |
| | 25 nm | 45 nm | |
| D-Ir(L14)(L'8)₂ | M1:M2: Ir(L14)(L'8)₂ (40%:50%:10%) | ETM1:ETM2 (50%:50%) | --- |
| | 25 nm | 45 nm | |
| D-Ir(L15)₂(L'18) | M1:M3: Ir(L15)₂(L'18) (65%:25%:10%) | ETM1:ETM2 (50%:50%) | --- |
| | 25 nm | 45 nm | |
| D-Ir(L15)(L'18)₂ | M1:M2: Ir(L15)(L'18)₂ (55%:35%:10%) | ETM1:ETM2 (50%:50%) | --- |
| | 25 nm | 45 nm | |
| D-Ir(L16)₂(L'19) | M1:M4: Ir(L16)₂(L'19) (60%:30%:10%) | ETM1:ETM2 (50%:50%) | --- |
| | 25 nm | 45 nm | |
| D-Ir(L16)(L'19)₂ | M1:M2: Ir(L16)(L'19)₂ (45%:45%:10%) | ETM1:ETM2 (50%:50%) | --- |
| | 25 nm | 45 nm | |
| D-Ir(L17)₂(L'20) | M1:M3:Ir(L17)₂(L'20) (45%:45%:10%) | ETM1:ETM2 (50%:50%) | --- |
| | 25 nm | 45 nm | |
| D-Ir(L17)(L'20)₂ | M1:M2: Ir(L17)(L'20)₂ (45%:45%:10%) | ETM1:ETM2 (50%:50%) | --- |
| | 25 nm | 45 nm | |
| D-Ir(L18)₂(L'21) | M1:M3: Ir(L18)₂(L'21) (65%:25%:10%) | ETM1:ETM2 (50%:50%) | --- |
| | 25 nm | 45 nm | |
| D-Ir(L18)(L'21)₂ | M1:M2: Ir(L18)(L'21)₂ (40%:50%:10%) | ETM1:ETM2 (50%:50%) | --- |
| | 25 nm | 45 nm | |
| D-Ir(L19)₂(L'22) | M1:M4: Ir(L19)₂(L'22) (60%:30%:10%) | ETM1:ETM2 (50%:50%) | --- |
| | 25 nm | 45 nm | |
| D-Ir(L19)(L'22)₂ | M1:M2: Ir(L19)(L'22)₂ (45%:45%:10%) | ETM1:ETM2 (50%:50%) | --- |
| | 25 nm | 45 nm | |
| D-Ir(L3)₂(L'23) | M1:M3: Ir(L3)₂(L'23) (45%:45%:10%) | ETM1:ETM2 (50%:50%) | --- |
| | 25 nm | 45 nm | |
| D-Ir(L3)₂(L'24) | M1:M3: Ir(L3)₂(L'24) (45%:45%:10%) | ETM1:ETM2 (50%:50%) | --- |
| | 25 nm | 45 nm | |
| D-Ir(L15)₂(L'25) | M1:M4: Ir(L15)₂(L'25) (60%:30%:10%) | ETM1:ETM2 (50%:50%) | |
| | 25 nm | 45 nm | |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD80 (h) 1000 cd/m²** |
|---|---|---|---|---|
| D-Ir(L1)₂(L'1) | 19.9 | 2.8 | 0.46/0.53 | 60000 |
| D-Ir(L12)₂(L'1) | 21.0 | 3.0 | 0.38/0.60 | 65000 |
| D-Ir(L15)₂(L'1) | 21.4 | 2.6 | 0.48/0.55 | 70000 |
| D-Ir(L11)₂(L'2) | 23.1 | 2.7 | 0.47/0.52 | 55000 |
| D-Ir(L7)₂(L'2) | 20.7 | 2.9 | 0.46/0.53 | 60000 |
| D-Ir(L8)₂(L'2) | 21.8 | 2.8 | 0.48/0.55 | 60000 |
| D-Ir(L13)₂(L'3) | 23.0 | 2.6 | 0.36/0.63 | 45000 |
| D-Ir(L5)₂(L'4) | 22.6 | 2.7 | 0.52/0.46 | 70000 |
| D-Ir(L16)₂(L'5) | 20.5 | 2.7 | 0.37/0.62 | 18000 |
| D-Ir(L1)₂(L'6) | 20.5 | 2.8 | 0.42/0.57 | 190000 |
| D-Ir(L1)(L'6)₂ | 21.8 | 2.7 | 0.44/0.55 | 220000 |
| D-Ir(L1)₂(L'7) | 22.0 | 2.6 | 0.45/0.53 | 210000 |
| D-Ir(L1)(L'7)₂ | 23.7 | 2.9 | 0.46/0.51 | 240000 |
| D-Ir(L1)₂(L'8) | 23.4 | 2.8 | 0.46/0.51 | 230000 |
| D-Ir(L1)(L'8)₂ | 22.8 | 2.8 | 0.51/0.48 | 250000 |
| D-Ir(L2)₂(L'9) | 23.0 | 2.7 | 0.41/0.58 | 230000 |
| D-Ir(L2)(L'9)₂ | 21.6 | 2.6 | 0.42/0.56 | 240000 |
| D-Ir(L4)₂(L'10) | 20:3 | 2.9 | 0.48/0.51 | 230000 |
| D-Ir(L4)(L'10)₂ | 21.0 | 2.7 | 0.51/0.48 | 250000 |
| D-Ir(L5)₂(L'11) | 21.1 | 2.6 | 0.56/0.42 | 240000 |
| D-Ir(L5)(L'11)₂ | 22.5 | 2.9 | 0.57/0.42 | 260000 |
| D-Ir(L7)₂(L'13) | 23.5 | 2.7 | 0.42/0.57 | 200000 |
| D-Ir(L7)(L'13)₂ | 22.9 | 2.7 | 0.44/0.55 | 210000 |
| D-IrL8₂(L'6) | 21.3 | 2.6 | 0.42/0.56 | 250000 |
| D-Ir(L8)(L'6)₂ | 22.1 | 2.8 | 0.44/0.54 | 240000 |
| D-Ir(L9)₂(L'14) | 23.2 | 2.9 | 0.42/0.56 | 150000 |
| D-Ir(L9)(L'14)₂ | 22.4 | 2.7 | 0.43/0.57 | 160000 |
| D-Ir(L10)₂(L'15) | 22.6 | 2.7 | 0.59/0.40 | 230000 |
| D-Ir(L10)(L'15)₂ | 23.0 | 2.6 | 0.60/0.38 | 250000 |
| D-Ir(L11)₂(L'8) | 23.1 | 2.6 | 0.57/0.41 | 250000 |
| D-Ir(L11)(L'8)₂ | 21.8 | 2.7 | 0.58/0.41 | 250000 |
| D-Ir(L12)₂(L'16) | 22.2 | 2.6 | 0.41/0.58 | 190000 |
| D-Ir(L12)(L'16)₂ | 23.3 | 2.9 | 0.42/0.57 | 230000 |
| D-Ir(L13)₂(L'17) | 20.4 | 2.8 | 0.40/0.58 | 200000 |
| D-Ir(L13)(L'17)₂ | 20.8 | 2.9 | 0.41/0.58 | 210000 |
| D-Ir(L14)₂(L'8) | 23.1 | 2.8 | 0.45/0.54 | 250000 |
| D-Ir(L14)(L'8)₂ | 23.4 | 2.8 | 0.47/0.52 | 270000 |
| D-Ir(L15)₂(L'18) | 21.5 | 2.9 | 0.59/0.38 | 260000 |
| D-Ir(L15)(L'18)₂ | 21.3 | 2.7 | 0.60/0.39 | 260000 |
| D-Ir(L16)₂(L'19) | 21.6 | 2.8 | 0.38/0.60 | 200000 |
| D-Ir(L16)(L'19)₂ | 21.7 | 2.9 | 0.39/0.59 | 210000 |
| D-Ir(L17)₂(L'20) | 21.6 | 2.7 | 0.58/0.40 | 220000 |
| D-Ir(L17)(L'20)₂ | 21.3 | 2.6 | 0.60/0.38 | 240000 |
| D-Ir(L18)₂(L'21) | 22.5 | 2.6 | 0.40/0.58 | 190000 |
| D-Ir(L18)(L'21)₂ | 23.6 | 2.6 | 0.41/0.57 | 200000 |
| D-Ir(L19)₂(L'22) | 21.2 | 2.8 | 0.43/0.56 | 230000 |
| D-Ir(L19)(L'22)₂ | 21.5 | 2.9 | 0.44/0.54 | 230000 |
| D-Ir(L3)₂(L'23) | 22.1 | 2.7 | 0.59/0.38 | 270000 |
| D-Ir(L3)₂(L'24) | 21.9 | 2.8 | 0.55/0.43 | 280000 |
| D-Ir(L15)₂(L'25) | 21.4 | 2.6 | 0.44/0.55 | 250000 |

### 2) Lösungs-prozessierte Devices

### A: Aus löslichen Funktionsmaterialien

Die erfindungsgemäßen Iridiumkomplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z.B. in der WO 2004/037887). Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf welche die ITO-Struktur (Indium-Zinn-Oxid) als Anode aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für ein Device typische Schichtdicke von 80 nm mittels Spincoating erzielt werden soll. Die lösungsprozessierten Devices enthalten eine Emissionsschicht aus (Polystyrol):M5:M6:Ir-Komplex (35%:25%:30%:10%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x 10⁻⁶ mbar) aufgedampft. Optional kann zunächst eine Lockblockierschicht und dann eine Eletronentransportschicht und dann erst die Kathode (z.B. Al oder LiF/Al) im Vakuum aufgedampft werden. Um das Device vor Luft und Luftfeuchtigkeit zu schützen, wird die Vorrichtung abschließend verkapselt und dann charakterisiert. Tabelle 3 fasst die erhaltenen Daten zusammen.

**Tabelle 3: Ergebnisse mit aus Lösung prozessierten Materialien**

| **Bsp.** | **Ir-Komplex** | **EQE (%) 1000 cd/m²** | **Spannung (V) 1000 cd/m²** | **CIE x/y 1000 cd/m²** |
|---|---|---|---|---|
| L-Ir(L6)₂(L'12) | Ir(L6)₂(L'12) | 20.6 | 3.3 | 0.45/0.53 |
| L-Ir(L6)(L'12)₂ | Ir(L6)(L'12)₂ | 20.9 | 3.5 | 0.47/0.51 |

### 3) Weiß emittierende OLEDs

Gemäß den allgemeinen Verfahren aus 1) wird eine weiß emittierende OLED mit folgendem Schichtaufbau hergestellt:

**Tabelle 4: Aufbau der weißen OLEDs**

| **Bsp.** | **HTL2** | **EML Rot-Orange** | **EML Blau** | **EML Grün** | **HBL** | **ETL** |
|---|---|---|---|---|---|---|
| | **Dicke** | **Dicke** | **Dicke** | **Dicke** | **Dicke** | **Dicke** |
| D-W1 | HTM2 | HTM2 Ir(L3)₂(L'23) (97%:3%) | M1:M3:Ir-B (45%:50%:5%) | M3:Ir-G (90%:10%) | M3 | ETM1:ETM2 (50%:50%) |
| | 230 nm | 10 nm | 8 nm | 7 nm | 10 nm | 30 nm |

**Tabelle 5: Deviceergebnisse**

| **Bsp.** | **EQE (%) 1000 cd/m²** | **Spannung (V) 1000 cd/m²** | **CIE x/y 1000 cd/m² CRI** | **LD50 (h) 1000 cd/m²** |
|---|---|---|---|---|
| D-W1 | 21.4 | 6.0 | 0.44/0.44 | 3200 |
| | | | 80 | |

**Tabelle 6: Strukturformeln der verwendeten Materialien**

| | |
|---|---|
| 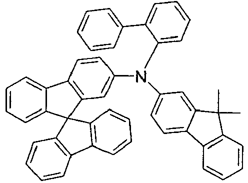 | 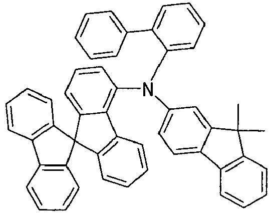 |
| HTM1 | HTM2 |
| 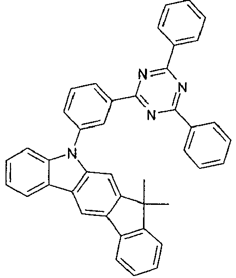 | 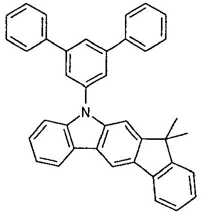 |
| M1 | M2 |
| 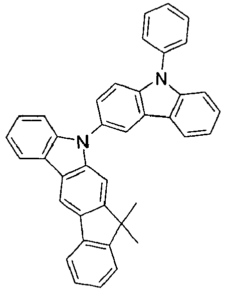 | 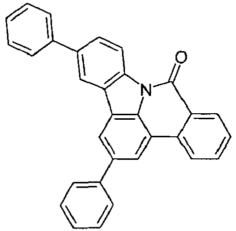 |
| M3 | M4 |
| 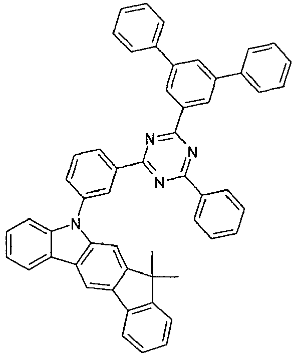 | 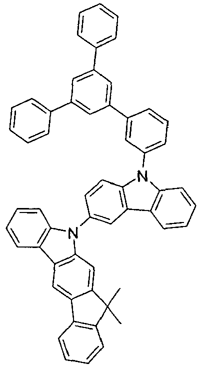 |
| M5 | M6 |
| 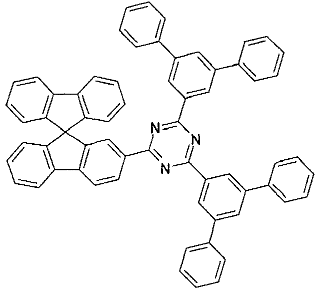 | 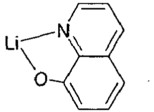 |
| ETM1 | ETM2 |
| 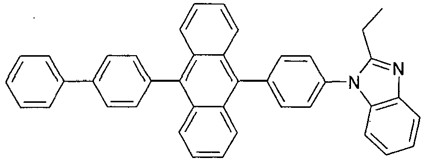 | LiF |
| ETM3 | EIM1 |
| 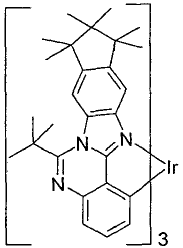 | 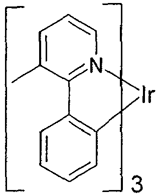 |
| Ir-B | Ir-G |

## Patentansprüche

1. Verbindung gemäß Formel (1),
[Ir(L)ₙ(L')ₘ] Formel (1)
wobei die Verbindung der allgemeinen Formel (1) eine Teilstruktur Ir(L)ₙ der Formel (2) enthält: 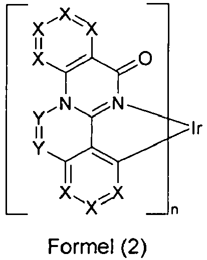 wobei für die verwendeten Symbole und Indizes gilt:
X ist bei jedem Auftreten gleich oder verschieden CR oder N mit der Maßgabe, dass maximal zwei Symbole X pro Ligand für N stehen;
Y ist bei jedem Auftreten gleich oder verschieden CR oder N mit der Maßgabe, dass maximal ein Symbol Y für N steht, oder die beiden Symbole Y stehen zusammen für eine Gruppe der folgenden Formel (3), 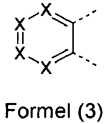 wobei die gestrichelten Bindungen die Verknüpfung dieser Gruppe im Liganden symbolisieren;
R ist bei jedem Auftreten gleich oder verschieden H, D, F, Cl, Br, I, N(R¹)₂, CN, Si(R¹)₃, B(OR¹)₂, C(=O)R¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, Si(R¹)₂, C=O, NR¹, O, S oder CONR¹ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden;
R¹ ist bei jedem Auftreten gleich oder verschieden H, D, F, N(R²)₂, CN, Si(R²)₃, B(OR²)₂, C(=O)R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², Si(R²)₂, C=O, NR², O, S oder CONR² ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches Ringsystem bilden;
R² ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R² auch miteinander ein mono- oder polycyclisches, aliphatisches oder aromatisches Ringsystem bilden;
L' ist gleich oder verschieden bei jedem Auftreten ein monoanionischer bidentater Ligand, welcher eine Kombination aus zwei der Formeln (32) bis (55) ist, wobei L' aus diesen Gruppen gebildet wird, indem diese Gruppen jeweils an der durch # gekennzeichneten Position aneinander binden, 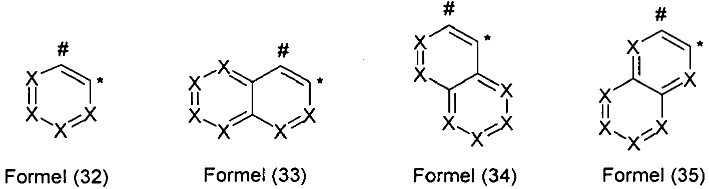 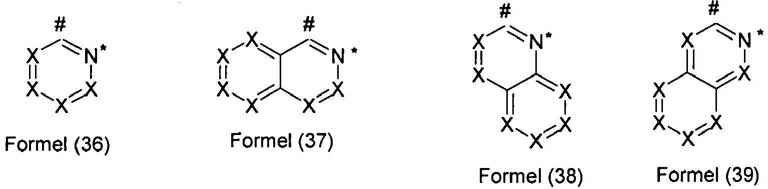 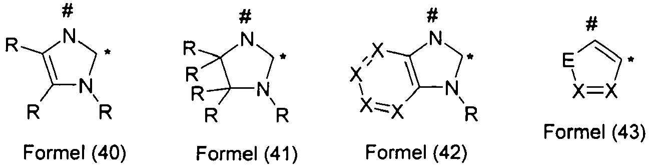 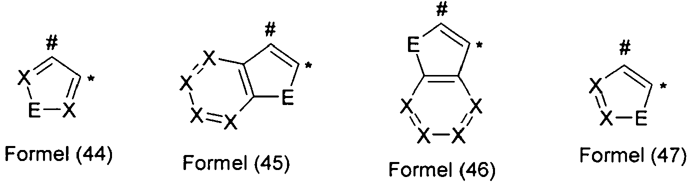 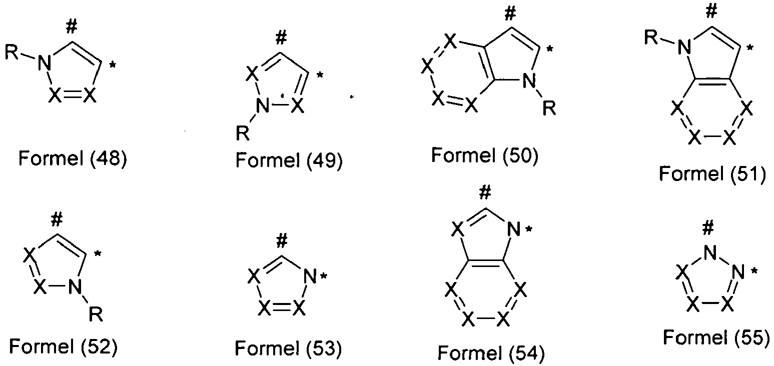 wobei die Position, an der die Gruppen an das Metall koordinieren, durch * gekennzeichnet sind und E für O, S oder CR₂ steht;
n ist 1 oder 2;
m ist 1 oder 2;
**dadurch gekennzeichnet, dass** n + m = 3 ist.

2. Verbindung nach Anspruch 1, **dadurch gekennzeichnet, dass** im Liganden L insgesamt 0, 1 oder 2 der Symbole X und Y für N stehen, bevorzugt insgesamt 0 oder 1 der Symbole X und Y.

3. Verbindung nach Anspruch 1 oder 2, ausgewählt aus den Strukturen der Formeln (4) bis (24), 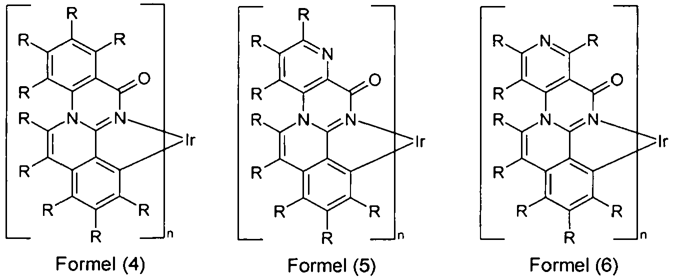 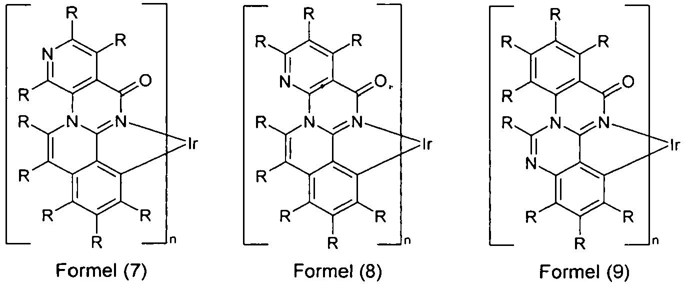 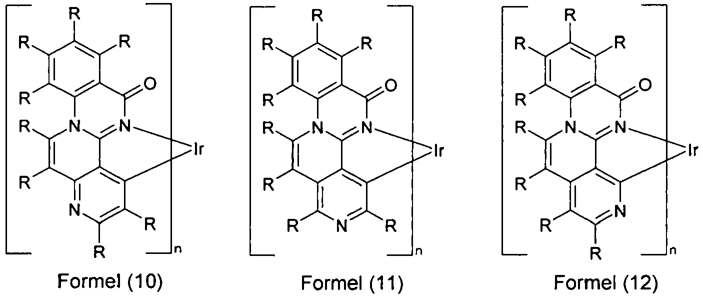 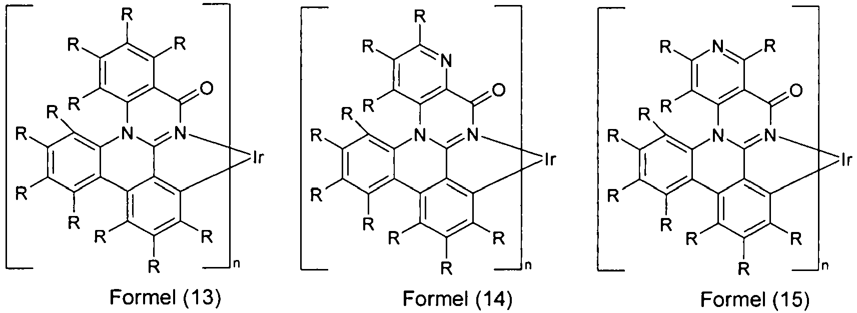 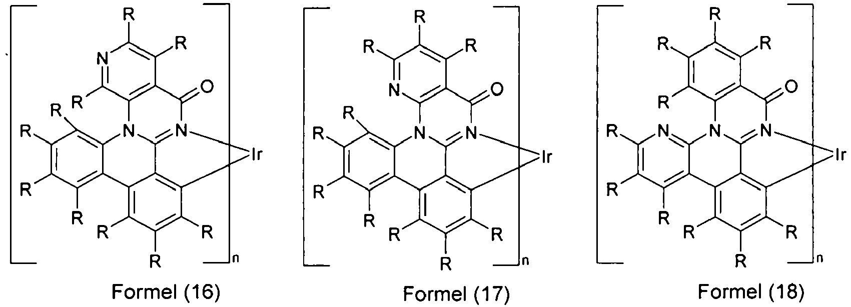 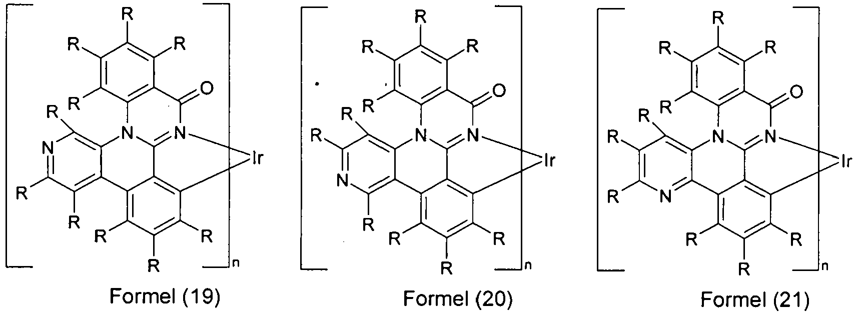 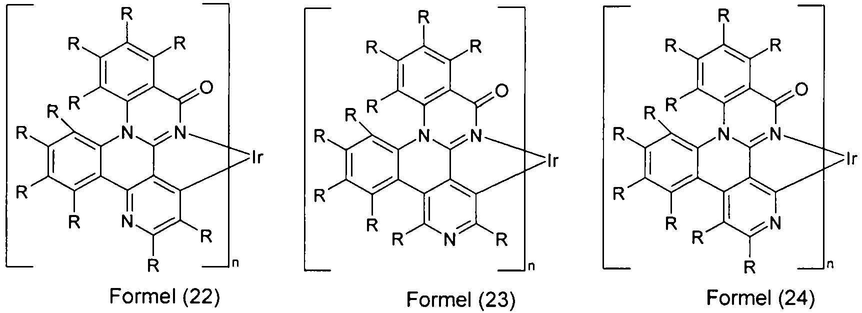 wobei die verwendeten Symbole und Indizes die in Anspruch 1 genannten Bedeutungen aufweisen.

4. Verbindung nach einem oder mehreren der Ansprüche 1 bis 3, **dadurch gekennzeichnet, dass**, wenn eine oder mehrere Gruppen X oder Y in den Teilstrukturen der Formel (2) für N stehen bzw. wenn es sich um Teilstrukturen der Formeln (5) bis (12) oder (14) bis (24) handelt, benachbart zu diesem Stickstoffatom eine Gruppe R als Substituent gebunden ist, welche ausgewählt ist aus CF₃, OCF₃, Alkyl- oder Alkoxygruppen mit 1 bis 10 C-Atomen, Dialkylaminogruppen mit 2 bis 20 C-Atomen, aromatischen bzw. heteroaromatischen Ringsystemen oder Aralkyl- bzw. Heteroaralkylgruppen.

5. Verbindung nach Anspruch 4, **dadurch gekennzeichnet, dass** der Rest R, der einem Stickstoffatom benachbart ist, ausgewählt ist aus den Gruppen der folgenden Formeln (R-1) bis (R-119), 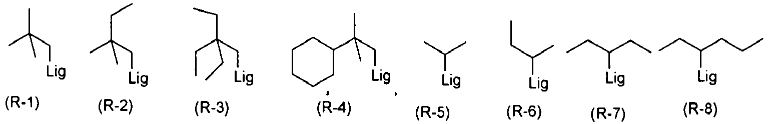 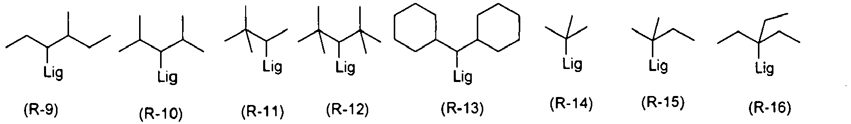 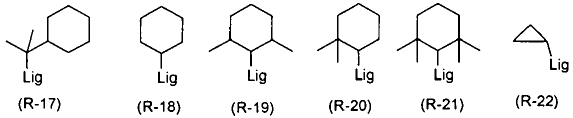 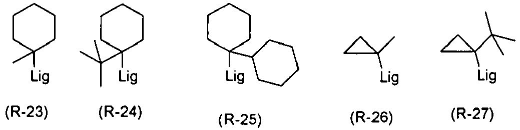 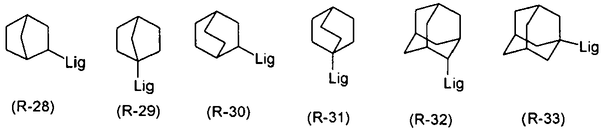 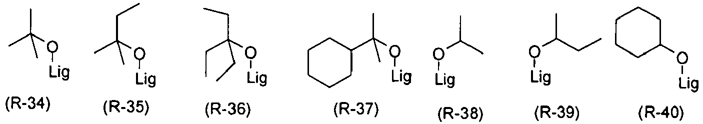 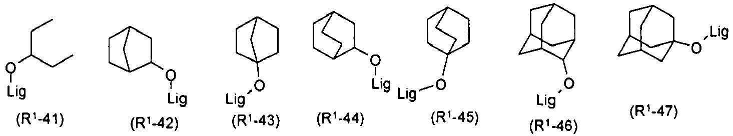 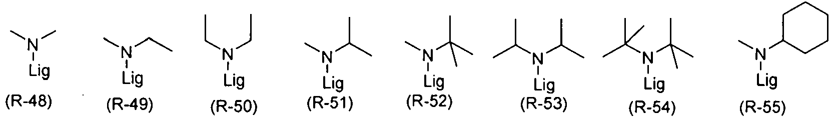 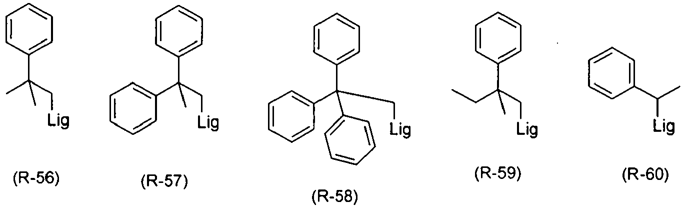 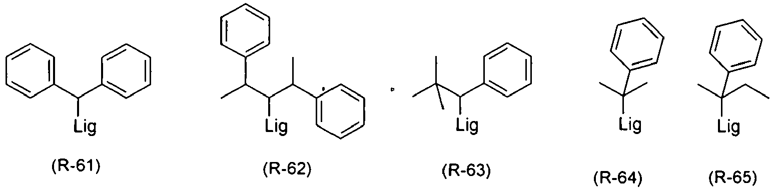 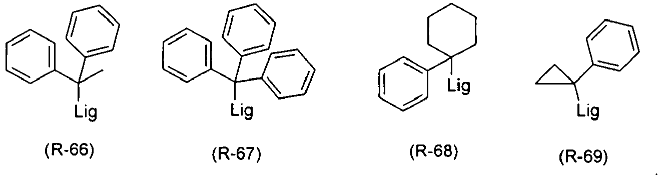 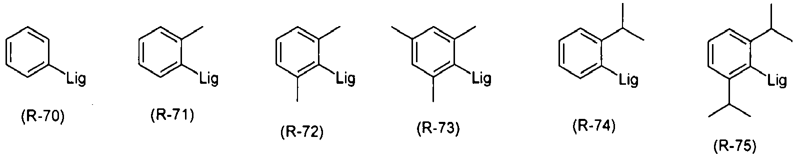 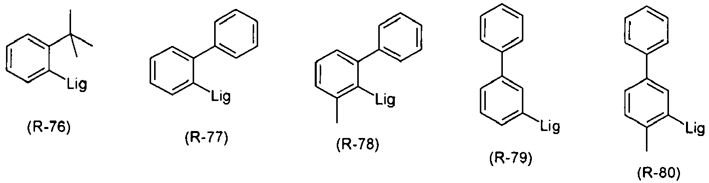 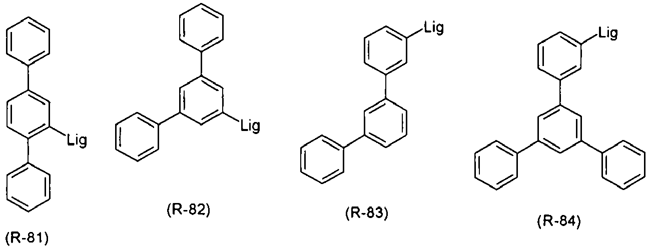 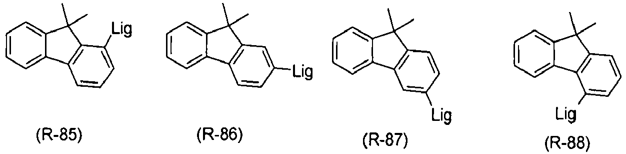 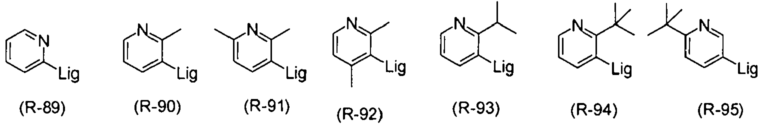 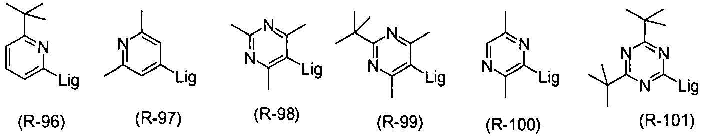 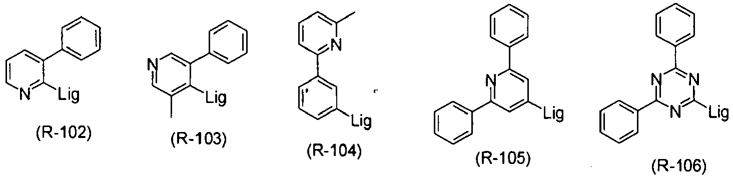 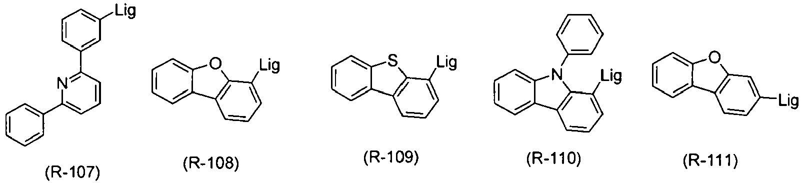 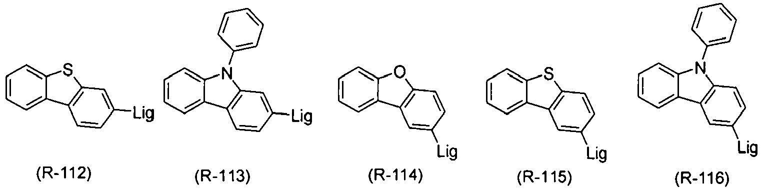 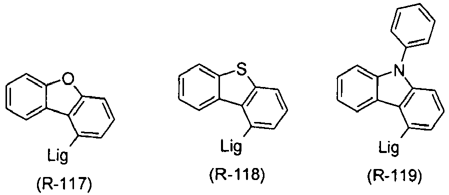 wobei Lig die Anknüpfung der Gruppe an den Liganden kennzeichnet und die aromatischen und heteroaromatischen Gruppen jeweils durch einen oder mehrere Reste R¹ substituiert sein können.

6. Verbindung nach einem oder mehreren der Ansprüche 1 bis 5, **dadurch gekennzeichnet, dass** in der Teilstruktur der Formel (2) zwei benachbarte Gruppen X für CR stehen und/oder zwei benachbarte Reste Y für CR stehen und die jeweiligen Reste R zusammen mit den C-Atomen einen Ring gemäß einer der Formeln (25) bis (31) aufspannen, 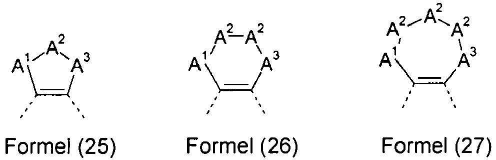 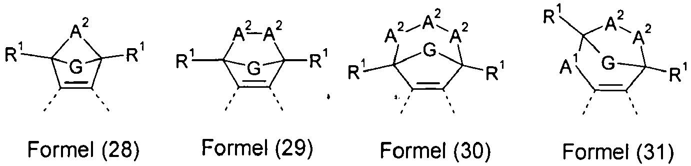 wobei R¹ und R² die in Anspruch 1 genannten Bedeutungen aufweisen, wobei mehrere R¹ auch miteinander verknüpft sein können und so ein weiteres Ringsystem aufspannen können, die gestrichelten Bindungen die Verknüpfung der beiden Kohlenstoffatome im Liganden andeuten und weiterhin gilt:
A¹, A³ ist gleich oder verschieden bei jedem Auftreten C(R³)₂, O, S, NR³ oder C(=O);
A² ist gleich oder verschieden bei jedem Auftreten C(R¹)₂, O, S, NR³ oder C(=O); oder A²-A² in Formel (26), (27), (29), (30) oder (31) kann außer für eine Kombination der oben genannten Gruppen für -CR²=CR²⁻ oder eine ortho-verknüpfte Arylen- oder Heteroarylengruppe mit 5 bis 14 aromatischen Ringatomen, welche durch einen oder mehrere Reste R² substituiert sein kann, stehen;
G ist eine Alkylengruppe mit 1, 2 oder 3 C-Atomen, welche mit einem oder mehreren Resten R² substituiert sein kann, -CR²=CR²⁻ oder eine ortho-verknüpfte Arylen- oder Heteroarylengruppe mit 5 bis 14 aromatischen Ringatomen, welche durch einen oder mehrere Reste R² substituiert sein kann;
R³ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann, oder eine Aralkyl- oder Heteroaralkylgruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

7. Verbindung nach Anspruch 6, **dadurch gekennzeichnet, dass** die Struktur der Formel (25) bis (31) ausgewählt ist aus den Strukturen der Formel (25-A) bis (25-F), (26-A) bis (26-F), (27-A) bis (27-E), (28-A) bis (28-C), (29-A), (30-A) oder (31-A), 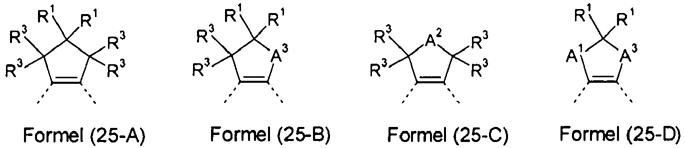 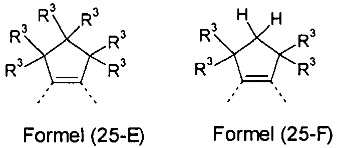 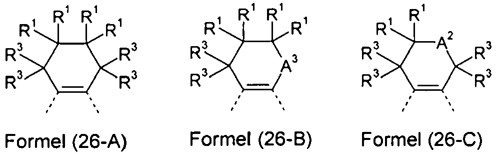 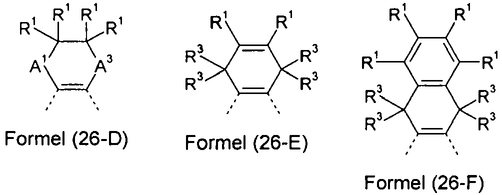 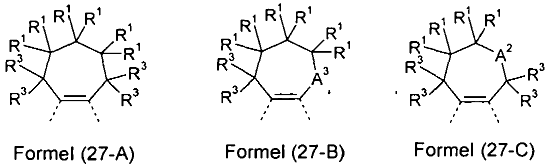 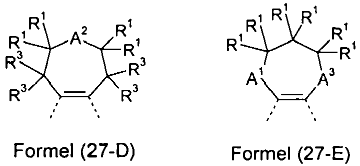 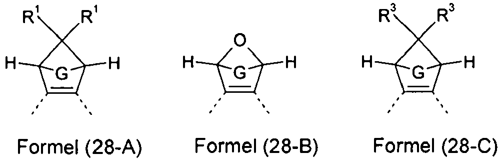 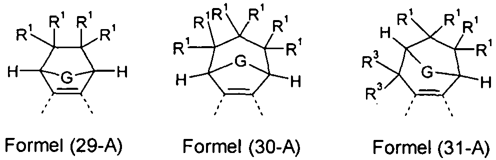 wobei R¹ und R³ die in Anspruch 1 genannten Bedeutungen aufweisen und A¹, A² und A³ gleich oder verschieden bei jedem Auftreten für O oder NR³ steht.

8. Verfahren zur Herstellung einer Verbindung nach einem oder mehreren der Ansprüche 1 bis 7 durch Umsetzung der entsprechenden freien Liganden L und L' mit Iridiumalkoholaten der Formel (60), mit Iridiumketoketonaten der Formel (61), mit Iridiumhalogeniden der Formel (62) oder mit dimeren Iridiumkomplexen der Formel (63) oder (64) oder mit Iridiumverbindungen, die sowohl Alkoholat- und/oder Halogenid- und/oder Hydroxy- wie auch Ketoketonatreste tragen, 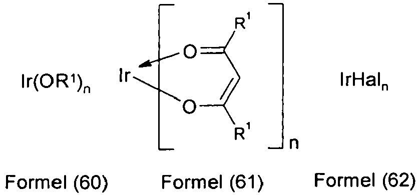 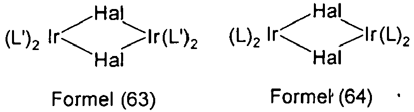 wobei die Symbole und Indizes L', m, n und R¹ die in Anspruch 1 angegebenen Bedeutungen haben und Hal = F, Cl, Br oder I ist.

9. Formulierung, enthaltend mindestens eine Verbindung nach einem oder mehreren der Ansprüche 1 bis 7 und mindestens eine weitere Verbindung, insbesondere ein Lösemittel.

10. Verwendung einer Verbindung nach einem oder mehreren der Ansprüche 1 bis 7 in einer elektronischen Vorrichtung, zur Erzeugung von Singulett-Sauerstoff, in der Photokatalyse oder in Sauerstoffsensoren.

11. Elektronische Vorrichtung enthaltend mindestens eine Verbindung nach einem oder mehreren der Ansprüche 1 bis 7, ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden.

12. Elektronische Vorrichtung nach Anspruch 11, wobei es sich um eine organische Elektrolumineszenzvorrichtung handelt, **dadurch gekennzeichnet, dass** die Verbindung nach einem oder mehreren der Ansprüche 1 bis 7 als emittierende Verbindung in einer oder mehreren emittierenden Schichten eingesetzt wird.

## Claims

1. Compound of the formula (1),
[Ir(L)ₙ(L')ₘ] formula (1)
where the compound of the general formula (1) contains a moiety Ir(L)ₙ of the formula (2): 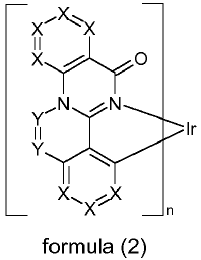 where the following applies to the symbols and indices used:
X is on each occurrence, identically or differently, CR or N, with the proviso that a maximum of two symbols X per ligand stand for N;
Y is on each occurrence, identically or differently, CR or N, with the proviso that a maximum of one symbol Y stands for N, or the two symbols Y together stand for a group of the following formula (3), 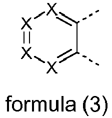 where the dashed bonds symbolise the linking of this group in the ligand;
R is on each occurrence, identically or differently, H, D, F, Cl, Br, I, N(R¹)₂, CN, Si(R¹)₃, B(OR¹)₂, C(=O)R1, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R¹, where one or more non-adjacent CH₂ groups may be replaced by R¹C=CR¹, Si(R¹)₂, C=O, NR¹, O, S or CONR¹ and where one or more H atoms may be replaced by D, F or CN, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; two or more adjacent radicals R may also form a mono- or polycyclic, aliphatic, aromatic and/or benzo-fused ring system with one another;
R¹ is on each occurrence, identically or differently, H, D, F, N(R²)₂, CN, Si(R²)₃, B(OR²)₂, C(=O)R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R², where one or more non-adjacent CH₂ groups may be replaced by R²C=CR², Si(R²)₂, C=O, NR², O, S or CONR² and where one or more H atoms may be replaced by D, F or CN, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², or a diarylamino group, diheteroarylamino group or arylheteroarylamino group having 10 to 40 aromatic ring atoms, which may be substituted by one or more radicals R²; two or more adjacent radicals R¹ may form a mono- or polycyclic, aliphatic ring system with one another;
R² is on each occurrence, identically or differently, H, D, F or an aliphatic, aromatic and/or heteroaromatic organic radical having 1 to 20 C atoms, in particular a hydrocarbon radical, in which, in addition, one or more H atoms may be replaced by D or F; two or more substituents R² may also form a mono- or polycyclic, aliphatic or aromatic ring system with one another;
L' is, identically or differently on each occurrence, a monoanionic bidentate ligand which is a combination of two of the formulae (32) to (55), where L' is formed from these groups by these groups in each case bonding to one another at the position denoted by #, 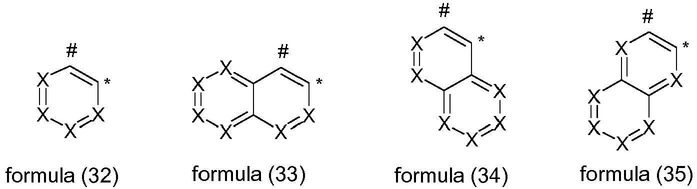 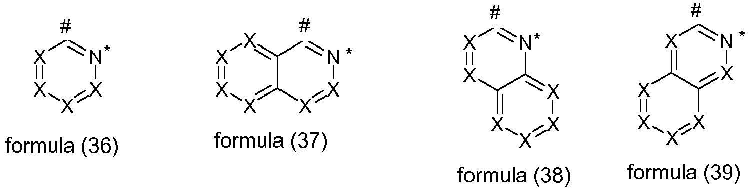 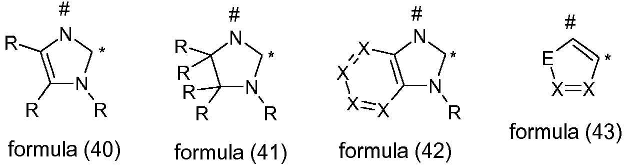 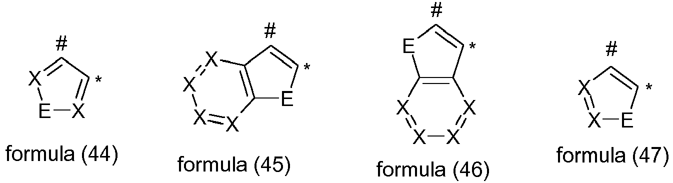 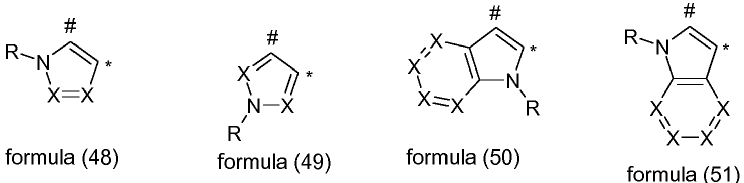 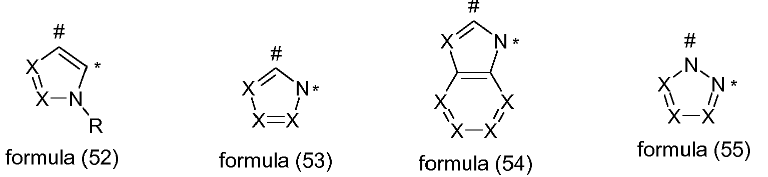 where the position at which the groups coordinate to the metal is denoted by * and E stands for O, S or CR₂;
n is 1 or 2;
m is 1 or 2;
**characterised in that** n + m = 3.

2. Compound according to Claim 1, **characterised in that** a total of 0, 1 or 2 of the symbols X and Y in the ligand L stand for N, preferably a total of 0 or 1 of the symbols X and Y.

3. Compound according to Claim 1 or 2, selected from the structures of the formulae (4) to (24), 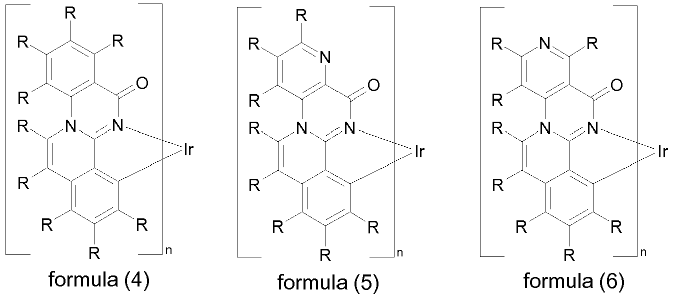 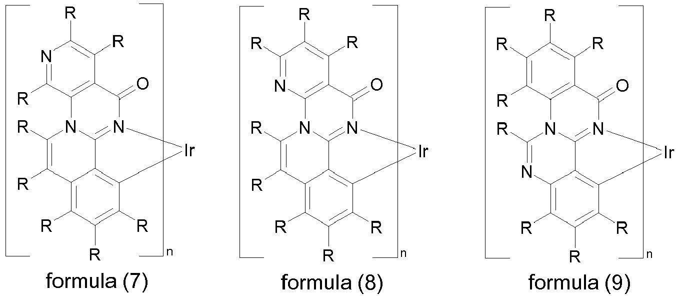 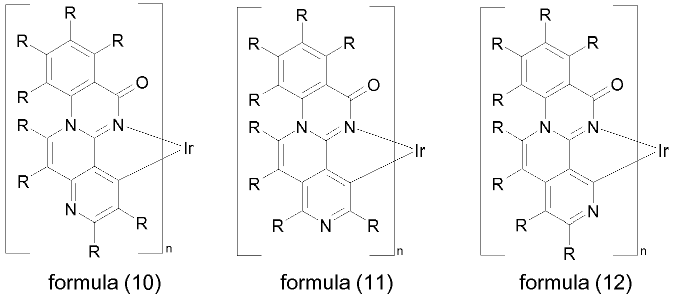 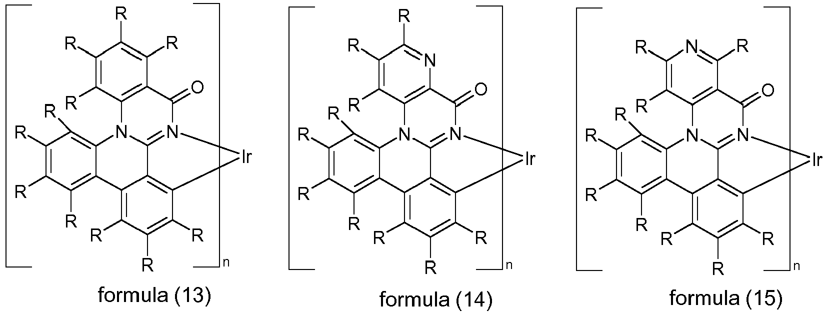 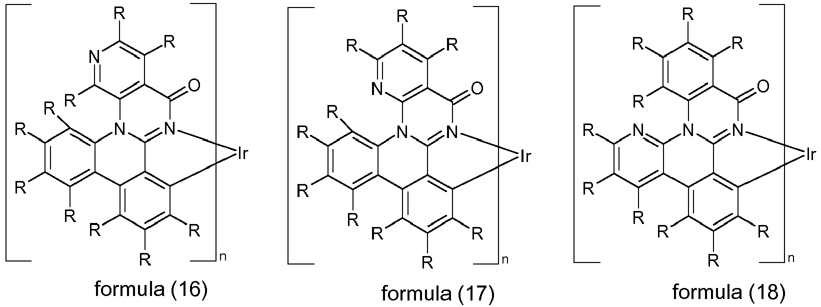 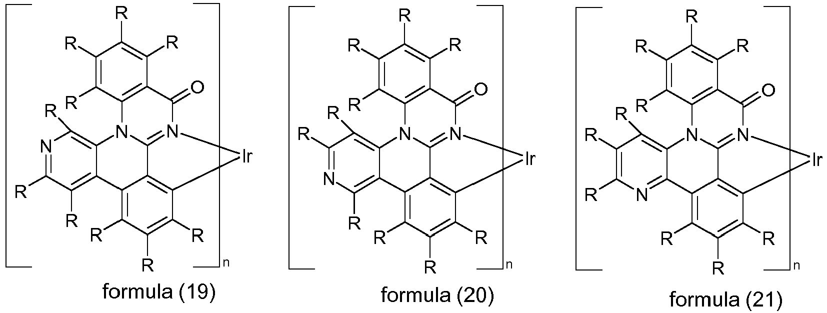 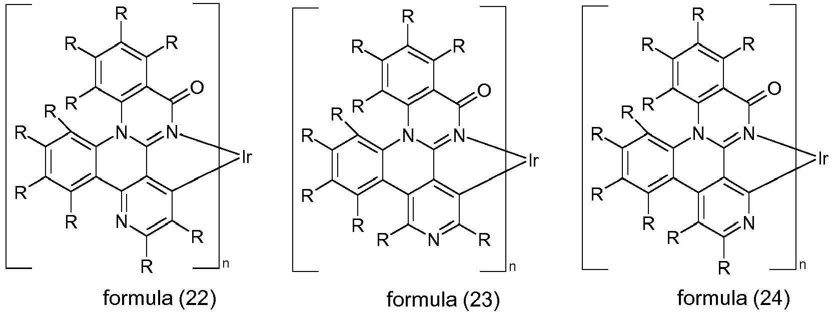 where the symbols and indices used have the meanings given in Claim 1.

4. Compound according to one or more of Claims 1 to 3, **characterised in that**, if one or more groups X or Y in the moieties of the formula (2) stand for N or in the case of moieties of the formulae (5) to (12) or (14) to (24), a group R selected from CF₃, OCF₃, alkyl or alkoxy groups having 1 to 10 C atoms, dialkylamino groups having 2 to 20 C atoms, aromatic or heteroaromatic ring systems or aralkyl or heteroaralkyl groups is bonded as substituent adjacent to this nitrogen atom.

5. Compound according to Claim 4, **characterised in that** the radical R which is adjacent to a nitrogen atom is selected from the groups of the following formulae (R-1) to (R-119), 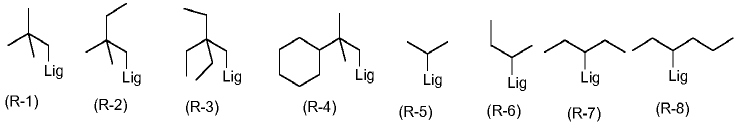 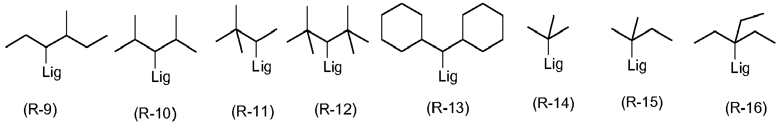 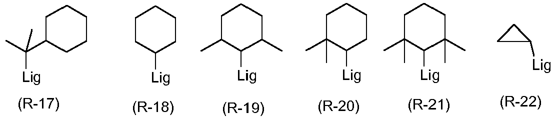 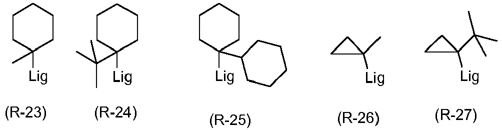 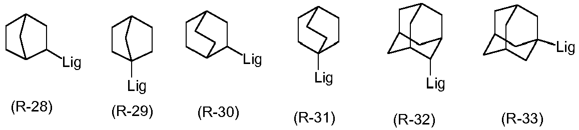 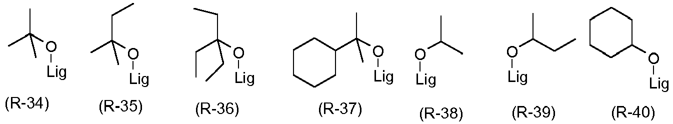 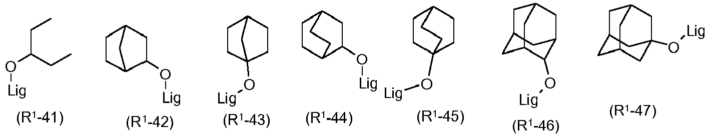 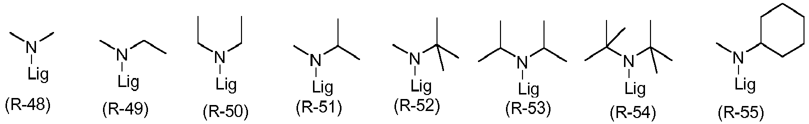 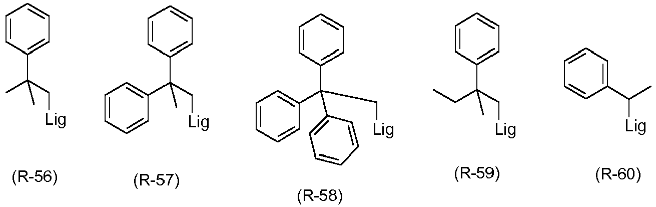 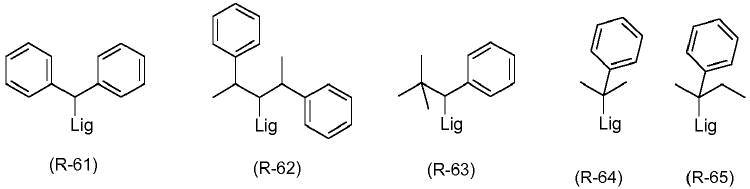 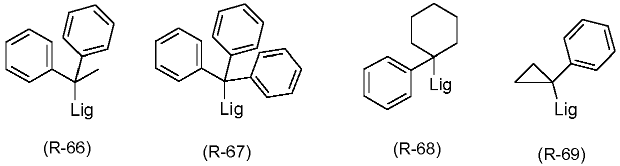 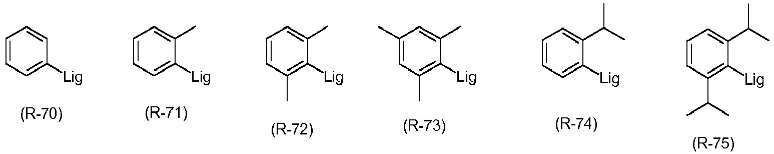 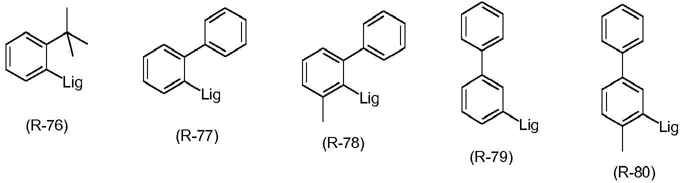 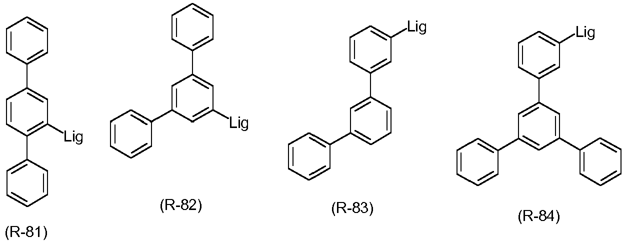 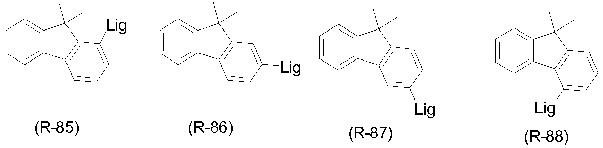 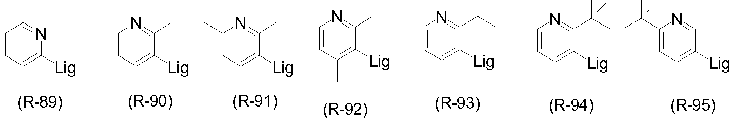 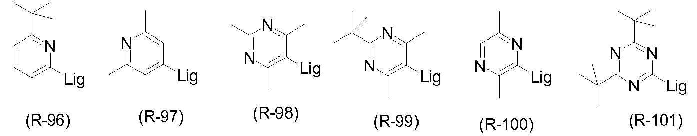 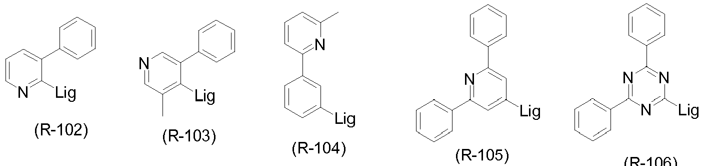 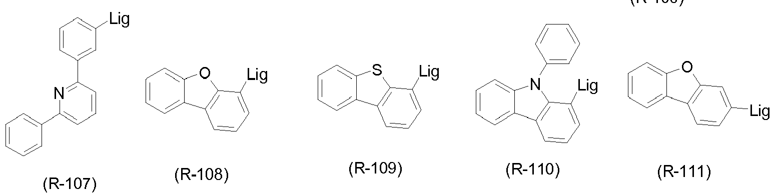 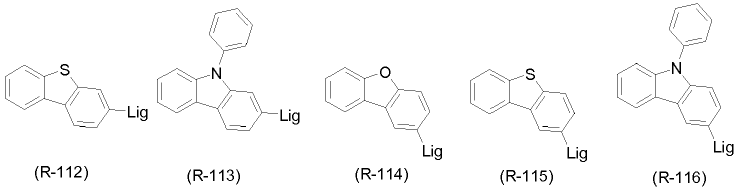 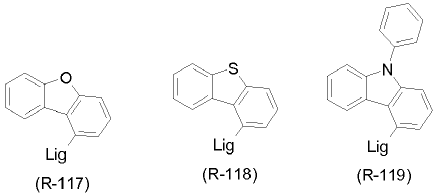 where Lig denotes the linking of the group to the ligand, and the aromatic and heteroaromatic groups may in each case be substituted by one or more radicals R¹.

6. Compound according to one or more of Claims 1 to 5, **characterised in that**, in the moiety of the formula (2), two adjacent groups X stand for CR and/or two adjacent radicals Y stand for CR and the respective radicals R, together with the C atoms, form a ring of one of the formulae (25) to (31), 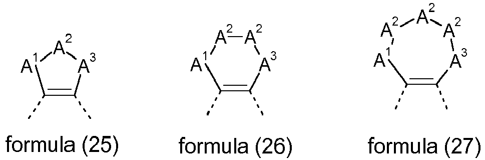 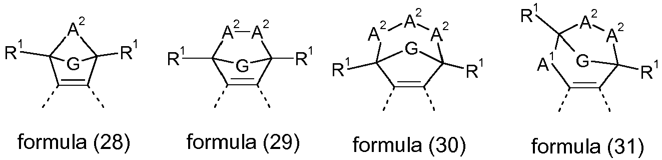 where R¹ and R² have the meanings given in Claim 1, where a plurality of R¹ may also be linked to one another and may thus form a further ring system, the dashed bonds indicate the linking of the two carbon atoms in the ligand, and furthermore:
A¹, A³ are, identically or differently on each occurrence, C(R³)₂, O, S, NR³ or C(=O);
A² is, identically or differently on each occurrence, C(R¹)₂, O, S, NR³ or C(=O); or A²-A² in formula (26), (27), (29), (30) or (31) may, apart from a combination of the above-mentioned groups, stand for -CR²=CR²⁻ or an ortho-linked arylene or heteroarylene group having 5 to 14 aromatic ring atoms, which may be substituted by one or more radicals R²;
G is an alkylene group having 1, 2 or 3 C atoms, which may be substituted by one or more radicals R², or is -CR²=CR²⁻ or an ortholinked arylene or heteroarylene group having 5 to 14 aromatic ring atoms, which may be substituted by one or more radicals R²;
R³ is, identically or differently on each occurrence, F, a straight-chain alkyl or alkoxy group having 1 to 10 C atoms, a branched or cyclic alkyl or alkoxy group having 3 to 10 C atoms, which may in each case be substituted by one or more radicals R², where one or more non-adjacent CH₂ groups may be replaced by R²C=CR², C=C, Si(R²)₂, C=O, NR², O, S or CONR² and where one or more H atoms may be replaced by D or F, or an aromatic or heteroaromatic ring system having 5 to 24 aromatic ring atoms, which may in each case be substituted by one or more radicals R², or an aryloxy or heteroaryloxy group having 5 to 24 aromatic ring atoms, which may be substituted by one or more radicals R², or an aralkyl or heteroaralkyl group having 5 to 24 aromatic ring atoms, which may be substituted by one or more radicals R²; two radicals R³ which are bonded to the same carbon atom may form an aliphatic or aromatic ring system with one another and thus form a spiro system; furthermore, R³ may form an aliphatic ring system with an adjacent radical R or R¹;
with the proviso that in these groups two heteroatoms are not bonded directly to one another and two groups C=O are not bonded directly to one another.

7. Compound according to Claim 6, **characterised in that** the structure of the formulae (25) to (31) is selected from the structures of the formulae (25-A) to (25-F), (26-A) to (26-F), (27-A) to (27-E), (28-A) to (28-C), (29-A), (30-A) or (31-A), 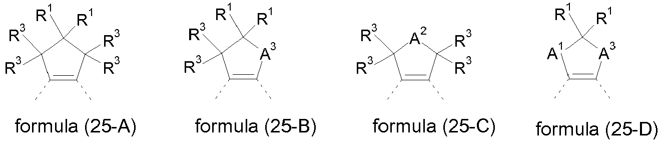 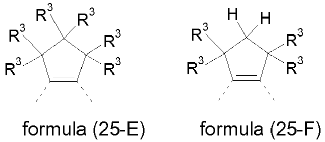 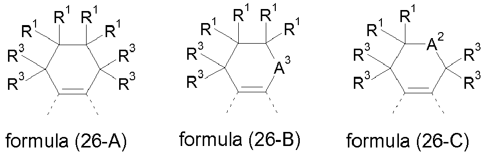 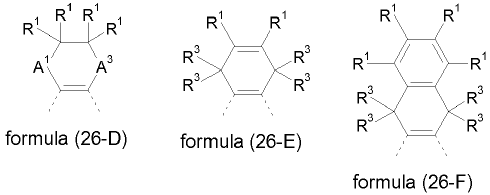 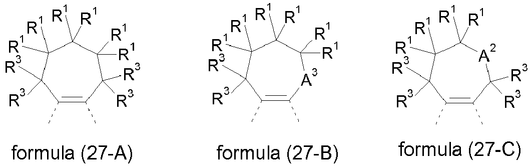 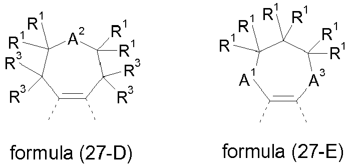 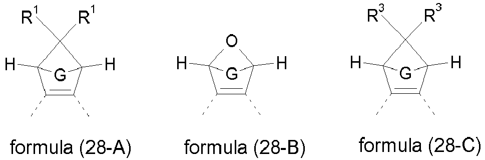 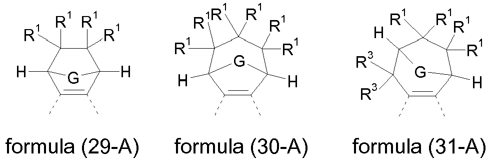 where R¹ and R³ have the meanings given in Claim 1 and A¹, A² and A³ stand, identically or differently on each occurrence, for O or NR³.

8. Process for the preparation of a compound according to one or more of Claims 1 to 7 by reaction of the corresponding free ligands L and L' with iridium alcoholates of the formula (60), with iridium ketoketonates of the formula (61), with iridium halides of the formula (62) or with dimeric iridium complexes of the formula (63) or (64) or with iridium compounds which carry both alcoholate and/or halide and/or hydroxyl and also ketoketonate radicals, 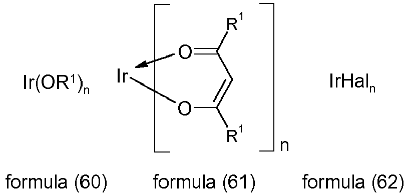 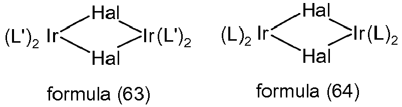 where the symbols and indices L', m, n and R¹ have the meanings indicated in Claim 1 and Hal = F, Cl, Br or I.

9. Formulation comprising at least one compound according to one or more of Claims 1 to 7 and at least one further compound, in particular a solvent.

10. Use of a compound according to one or more of Claims 1 to 7 in an electronic device, for the generation of singlet oxygen, in photocatalysis or in oxygen sensors.

11. Electronic device containing at least one compound according to one or more of Claims 1 to 7, selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

12. Electronic device according to Claim 11, which is an organic electroluminescent device, **characterised in that** the compound according to one or more of Claims 1 to 7 is employed as emitting compound in one or more emitting layers.

## Revendications

1. Composé de la formule (1),
[Ir(L)ₙ(L')ₘ] formule (1)
dans laquelle le composé de la formule générale (1) contient une moitié Ir(L)ₙ de la formule (2), 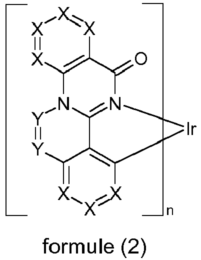 dans laquelle ce qui suit s'applique aux symboles et aux indices qui sont utilisés :
X est pour chaque occurrence, de manière identique ou différente, CR ou N, étant entendu qu'un maximum de deux symboles X par ligand représentent N ;
Y est pour chaque occurrence, de manière identique ou différente, CR ou N, étant entendu qu'un maximum d'un seul symbole Y représente N, ou les deux symboles Y représentent en association un groupe de la formule (3) qui suit, 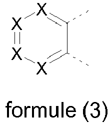 dans laquelle les liens en pointillés symbolisent la liaison de ce groupe dans le ligand ;
R est pour chaque occurrence, de manière identique ou différente, H, D, F, Cl, Br, I, N(R¹)₂, CN, Si(R¹)₃, B(OR¹)₂, C(=O)R¹, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R¹, où un ou plusieurs groupe(s) CH₂ non adjacents peut/peuvent être remplacé(s) par R¹C=CR¹, Si(R¹)₂, C=O, NR¹, O, S ou CONR¹ et où un ou plusieurs atome(s) de H peut/peuvent être remplacé(s) par D, F ou CN, ou un système de cycle aromatique ou hétéroaromatique qui comporte de 5 à 60 atomes de cycle aromatique, lequel peut dans chaque cas être substitué par un radical ou par plusieurs radicaux R¹, ou un groupe aryloxy ou hétéroaryloxy qui comporte de 5 à 60 atomes de cycle aromatique, lequel peut être substitué par un radical ou par plusieurs radicaux R¹, un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R¹ ; deux radicaux R adjacents ou plus peuvent également former un système de cycle aliphatique, aromatique et/ou benzo-fusionné mono- ou polycyclique, l'un avec l'autre ou les uns avec les autres ;
R¹ est pour chaque occurrence, de manière identique ou différente, H, D, F, N(R²)₂, CN, Si(R²)₃, B(OR²)₂, C(=O)R², un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R², où un ou plusieurs groupe(s) CH₂ non adjacents peut/peuvent être remplacé(s) par R²C=CR², Si(R²)₂, C=O, NR², O, S ou CONR² et où un ou plusieurs atome(s) de H peut/peuvent être remplacé(s) par D, F ou CN, ou un système de cycle aromatique ou hétéroaromatique qui comporte de 5 à 60 atomes de cycle aromatique, lequel peut dans chaque cas être substitué par un radical ou par plusieurs radicaux R², ou un groupe aryloxy ou hétéroaryloxy qui comporte de 5 à 60 atomes de cycle aromatique, lequel peut être substitué par un radical ou par plusieurs radicaux R², ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R²; deux radicaux R¹ adjacents ou plus peuvent former un système de cycle aliphatique mono- ou polycyclique l'un avec l'autre ou les uns avec les autres ;
R² est pour chaque occurrence, de manière identique ou différente, H, D, F ou un radical organique aliphatique, aromatique et/ou hétéroaromatique qui comporte de 1 à 20 atome(s) de C, en particulier un radical hydrocarbone, où, en outre, un ou plusieurs atome(s) de H peut/peuvent être remplacé(s) par D ou F ; deux substituants R² ou plus peuvent également former un système de cycle aliphatique ou aromatique mono- ou polycyclique l'un avec l'autre ou les uns avec les autres ;
L' est, de manière identique ou différente pour chaque occurrence, un ligand bidenté monoanionique qui est une combinaison de deux des formules (32) à (55), où L' est formé à partir de ces groupes au moyen de ces groupes qui sont dans chaque cas liés les uns aux autres au niveau de la position qui est indiquée au moyen de #, 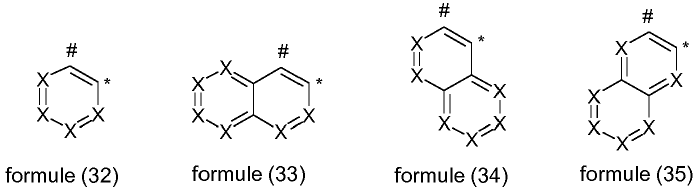 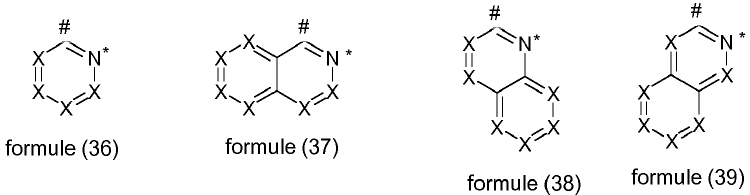 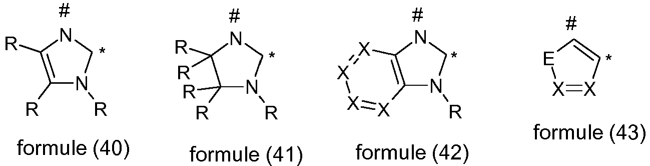 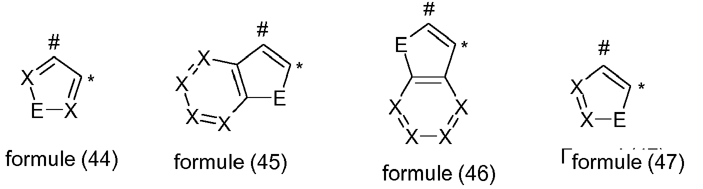 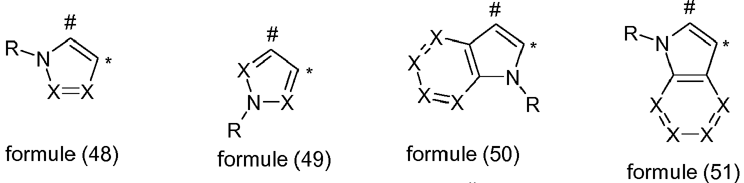 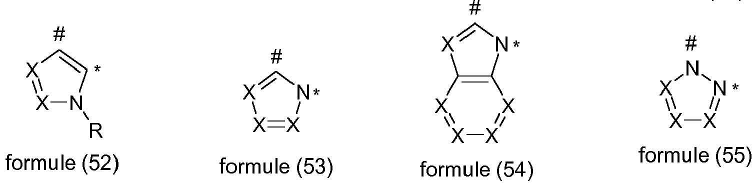 où la position au niveau de laquelle les groupes sont coordonnés sur le métal est indiquée au moyen de * et E représente O, S ou CR₂ ;
n est 1 ou 2 ;
m est 1 ou 2 ;
**caractérisé en ce que** n + m = 3.

2. Composé selon la revendication 1, **caractérisé en ce qu'**un total de 0, 1 ou 2 des symboles X et Y dans le ligand L représente(nt) N, de préférence un total de 0 ou 1 des symboles X et Y.

3. Composé selon la revendication 1 ou 2, sélectionné parmi les structures des formules (4) à (24), 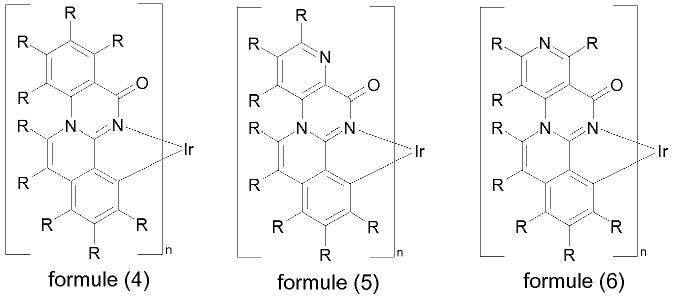 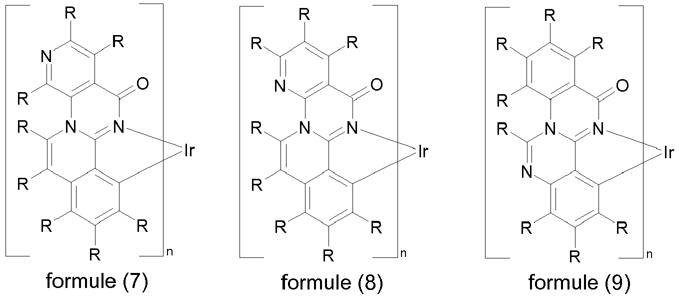 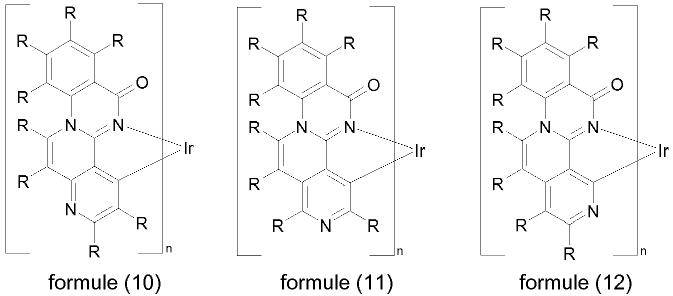 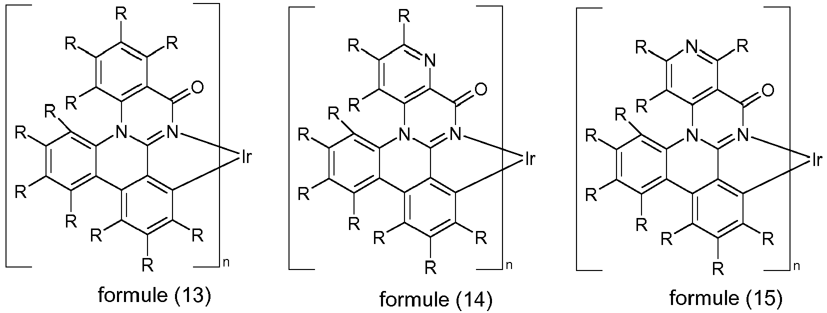 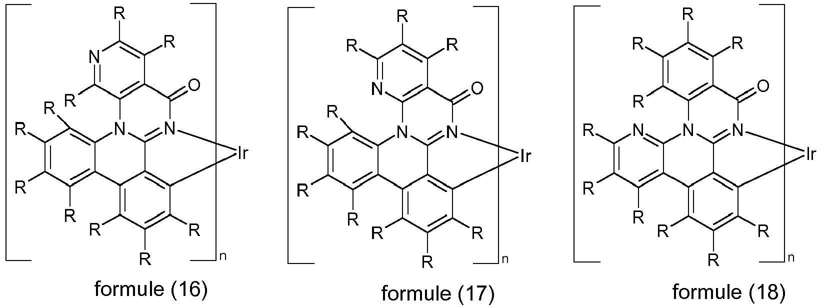 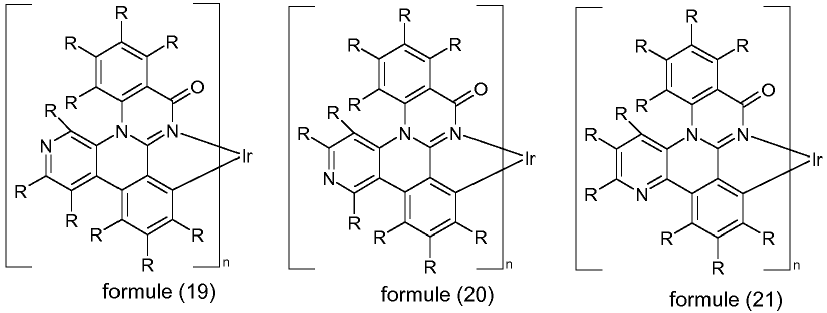 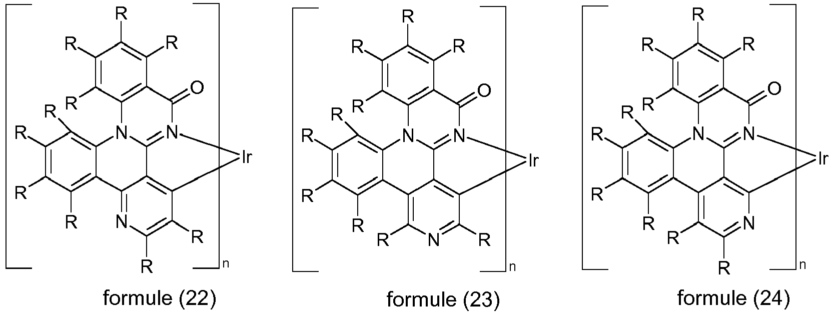 dans lesquelles les symboles et les indices qui sont utilisés présentent les significations qui ont été données selon la revendication 1.

4. Composé selon une ou plusieurs des revendications 1 à 3, **caractérisé en ce que**, si un ou plusieurs groupe(s) X ou Y dans les moitiés de la formule (2) représente(nt) N ou dans le cas de moitiés des formules (5) à (12) ou (14) à (24), un groupe R qui est sélectionné parmi CF₃, OCF₃, des groupes alkyle ou alcoxy qui comportent de 1 à 10 atome(s) de C, des groupes dialkylamino qui comportent de 2 à 20 atomes de C, des systèmes de cycle aromatique ou hétéroaromatique ou des groupes aralkyle ou hétéroaralkyle est lié en tant que substituant adjacent à cet atome d'azote.

5. Composé selon la revendication 4, **caractérisé en ce que** le radical R qui est adjacent à un atome d'azote est sélectionné parmi les groupes des formules (R-1) à (R-119) qui suivent, 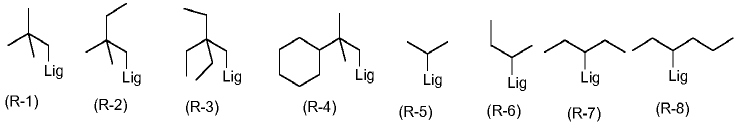 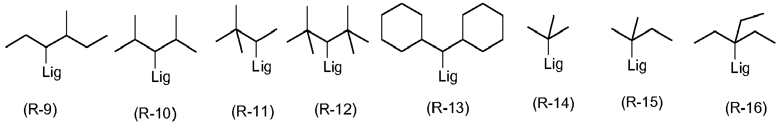 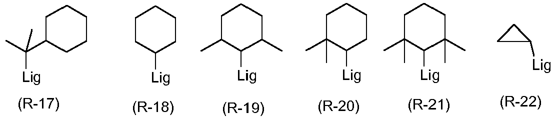 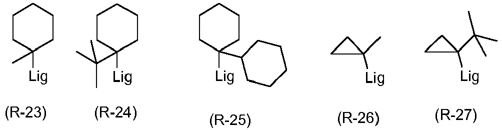 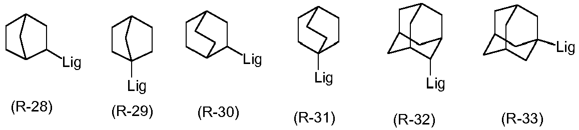 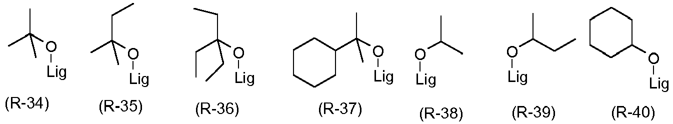 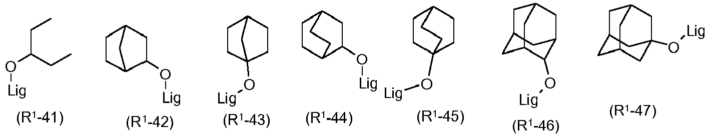 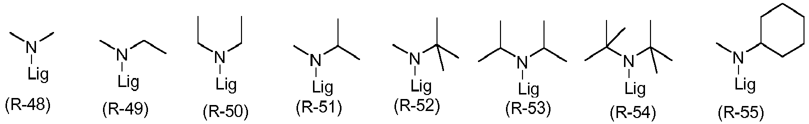 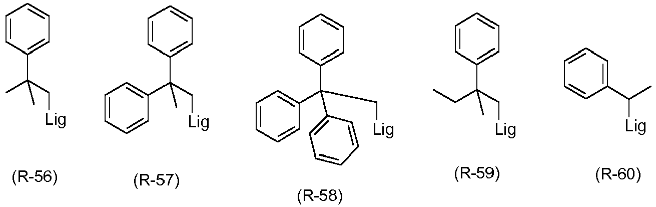 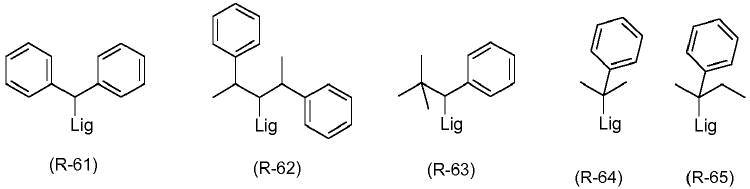 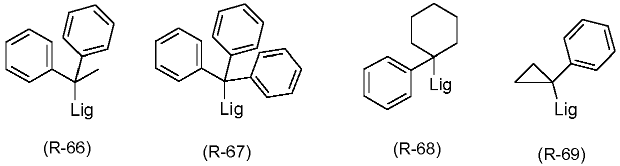 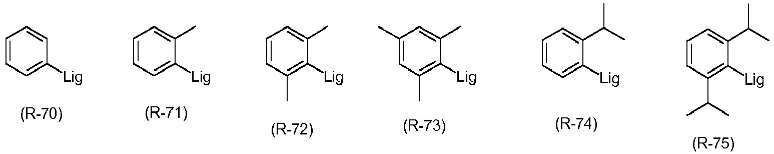 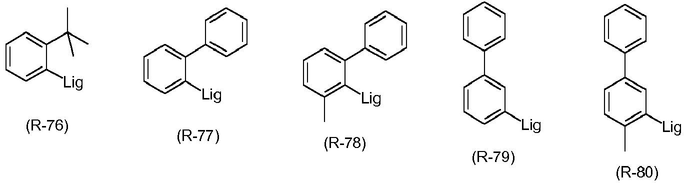 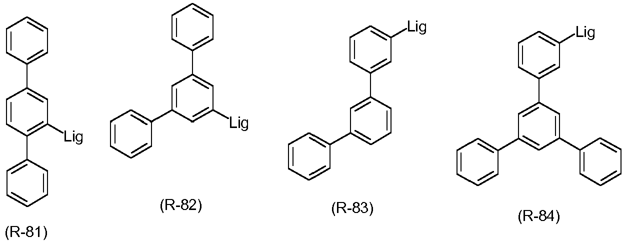 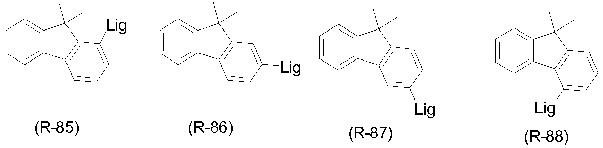 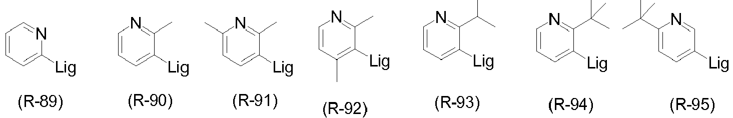 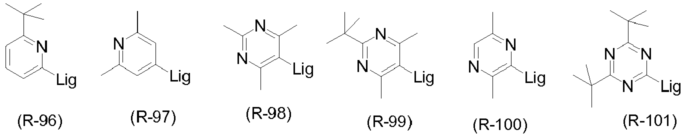 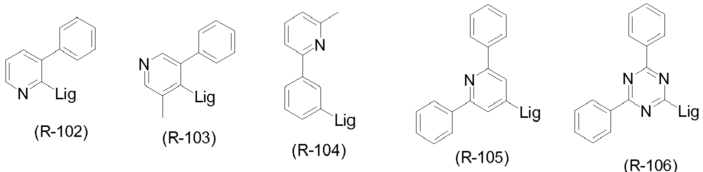 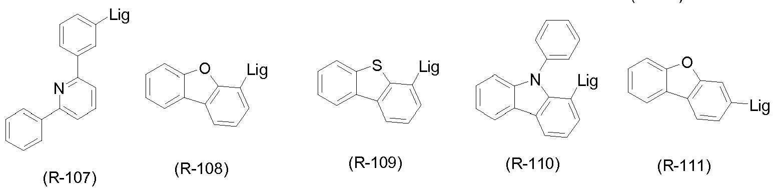 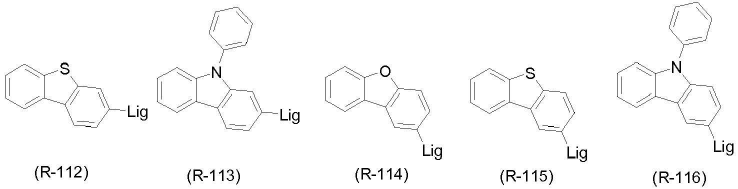 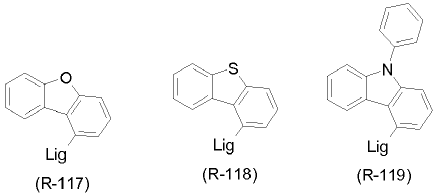 dans lesquelles Lig représente la liaison du groupe sur le ligand, et les groupes aromatiques et hétéroaromatiques peuvent dans chaque cas être substitués par un radical ou par plusieurs radicaux R¹.

6. Composé selon une ou plusieurs des revendications 1 à 5, **caractérisé en ce que**, dans la moitié de la formule (2), deux groupes adjacents X représentent CR et/ou deux radicaux adjacents Y représentent CR et les radicaux respectifs R, en association avec les atomes de C, forment un cycle de l'une des formules (25) à (31), 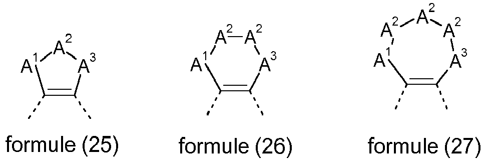 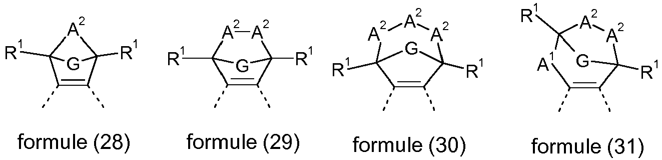 dans lesquelles R¹ et R² présentent les significations qui ont été données selon la revendication 1, où une pluralité de R¹ peuvent également être liés les uns aux autres et peuvent ainsi former un autre système de cycle, les liens en pointillés indiquent la liaison des deux atomes de carbone dans le ligand, et en outre :
A¹, A³ sont, de manière identique ou différente pour chaque occurrence, C(R³)₂, O, S, NR³ ou C(=O) ;
A² est, de manière identique ou différente pour chaque occurrence, C(R¹)₂, O, S, NR³ ou C(=O) ; ou A²-A² dans la formule (26), (27), (29), (30) ou (31) peut, indépendamment d'une combinaison des groupes qui ont été mentionnés ci-avant, représenter -CR²=CR²-ou un groupe arylène ou hétéroarylène ortho-lié qui comporte de 5 à 14 atomes de cycle aromatique, lequel peut être substitué par un radical ou par plusieurs radicaux R² ;
G est un groupe alkylène qui comporte 1, 2 ou 3 atome(s) de C, lequel peut être substitué par un radical ou par plusieurs radicaux R², ou est -CR²=CR²- ou un groupe arylène ou hétéroarylène ortho-lié qui comporte de 5 à 14 atomes de cycle aromatique, lequel peut être substitué par un radical ou par plusieurs radicaux R²;
R³ est, de manière identique ou différente pour chaque occurrence, F, un groupe alkyle ou alcoxy en chaîne droite qui comporte de 1 à 10 atome(s) de C, un groupe alkyle ou alcoxy ramifié ou cyclique qui comporte de 3 à 10 atomes de C, lequel peut dans chaque cas être substitué par un radical ou par plusieurs radicaux R², où un ou plusieurs groupe(s) CH₂ non adjacents peut/ peuvent être remplacé(s) par R²C=CR², C=C, Si(R²)₂, C=O, NR², O, S ou CONR² et où un ou plusieurs atome(s) de H peut/ peuvent être remplacé(s) par D ou F, ou un système de cycle aromatique ou hétéroaromatique qui comporte de 5 à 24 atomes de cycle aromatique, lequel peut dans chaque cas être substitué par un radical ou par plusieurs radicaux R², ou un groupe aryloxy ou hétéroaryloxy qui comporte de 5 à 24 atomes de cycle aromatique, lequel peut être substitué par un radical ou par plusieurs radicaux R², ou un groupe aralkyle ou hétéroaralkyle qui comporte de 5 à 24 atomes de cycle aromatique, lequel peut être substitué par un radical ou par plusieurs radicaux R²; deux radicaux R³ qui sont liés au même atome de carbone peuvent former un système de cycle aliphatique ou aromatique l'un avec l'autre et peuvent ainsi former un système spiro ; en outre R³ peut former un système de cycle aliphatique avec un radical R ou R¹ adjacent ;
étant entendu que dans ces groupes, deux hétéroatomes ne sont pas liés directement l'un à l'autre et deux groupes C=O ne sont pas liés directement l'un à l'autre.

7. Composé selon la revendication 6, **caractérisé en ce que** la structure des formules (25) à (31) est sélectionnée parmi les structures des formules (25-A) à (25-F), (26-A) à (26-F), (27-A) à (27-E), (28-A) à (28-C), (29-A), (30-A) ou (31-A), 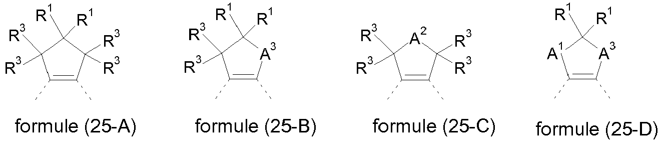 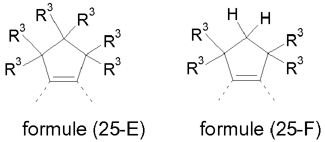 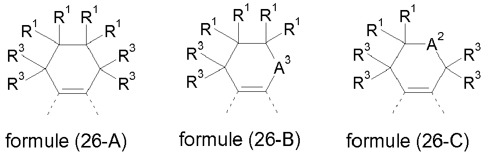 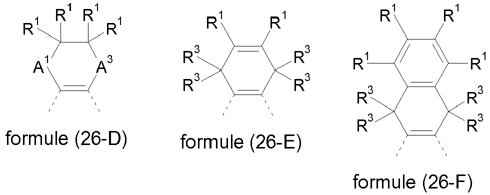 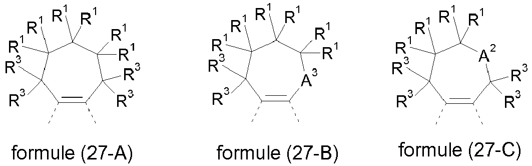 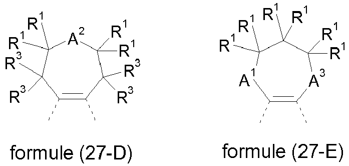 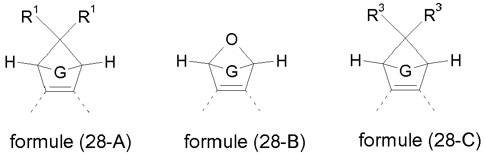 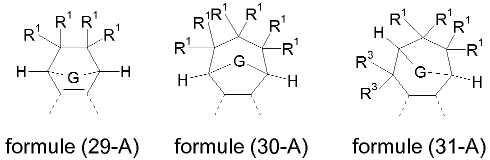 dans lesquelles R¹ et R³ présentent les significations qui ont été données selon la revendication 1 et A¹, A² et A³ représentent, de manière identique ou différente pour chaque occurrence, O ou NR³.

8. Procédé pour la préparation d'un composé selon une ou plusieurs des revendications 1 à 7 par réaction des ligands libres correspondants L et L' avec des alcoolates d'iridium de la formule (60), avec des cétocétonates d'iridium de la formule (61), avec des halogénures d'iridium de la formule (62) ou avec des complexes d'iridium dimériques de la formule (63) ou (64) ou avec des composés d'iridium qui sont porteurs à la fois de radicaux alcoolate et/ou halogénure et/ou hydroxyle et également cétocétonate, 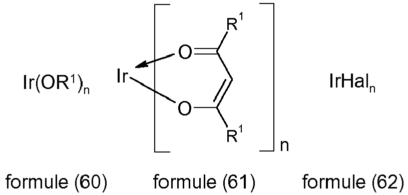 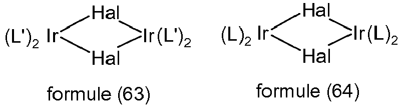 où les symboles et les indices L', m, n et R¹ présentent les significations qui ont été indiquées selon la revendication 1 et Hal = F, Cl, Br ou I .

9. Formulation comprenant au moins un composé selon une ou plusieurs des revendications 1 à 7 et au moins un autre composé, en particulier un solvant.

10. Utilisation d'un composé selon une ou plusieurs des revendications 1 à 7 dans un dispositif électronique, pour la génération d'un oxygène singulet, lors d'une photocatalyse ou dans des capteurs d'oxygène.

11. Dispositif électronique contenant au moins un composé selon une ou plusieurs des revendications 1 à 7, sélectionné parmi le groupe qui est constitué par les dispositifs électroluminescents organiques, les circuits intégrés organiques, les transistors à effet de champ organiques, les transistors à film mince organiques, les transistors à émission de lumière organiques, les cellules solaires organiques, les détecteurs optiques organiques, les photorécepteurs organiques, les dispositifs à extinction de champ organiques, les cellules électrochimiques à émission de lumière ou les diodes laser organiques.

12. Dispositif électronique selon la revendication 11, lequel est un dispositif électroluminescent organique, **caractérisé en ce que** le composé selon une ou plusieurs des revendications 1 à 7 est utilisé en tant que composé d'émission dans une ou plusieurs couche(s) d'émission.
